(19) Europäisches Patentamt
European Patent Office
Office européen des brevets

(11) EP 1 445 120 B1

(12) **EUROPEAN PATENT SPECIFICATION**

(45) Date of publication and mention of the grant of the patent:
**18.07.2007 Bulletin 2007/29**

(51) Int Cl.:
***B41N 3/03*** *(2006.01)* ***B41N 1/08*** *(2006.01)*
***B41C 1/10*** *(2006.01)*

(21) Application number: **04002431.7**

(22) Date of filing: **04.02.2004**

(54) **Photosensitive lithographic printing plate**

Lichtempfindliche Flachdruckplatte

Plaque lithographique photosensible

(84) Designated Contracting States:
**AT BE BG CH CY CZ DE DK EE ES FI FR GB GR HU IE IT LI LU MC NL PT RO SE SI SK TR**

(30) Priority: **06.02.2003 JP 2003029879**
**06.02.2003 JP 2003029880**
**06.02.2003 JP 2003029881**

(43) Date of publication of application:
**11.08.2004 Bulletin 2004/33**

(73) Proprietor: **FUJIFILM Corporation**
**Minato-ku**
**Tokyo (JP)**

(72) Inventors:
- **Kondo, Shunichi, c/o Fuji Photo Film Co., LTD.**
**Haibara-gun,**
**Shizuoka (JP)**
- **Hotta, Hisashi, c/o Fuji Photo Film Co., LTD.**
**Haibara-gun,**
**Shizuoka (JP)**

(74) Representative: **HOFFMANN EITLE**
**Patent- und Rechtsanwälte**
**Arabellastrasse 4**
**81925 München (DE)**

(56) References cited:
**EP-A- 0 812 705** **EP-A- 0 924 570**
**US-A- 6 103 087**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 445 120 B1

## Description

### FIELD OF THE INVENTION

The present invention relates to a photosensitive lithographic printing plate with a photopolymerization layer, especially to that for CTP. More precisely, the invention relates to a photosensitive lithographic printing plate which is highly sensitive to radiations of Ar ion laser, FD-YAG laser, violet laser, short-wave semiconductor laser and the like, which satisfies both the requirement of staining resistance inprinting and the requirement of printing durability, and which has good developability, good ink acceptability, good image formability and broad exposure latitude.

### BACKGROUND OF THE INVENTION

Heretofore, various methods of image formation through photopolymerization are known and are widely used in various fields of printing plates, printed circuits, holographic recording, three-dimensional imaging, etc.

For example, for forming printing plates, one general method comprises applying a photopolymerizable composition that contains an addition-polymerizable, ethylenic double bond-having compound (this may be referred to as "ethylenic unsaturated bond-having compound), a photopolymerization initiator, an organic polymer compound (this may be referred to as "binder" or "binder polymer") and a thermal polymerization inhibitor, onto a support to form a coating layer (this may be referred to as "photopolymerization layer", "image-recording layer", "photopolymerizing photosensitive layer" or "photosensitive layer") thereon, then imagewise exposing it for a desired image, polymerizing and curing the exposed area thereof, and dissolving and removing the non-exposed area thereof to form a cured relief image on the support.

For the organic polymers in these compositions, copolymers of (meth) acrylic acid and (meth) acrylates are used as well known in various references (e.g., see patent references JP-B54-34327, JP-B58-12577, JP-A 60-159743 and JP-A 60-208748).

It is also known that a copolymer of allyl (meth) acrylate and (meth)acrylic acid used for an organic polymer in a photopolymerizable composition increases the curing efficiency of the composition (e.g., see patent reference JP-B 3-63740).

However, the properties of the conventional compositions are not still satisfactory, and in particular, it is desired to improve the sensitivity, the curability, the developability and the printing durability of the compositions.

Studies of high-sensitivity photographic materials with photopolymerizable components are much progressing these days, and are being applied to various fields. In particular, laser direct processing systems are now in a practicable field, and CTP plates capable of being processed for image formation thereon with argon ion laser (488 nm), FD-YAG laser (532 nm) or violet laser (405 nm) are in practical use (e.g., see patent references JP-A 3-12403, JP-A 6-295061 and JP-A 11-171907).

However, the CRT plates described in patent references JP-A 3-12403, JP-A 6-295061 and JP-A 11-171907 do not satisfy all the requirements of sensitivity, developability, ink acceptability, staining resistance in printing and printing durability, and printing plates having well-balanced properties are desired.

### SUMMARY OF THE INVENTION

An object of the present invention is to solve the problems in the related art as above, and to provide a photosensitive lithographic printing plate which is processable for image formation thereon with Ar ion laser, FD-YAG laser, violet laser or the like, which has high sensitivity, which satisfies both the requirement of staining resistance in printing and the requirement of printing durability, and which has good developability, good ink acceptability, good image formability, good controllability of lateral fog in solid image area and broad exposure latitude.

To solve the problems in the related art, we, the present inventors have studied in detail the grain structure of supports, and, as a result, have found the following: The grain structure has a double structure of large and small pits. When the mean opening diameters of the pits are controlled to fall within a suitable range and when an amido group-having binder is used for the polymer binder in a photopolymerization layer so that it may well match with the thus-controlled grain structure, then it improves the sensitivity, the staining resistance, the easy visibility when dampened with water, the printing durability of printing plates, and further improves the developability and the ink acceptability thereof. When a specific polyurethane is used, then it improves the sensitivity, the staining resistance, the easy visibility when dampened with water, and the printing durability of printing plates, not detracting from the image formability thereof. On the basis of these findings, we have reached a photosensitive lithographic printing (first aspect) of the invention.

In addition, we have further found that, when the coating amount of the photopolymerization layer and the optical density of the sensitizing dye used are controlled to fall within a predetermined range, then it improves the sensitivity, the staining resistance, the easy visibility when dampened with water and the printing durability of printing

plates and broadens the exposure latitude thereof, and on the basis of these findings, we have reached another photosensitive lithographic printing (second aspect) of the invention.

Specifically, the invention provides photosensitive lithographic printing plates of the following constitutions:

(1). A photosensitive lithographic printing plate containing:

a support prepared by an electrochemically surface-roughening treatment on an aluminium or aluminium alloy sheet with an aqueous solution that contains at least hydrochloric acid and by an anodic oxidation treatment; and a photopolymerization layer containing an addition-polymerizable ethylenic unsaturated compound, a photopolymerization initiator, and a polymer binder,

wherein the support has a double structure of large and small pits, the large pits have a mean opening diameter of 2 to 10 μm, the small pits have a mean opening diameter of 0.1 to 0.8 μm, the small pits have a ratio of a diameter to a depth of 1: 0. 2 to 1:0.6, a surface area ΔS represented by the following formula is at most 40, and the polymer binder in the photopolymerization layer is at least one of organic polymer compounds that have an amido group of the following formula (M1)in a side branches there of and polyurethane resins produced from compounds (i) at least one diisocyanate compound, (ii) at least one diol compound having at least one carboxyl group, (iii) at least one diol compound having a value log P of smaller than 0, and (iv) at least one diol compound having a value log P of larger than 0, provided that the compounds (iii) and (iv) are not carboxyl group-having diol compounds:

$$\Delta S = (Sx - So)/So \times 100\ \%$$

wherein Sx indicates an actual surface area of the support obtained by measuring 512 × 512 points of 50 $\mu m^2$, and So indicates a geometrically-measured surface area thereof;

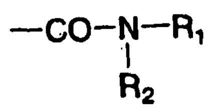

(M1)

wherein $R_1$ and $R_2$ each independently represent a hydrogen atom, an alkyl group, an alkenyl group, an alkynyl group, an aryl group, a heterocyclic group or a substituted sulfonyl group, and $R_1$ and $R_2$ may bond to each other to form a cyclic structure.

(2). A photosensitive lithographic printing plate containing:

a support prepared by an electrochemically surface-roughening treatment on an aluminium or aluminium alloy sheet with an aqueous solution that contains at least hydrochloric acid and by an anodic oxidation treatment, a photopolymerization layer containing an addition-polymerizable ethylenic unsaturated compound, a sensitizing dye, a photopolymerization initiator , and a polymer binder, and
an oxygen-blocking overcoat layer, in this order,

wherein the support has a double structure of large and small pits, the large pits have a mean opening diameter of 2 to 10μ m, the small pits have a mean opening diameter of 0.1 to 0.8 μm, a surface area ΔS represented by the following formula is at most 40, the photopolymerization layer has a coating amount by weight of 0.5 to 2.0 $g/m^2$, and the sensitizing dye in the photopolymerization layer has an optical density of 0.2 to 1.0:

$$\Delta S = (Sx - So)/So \times 100\ \%$$

wherein Sx indicates an actual surface area of the support obtained by measuring 512 × 512 points of 50 $\mu m^2$, and So indicates a geometrically-measured surface area thereof.

(3). The photosensitive lithographic printing plate according to item (2), wherein the sensitizing dye in the photopolymerization layer is a compound of the following formula (SD-1) or (SD-2):

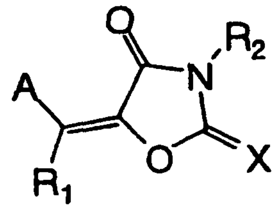

(SD-1)

wherein A represents an optionally-substituted aromatic or heterocyclic ring; X represents an oxygen or sulfur atom, or $-N(R_3)-$; $R_1$, $R_2$ and $R_3$ each independently represent a hydrogen atom, or a monovalent non-metallic atomic group; A and $R_1$, and $R_2$ and $R_3$ may bond to each other to form an aliphatic or aromatic ring;

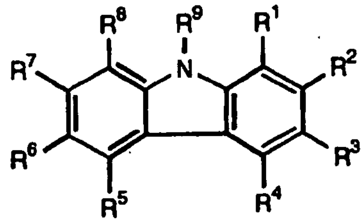

(SD-2)

wherein $R^1$, $R^2$, $R^3$, $R^4$, $R^5$, $R^6$, $R^7$, $R^8$ and $R^9$ each independently a hydrogen atom, or a monovalent non-metallic atomic group, provided that at least one of $R^1$ and $R^3$ is a monovalent organic residue represented by the following partial structural formula (a), and $R^1$, $R^2$, $R^3$, $R^4$, $R^5$, $R^6$, $R^7$, $R^8$ and $R^9$ may independently bond to each other to form an aliphatic or aromatic ring:

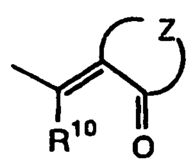

(a)

wherein $R^{10}$ represents a hydrogen atom, or a monovalent non-metallic atomic group; Z represents a divalent non-metallic atomic group necessary for forming a 5-membered acidic nucleus along with the adjacent atoms; $R^{10}$ may bond to any of $R^1$, $R^2$, $R^3$, $R^4$, $R^5$, $R^6$, $R^7$, $R^8$ or $R^9$ to form an aliphatic or aromatic ring.

(4). The photosensitive lithographic printing plate according to items (1) or (2), wherein the large pits have a mean opening diameter of 4 to 8 μm, the small pits have a mean opening diameter of 0.2 to 0.6 μm, the small pits have a ratio of the diameter to the depth of 1:0.3 to 1:0.5.

(5). The photosensitive lithographic printing plate according to items (1) or (2), wherein the aluminium or aluminium alloy sheet have a thickness of 0.05 to 0.8mm.

(6). The photosensitive lithographic printing plate according to items (1) or (2), which further contains at least one of an organic subbing layer having a dry coating amount of 2 to 200 mg/m$^2$ or an inorganic subbing layer having a dry coating amount of 0.1 to 100 mg/m$^2$.

(7). The photosensitive lithographic printing plate according to items (1) or (2), wherein the polymer binder has a weight-average molecular weight of 5000 to 1, 000, 000, and an acid value of 0.1 to 5.0 meq/g.

The photosensitive lithographic printing plate of the invention is processable for image formation thereon with argon ion laser, FD-YAG laser, violet laser or the like and is usable for CTP. It has high sensitivity and satisfies both the

requirement of staining resistance in printing and the requirement of printing durability, and it has good developability, good ink acceptability, good image formability and broad exposure latitude.

## BRIEF DESCRIPTION OF THE DRAWING

[Fig. 1]
This is a cross-sectional view showing one example of an electrolytic surface-roughening device equipped with a flat AC electrolytic cell for use in the invention.
[Fig. 2]
This is a cross-sectional view showing another example of an electrolytic surface-roughening device equipped with a flat AC electrolytic cell for use in the invention.
[Fig. 3]
This is a cross-sectional view showing one example of an electrolytic surface-roughening device equipped with a radial AC electrolytic cell for use in the invention.
[Fig. 4]
This is a side view showing the concept of a brush graining step for mechanical surface-roughening treatment in the invention.

[Description of Reference Numerals and Signs]

| | |
|---|---|
| 2, 20 | AC Electrolytic Cell |
| 4A, 4B, 4C, 26A, 26B | Main Electrode |
| 6A, 6B, 14A, 14B | Conveyor Roller |
| 8A, 16A | Feed Roller |
| 8B, 16B | Take-out Roller |
| 10, 34 | Auxiliary Electrolytic Cell |
| 12, 36 | Auxiliary Electrode |
| 22 | AC Electrolytic Cell Body |
| 22A | Opening |
| 24 | Feed Roller |
| 28A, 28B | Supply Nozzle |
| 30A | Upstream Guide Roller |
| 30B | Downstream Guide Roller |
| 32 | Overflow Cell |
| 34A | Bottom of Auxiliary Electrolytic Cell |
| 35 | Upstream Guide Roller |
| 51 | Aluminium (Alloy) Sheet |
| 52, 54 | Brush Roller |
| 53 | Abrasive Slurry |
| 55, 56, 57, 58 | Support Roller |
| 100, 102, 104 | Electrolytic Surface-Roughening Device |
| a | Traveling Direction |
| T | Traveling Face |
| Tac | Power Source |
| Th1, Th2, Th3, Th4, Th5 | Thyristor |
| W | Aluminium Web |

## DETAILED DESCRIPTION OF THE INVENTION

The photosensitive lithographic printing plate of the invention is described in detail hereinunder.
The photosensitive lithographic printing plate of the invention has a photopolymerization layer on a support thereof, and optionally has a subbing layer between the support and the photopolymerization layer and a protective layer on the photopolymerization layer.
The support and the layers that constitute the photosensitive lithographic printing plate of the invention are

described below.

[A. Support]

The support of the photosensitive lithographic printing plate of the invention is one prepared by electrochemically surface-roughening an aluminium or aluminium alloy sheet with an aqueous solution that contains at least hydrochloric acid followed by subjecting it to anodic oxidation. The support has a double structure of large and small pits, the mean opening diameter of the large pits is from 2 to 10 μm, and the mean opening diameter of the small pits is from 0.1 to 0.8 μm. In the support of the photosensitive lithographic printing plate of the first aspect of the invention, the ratio of a deameter to a depth of the small pits falls between 1:0.2 and 1:0.6. The double structure of large and small pits means that the small pits exist at the surface of the large pits.

In the invention, the large pits are preferably from 2 to 10 μm in size, more preferably from 4 to 8 μm. The small pits are preferably from 0.1 to 0.8 μm in size, more preferably from 0.2 μm to 0.6 μm. The ratio of the depth to the diameter of the small pits preferably falls between 0.2 and 0.6, more preferably between 0.3 and 0.5.

ΔS is derived from the three-dimensional data obtained by measuring 512 × 512 points of the surface of 50 $\mu m^2$ (50 μm × 50 μm) each by the use of an atomic force microscope, and is characterized in that it is at most 40 %.

As will be described in detail hereinunder, ΔS is obtained according to the following formula in which Sx indicates the actual surface area of the support obtained through three-point approximation of the above-mentioned three-dimensional data, and So indicates the geometrically-measured surface area (apparent surface area) thereof:

$$\Delta S = (Sx - So)/So \times 100\ (\%).$$

The surface area ratio ΔS is a factor that indicates the increase in the actual area Sx through surface-roughening treatment relative to the geometrically-measured area So. A larger ΔS means that the contact area between the support and the image-recording layer is larger, and, as a result, it improves the printing durability of the printing plate. For increasing ΔS, it is effective to form a large number of small projections and recesses in the surface of the support. Concretely for forming such a large number of small projections and recesses in the surface thereof, for example, the support is subjected to electrolytic surface-roughening with an electrolytic solution that essentially comprises hydrochloric acid. Combined with the treatment, the support may also be subjected to electrolytic surface-roughening with an electrolytic solution that essentially comprises high-concentration and high-temperature nitric acid. Mechanical surface-roughening or electrolytic surface-roughening with an ordinary electrolytic solution that essentially comprises nitric acid alone may increase ΔS, but its effect is small. In the invention, ΔS must be at most 40 %, preferably from 20 to 35 %.

Concretely, ΔS of the support for use in the photosensitive lithographic printing plate of the invention may be obtained according to the method mentioned below.

The surface profile of the support is analyzed with an atomic force microscope (AFM) to obtain the three-dimensional data thereof.

For example, the support may be analyzed under the condition mentioned below. Concretely, a sample of 1 $cm^2$ in size is cut out of the support, and set on a horizontal sample stand put on a piezo-scanner. A cantilever is made to approach the sample surface, and when it has reached a region that may receive interatomic force, the sample is scanned in the X-Y directions whereupon the surface roughness of the sample is detected as the piezo-displacement thereof in the Z direction. The piezo-scanner used herein is scannable for 150 μm in the X-Y directions and for 10 μm in the Z direction. The cantilever used herein has a resonance frequency of from 120 to 150 kHz and a spring constant of from 12 to 20 N/m (SI-DF20 by Nanoprobe), and it is driven in DFM (dynamic force mode). Thus obtained, the three-dimensional data are processed for least square approximation to correct any slight inclination of the sample so as to determine the standard face thereof.

512 × 512 points of the surface of 50 $\mu m^2$ each are measured. The resolution in the X-Y directions is 1.9 μm, and that in the Z direction is 1 nm, and the scanning speed is 60 μm/sec.

Using the three-dimensional data (f(x, y)) obtained as in the above, the neighboring three points are extracted, and the sum total of the area of the small triangles that are formed by the three points is obtained. This is the actual surface area Sx. The surface area ratio ΔS is obtained according to the following formula that includes the thus-measured actual surface area Sx and the geometrically-measured surface area So:

$$\Delta S = (Sx - So)/So \times 100\ (\%).$$

So is obtained as So = Lx × Ly. Lx and Ly each indicate the length of the side in the x direction and the y direction, respectively, in the measurement region (rectangle). In the present invention, Lx = Ly = 50 μm.

[Method of Producing Support]

<Aluminium (Alloy) Sheet (rolled aluminium)>

The aluminium (alloy) sheet for use in the invention is selected from pure aluminium sheets, aluminium-based alloy sheets with minor hetero elements, and aluminium-laminated or deposited plastic films. The minor hetero elements to be in the aluminium (alloy) sheets may be one or more elements selected from those listed in the Periodic Table of elements, and their content may be from 0.001 % by weight to 1. 5 % by weight. Typical examples of the hetero atoms that may be in the aluminium (alloy) sheets are silicon, iron, nickel, manganese, copper, magnesium, chromium, zinc, bismuth, titanium, vanadium. In general, known materials described in Aluminium Handbook, 4th Ed. (1990, by the Light Metal Association of Japan) are used herein, such as typically JIS A 1050, JIS A 3103, JIS A 3005, JIS A 1100, JIS A 3004, and those with at most 5 % by weight of magnesium added thereto for increasing the tensile strength of the alloys.

Drink cans may be recycled into aluminium (alloy) sheets for use in the invention, for example, by scrapping them and rolling the resulting ingots that contain a large amount of impurities. According to the method of producing the aluminium support for the photosensitive lithographic printing plate of the invention, even aluminium (alloy) sheets that contain a large amount of minor hetero elements such as those mentioned above may be well electrochemically surface-roughened with an aqueous hydrochloric acid solution to make their surfaces have the intended, uniform grain structure (honeycomb pit structure). For example, even when a large amount of Si is in aluminium (alloy) sheets, it does not cause surface defects in the oxide film formed through anodic oxidation after the surface-roughening treatment of the sheets, and it therefore does no cause printing stains on paper. Further, even if a large amount of Cu is in aluminium (alloy) sheets, it does not increase the area with no honeycomb pits formed therein, and therefore does not worsen the appearance of the surface-processed sheets for the support of the invention.

The aluminium (alloy) sheets to be used in producing the aluminium support for the photosensitive lithographic printing plate of the invention may be those prepared in a mode of DC casting followed by inter-annealing or soaking; or those prepared through direct DC casting with neither inter-annealing nor soaking; or those prepared in a mode of continuous casting with no inter-annealing.

The thickness of the aluminium (alloy) sheets for use in the invention is generally from 0.05 mm to 0.8 mm, preferably from 0.1 mm to 0.6 mm.

In the method of producing the aluminium (alloy) sheet for the photosensitive lithographic printing plate of the invention, the aluminium (alloy) sheet mentioned above is subjected to surface treatment including electrochemical surface-roughening in an aqueous acid solution to obtain an aluminium support for lithographic printing plates. The surface treatment may include other various treatments. In various steps that are employed in the invention, the alloying components of the aluminium (alloy) sheet to be processed may dissolve out in the processing solutions used therein, and therefore, the processing solutions may contain the alloying components of the aluminium (alloy) sheet. In particular, it is desirable that the alloying components are added to the processing solutions so that the solutions could be in a steady state before used for the treatment.

In the invention, various treatments mentioned below may be combined for surface-roughening. Of those, the electrochemical surface-roughening in an aqueous solution that contains hydrochloric acid is indispensable to the invention. Prior to the electrochemical surface-roughening, aluminium (alloy) sheets are preferably subjected to alkali etching or desmutting, or to alkali etching and desmutting in that order. After the electrochemical surface-roughening, the aluminium (alloy) sheets are also preferably subjected to alkali etching or desmutting, o to alkali etching and desmutting in that order. After the electrochemical surface-roughening, the alkali etching may be omitted.

In the invention, it is also desirable that aluminium (alloy) sheets are mechanically surface-roughened before these treatment. If desired, the electrochemical surface-roughening treatment may be effected twice or more. Also if desired, the electrochemical surface-roughening with an aqueous solution that contains hydrochloric acid may be combined with any other type of electrochemical surface-roughening treatment, for example, with an aqueous solution that contains nitric acid. After these treatments, it is also desirable that the aluminium (alloy) sheets are further processed for anodic oxidation, pore-sealing and hydrophilication.

In particular, one preferred embodiment of the surface treatment in the invention comprises alkali etching, desmutting, electrochemical surface-roughening in an aqueous hydrochloric acid solution, alkali etching and/or desmutting, anodic oxidation, and hydrophilication in an aqueous silicate-containing solution in that order.

The steps of mechanical surface-roughening, first alkali etching, first desmutting, first electrochemical surface-roughening, second alkali etching, second desmutting, second electrochemical surface-roughening, third alkali etching, third desmutting, anodic oxidation, pore-sealing and hydrophilication are separately described in detail hereinunder.

In this description, the electrochemical surface-roughening in an aqueous hydrochloric acid solution is referred

to as the first electrochemical surface-roughening; the electrochemical surface-roughening in an aqueous nitric acid solution is referred to as the second electrochemical surface-roughening; and the subsequent treatments after them will be referred to as the n-th electrochemical surface-roughening in order.

The alkali etching to be effected first is referred to as the first alkali etching; and when alkali etching is again effected after different treatments, then it is referred to as the 2nd, . . the n-th alkali etching in order.

The same shall apply to desmutting treatment, which will be therefore referred to as the first, the second, ... n-th desmutting also in order. Preferably, desmutting is effected after alkali etching.

<Mechanical Surface-Roughening>

In the invention, mechanical surface-roughening is preferably effected before electrochemical surface-roughening. Mechanical surface-roughening increases the surface area of the treated aluminium (alloy) sheet.

Before processed for brush graining, aluminium (alloy) sheets are optionally degreased for removing the rolling oil from their surfaces. For example, aluminium (alloy) sheets are degreased with surfactant, organic solvent or alkaline aqueous solution. However, when the amount of the rolling oil deposited is small, the degreasing may be omitted.

Next, using one or at least two different types of brushes that differ in point of the hair diameter, the aluminium (alloy) sheets are subjected to brush graining with an abrasive slurry being applied to the surface of the sheet.

Mechanical surface-roughening is described in detail in, for example, JP-A 6-135175, JP-B 50-40047. The brush used first in the brush graining is referred to as the first brush; and the that used lastly is referred to as the second brush. In Fig. 4, 51 is an aluminium (alloy) sheet; 52 and 53 are roller brushes; 53 is an abrasive slurry; and 55, 56, 57 and 58 are support rollers. For the graining treatment, the roller brushes 52 and 54, and two pairs of support rollers 55, 56, and 57 and 58 are disposed on the opposite sides of the aluminium (alloy) sheet 51, as in Fig. 4. The two support rollers 55, 56, and 57 and 58 are so disposed that the shortest distance between the outer surfaces thereof is smaller than the outer diameter of the roller brush 52, 54, and the aluminium (alloy) sheet 51 is pressed by the roller brushes 52 and 54 so that it could be pushed into the space between the two support rollers 55, 56, and 57, 58. In that condition, the aluminium (alloy) sheet is conveyed at a constant speed, while the abrasive slurry 53 is applied onto the thus-traveling aluminium (alloy) sheet, and the roller brush are rotated on the sheet to polish the surface of the sheet.

Brushes constructed by planting a brush material such as nylon, polypropylene, animal hair, steel wire or the like at a uniform hair length and in a uniform planting distribution on a roller support; those constructed by plating brush hair bundles into small holes formed in a roller support; and channel-roller type brushes are preferably used in the invention. Above all, nylon is preferred for the brush material, and the preferred length of the brush hair is from 10 to 200 mm. Also preferably, the planted hair density of the roller brush is from 30 to 1000 hairs/$cm^2$, more preferably from 50 to 300 hairs/$cm^2$.

Preferably, the hair diameter of the brush is from 0.24 to 0.83 mm, more preferably from 0.295 to 0.72 mm. Also preferably, the cross section of the brush hair is circular. If the hair diameter is smaller than 0.24 mm, the staining resistance of the printing plate in the shadow area will be bad; but if larger than 0.83 mm, the staining resistance of the printing plate on blankets will be also bad. Regarding its material, nylon is preferred for the brush. For example, nylon 6, nylon 6.6, and nylon 6.10 may be sued. Most preferred is nylon 6.10 inview of its tensile strength, abrasion resistance, dimensional stability in wet, folding resistance, heat resistance and restorability.

The number of the brushes is preferably from 1 to 10, more preferably from 1 to 6. If desired, brush rollers that differ in point of the hair diameter may be combined for use herein, as in JP-A 6-135175.

The number of revolutions of the brush roller may be suitably determined within a range of from 100 rpm to 500 rpm. Preferably, the support rollers have a rubber or metal surface, and have good straightness. The rotating direction of the brush rollers is preferably the same as the traveling direction of the aluminium (alloy) sheet, as in Fig. 4. However, when a number of brush rollers are used, some of them may be rotated in the opposite direction to that of the others. The pushing degree by the brushes is preferably controlled by the load applied to the driving motor for brush rotation. Concretely, the driving motor is preferably so controlled that its consumption power is from 1.0 to 10 kW, more preferably from 2 to 10 kW.

In the invention, after the aluminium (alloy) sheets are surface-roughened with the above-mentioned thick brushes, they are preferably processed with thin brushes. Thus processed, the resulting supports may have all the necessary properties of good hydrophilicity, good water retentiveness and good adhesiveness. In this case, the shadow area of the printing plate is not deformed even when the amount of the dampening water applied the printing plate is small, and therefore the water width may be broad and the background area of the printing plate is stained little, and, in addition, the adhesiveness between the support and the photosensitive layer is not worsened.

Preferably, the abrasive slurry for use in the invention is prepared by dispersing an abrasive such as silica sand, aluminium hydroxide, alumina powder, volcanic ash, pumice, carborundum, emery or the like having a mean grain size of from 1 to 50 μm, more preferably from 20 to 45 μm, in water to have a specific gravity of from 1.05 to 1.3. The mean grain size of the abrasive in the slurry is as follows: The cumulative frequency of the ratio of the abrasive grains

of different sizes to the volume of all the abrasive grains in the slurry is determined, and the grain size that corresponds to the cumulative percentage of 50 % is the mean grain size of the abrasive in the slurry.

Preferably, the aluminium (alloy) sheets are mechanically surface-roughened to have a center line average height (Ra) of from 0.3 to 1.0 μm.

Needless-to-say, any other mode of slurry spraying, wire brushing, or transferring the surface profile of an embossed roll to aluminium (alloy) sheets may also be employed in the invention. Such other modes are described in, for example, JP-A 55-074898, 61-162351, 63-104889.

Preferably, the surface of the thus brush-grained aluminium (alloy) sheet is then chemically etched. The chemical etching is for removing the abrasive and the aluminiumdust having gotten into the surface of the brush-grained aluminium (alloy) sheet, and this enables more uniform and more effective treatment of the subsequent electrochemical surface-roughening.

<Chemical Etching in Aqueous Alkaline Solution (first alkali etching)>

The first alkali etching is to etch aluminium (alloy) sheets by contacting the sheet with an alkali solution. In case where the mechanical surface roughening is omitted, the first alkali etching is for removing the rolling oil, the dirt and the spontaneous oxidation film from the aluminium (alloy) sheet (rolled aluminium). On the other hand, when the sheet is processed for mechanical surface-roughening, then the first alkali etching is for dissolving the edges of the surface projections and recesses formed through the mechanical surface-roughening to thereby make the sheet have a smooth and waved surface.

For contacting the aluminium (alloy) sheet with an alkali solution, for example, employable is a method of passing the sheet in a bath with an alkali solution therein, a method of dipping the sheet in a bath with an alkali solution therein, or a method of spraying an alkali solution on the surface of the sheet.

The method of chemical etching as above is described in detail in USP 3,834,398. More concretely, it comprises dipping an aluminium (alloy) sheet in a solution capable of dissolving aluminium, even more concretely in an aqueous alkali solution.

The alkali includes, for example, sodium hydroxide, potassium hydroxide, sodium tertiary phosphate, potassium tertiary phosphate, sodium aluminate, sodium metasilicate, sodium carbonate. Using an aqueous base solution promotes the etching.

Preferably, the chemical etching is effected in an aqueous solution of from 0.05 to 50 weight % alkali, at a liquid temperature of from 40˚C to 100˚C for 5 to 300 seconds. More preferably, the concentration of the aqueous alkali solution is from 1 to 30 % by weight, and the solution may contain not only aluminium but also the alloying components of aluminium alloys in an amount of from 0 to 10 % by weight. Especially preferably, the aqueous alkali solution is an aqueous solution of essentially sodium hydroxide. Preferably, the liquid temperature is from room temperature to 95˚C, and the processing time is from 1 to 120 seconds.

After thus etched, it is desirable that the aluminium (alloy) sheet is wiped with nip rollers and washed with water sprayed thereon in order that the processing liquid is not carried over into the next step.

Regarding the chemical etching rate of the aluminium (alloy) sheet, the dissolution of the sheet on one side thereof is preferably from 0.001 to 30 g/m$^2$, more preferably from 1 to 15 g/m$^2$, even more preferably from 3 to 12 g/m$^2$.

<Acid Etching>

Acid etching is for chemically etching aluminium (alloy) sheets in an aqueous acid solution, and it is preferably effected after the previous electrochemical surface-roughening. In case where the above-mentioned alkali etching is effected before and/or after the electrochemical surface-roughening, then it is also desirable that acid etching is effected after the alkali etching.

When the aluminium (alloy) sheet that has been etched with alkali in the manner as above is etched with acid, then the silica-containing intermetallic compound or the simple substance Si may be removed from the surface of the aluminium (alloy) sheet, and therefore the sheet may be free from surface defects in the oxide film to be formed in the subsequent anodic oxidation. As a result, a printing trouble to give ink peppers that are referred to as dust stains in the non-image background area in prints may be prevented.

The aqueous acid solution to be used for the acid etching may be an aqueous solution that contains phosphoric acid, nitric acid, sulfuric acid, chromium acid, hydrochloric acid, or mixed acid of two or more of these. Above all, aqueous sulfuric acid solution is preferred. Preferably, the concentration of the aqueous acid solution is from 50 to 500 g/liter. The aqueous acid solution may contain not only aluminium but also the alloying components of the aluminium (alloy) sheet.

Preferably, the acid etching is effected at a liquid temperature of from 60 to 90˚C, more preferably from 70 to 80˚C for 1 to 10 seconds. In this treatment, the dissolution of the aluminium (alloy) sheet is preferably from 0.001 to 0.2 g/m$^2$. Also preferably, the acid concentration, for example, the sulfuric acid concentration and the aluminium ion concentration are selected from the range not giving any crystal at room temperature. Preferably, the aluminium ion concentration is from 0.1 to 50 g/liter, more preferably from 5 to 15 g/liter.

After thus etched with acid, it is desirable that the aluminium (alloy) sheet is wiped with nip rollers and washed with water sprayed thereon in order that the processing liquid is not carried over into the next step.

<Desmutting in Aqueous Acid Solution (first desmutting)>

In general, chemical etching in aqueous alkali forms smut on the surface of aluminium. In this case, therefore, the aluminium (alloy) sheet isdesmuttedwithphosphoricacid, nitric acid, sulfuric acid, chromic acid, hydrochloric acid, or mixed acid of two or more of these. Preferably, the concentration of the aqueous acid solution is from 0.5 to 60 % by weight. The aqueous acid solution may contain not only aluminium but also the alloying components of aluminium alloys in an amount of from 0 to 5 % by weight.

Especially preferably, the waste liquid after the electrochemical surface-roughening or the waste after the anodic oxidation is used for the desmutting solution.

The liquid temperature may be from room temperature to 95˚C, preferably from 30 to 70˚C. The processing time is preferably from 1 to 120 seconds, more preferably from 1 to 5 seconds. After thus desmutted, it is desirable that the aluminium (alloy) sheet is wiped with nip rollers and washed with water sprayed thereon in order that the processing liquid is not carried over into the next step. In case where the desmutting solution is the same as the processing solution to be used in the next step or has the same composition as that of the processing solution in the next step, then the wiping treatment and the washing treatment may be omitted.

When an auxiliary anode bath is used in the electrochemical surface-roughening device for preventing the electrode dissolution and for controlling the roughened surface profile and when the auxiliary anode bath is set before the electrochemical surface-roughening bath in which the aluminium plate receives an alternating current and is thereby electrochemically surface-roughened, the desmutting step in an aqueous acid solution before the electrochemical surface-roughening treatment may be omitted.

<Electrochemical Surface-Roughening>

The electrochemical surface-roughening in the invention is characterized in that aluminium (alloy) sheets are electrochemically surface-roughened in an aqueous solution of essentially hydrochloric acid, under a specific condition.

When the electrochemical surface-roughening under a specific condition is followed by anodic oxidation and optionally by mechanical surface-roughening and other various surface treatments described herein, then it attains the object of the invention.

The electrochemical surface-roughening may be effected plural times, and the electrochemical surface-roughening in an aqueous solution of essentially hydrochloric acid may be effected after electrochemical surface-roughening in an aqueous solution of essentially nitric acid.

The electrochemical surface-roughening under a specific condition is described below.

(1) Aqueous solution of essentially hydrochloric acid:

For the aqueous solution of essentially hydrochloric, any one that is generally used in ordinary DC or AC electrochemical surface-roughening is usable in the invention. For example, from 1 g/liter to saturation of at least one of sulfuric acid, hydrochloric acid or nitric acid compounds such as those with sulfate ion, for example, aluminium sulfate, sodium sulfate, ammonium sulfate, or those with nitrate ion, for example, aluminium nitrate, sodium nitrate, ammonium nitrate, or those with chloride ion such as aluminium chloride, sodium chloride, ammonium chloride may be added to from 5 to 25 g/liter of an aqueous hydrochloric acid solution, and the resulting solutions may be used in the invention. If desired, copper or a compound capable of forming a complex may be added to the solution in a ratio of from 1 to 200 g/liter. The aqueous solution of essentially hydrochloric acid may optionally contain a metal that may be in aluminium alloys, for example, iron, copper, manganese, nickel, titanium, magnesium, silica, etc. Also if desired, from 1 to 100 g/liter of hypochlorous acid or hydrogen peroxide may be added to the solution.

More preferably, the aqueous hydrochloric acid solution contains from 1 to 50 g/liter of aluminium ions, which is prepared by adding an aluminium salt (aluminium chloride) to an aqueous solution that contains from 5 to 25 g/liter of hydrochloric acid, and has a liquid temperature of from 15 to 50˚C.

Even more preferably, the aqueous hydrochloric acid solution contains from 5 to 20 g/liter of aluminium ions, which is prepared by adding an aluminium salt (aluminium chloride, $AlCl_3 \cdot 6H_2O$) to an aqueous solution that contains from 1 to 10 g/liter of hydrochloric acid, and has a liquid temperature of from 15 to 50˚C. The electrochemical surface-roughening with the aqueous hydrochloric acid solution of the type enables the roughened surface to have a uniform surface profile. In addition, even when low-purity rolled aluminium alloy sheets (aluminium alloy sheets containing a

large amount of alloying components, or aluminium alloy sheets of which the alloying components are not controlled) are surface-roughened with the acid solution of the type, they are free from a problem of uneven treatment, and the lithographic printing plate that comprises the surface-roughened sheet as its support satisfies the two necessary requirements, printing durability and printability (staining resistance).

Preferably, the aqueous hydrochloric acid contains from 1 to 10g/liter, more preferably from 2 to 6 g/liter of hydrochloric acid.

The amount of the aluminium chloride hexahydrate to be added is preferably from 10 to 70 g/liter, more preferably from 20 to 50 g/liter, even more preferably from 35 to 45 g/liter.

The aluminium ion concentration in the aqueous hydrochloric acid solution with aluminium chloride hexahydrate added thereto is preferably from 1 to 8 g/liter, more preferably from 2 to 6 g/liter, even more preferably from 4 to 5 g/liter.

Additives to the aqueous solution of essentially hydrochloric acid, as well as the device, the power source, the current density, the flow rate and the temperature of the solution may be any ones that are generally used in known electrochemical surface-roughening treatment. For the power source for the electrochemical surface-roughening, direct current or alternating current may be used, but alternating current is especially preferred. The quantity of electricity for the anodic reaction of the aluminium (alloy) sheet that is electrochemically surface-roughened in the aqueous solution of essentially hydrochloric acid may be selected from a range of from 10 to 1000 C/dm$^2$, but preferably from 20 to 80 C/dm$^2$, more preferably from 25 to 60 C/dm$^2$ at the end point of the electrochemical surface-roughening treatment.

(2) Aqueous solution of essentially nitric acid:

The aqueous solution of essentially nitric acid for use herein may be any one generally used in ordinary DC or AC electrochemical surface-roughening. For example, from 1 g/liter to saturation of at least one of hydrochloric acid or nitric acid compounds such as those with nitrate ion, for example, aluminium nitrate, sodium nitrate, ammonium nitrate, or those with chloride ion such as aluminium chloride, sodium chloride, ammonium chloride may be added to from 1 to 100 g/liter of an aqueous nitric acid solution, and the resulting solutions may be used in the invention. If desired, copper or a compound capable of forming a complex may be added to the solution in a ratio of from 1 to 200 g/liter. The aqueous solution of essentially nitric acid may optionally contain a metal that may be in aluminium alloys, for example, iron, copper, manganese, nickel, titanium, magnesium, silica, etc. Also if desired, from 1 to 100 g/liter of hypochlorous acid or hydrogen peroxide may be added to the solution.

More preferably, the aqueous nitric acid solution contains from 3 to 50 g/liter of aluminium ions, which is prepared by adding an aluminium salt (aluminium nitrate) to an aqueous solution that contains from 5 to 15 g/liter of nitric acid, and has a liquid temperature of from 15 to 90°C. Additives to the aqueous solution of essentially nitric acid, as well as the device, the power source, the current density, the flow rate and the temperature of the solution may be any ones that are generally used in known electrochemical surface-roughening treatment. For the power source for the electrochemical surface-roughening, direct current or alternating current may be used, but alternating current is especially preferred. The quantity of electricity for the anodic reaction of the aluminium (alloy) sheet that is electrochemically surface-roughened in the aqueous solution of essentially nitric acid may be selected from a range of from 10 to 1000 C/dm$^2$, but preferably from 30 to 500 C/dm$^2$, more preferably from 45 to 300 C/dm$^2$ at the end point of the electrochemical surface-roughening treatment.

A method that comprises the surface-roughening treatment with the aqueous solution (1) of essentially hydrochloric acid after the electrochemical surface-roughening treatment with the aqueous solution (2) of essentially nitric acid is also effective in the invention. These treatments are free from a problem of uneven treatment, and the lithographic printing plate that comprises the surface-roughened sheet as its support satisfies the two necessary requirements, printing durability and printability (staining resistance).

(3) Electrochemical Surface-Roughening:

The electrochemical surface-roughening is for electrochemically processing an aluminium (alloy) sheet in an aqueous acid solution with direct current or alternating current being applied to the aluminium (alloy) sheet and the electrode that faces it, to thereby roughen the surface of the sheet. In the invention, alternating current is preferred for the treatment. The alternating current may be any of single-phase, two-phase or three-phase AC. Also usable herein is superimposed current of AC and DC.

Any known electrolytic cell may be used for the electrochemical surface-roughening herein. For example, herein usable are vertical, flat or radial electrolytic cells that are generally used for ordinary electrochemical surface-roughening. A plurality of electrolytic cells may be combined for use herein. If desired, the electrochemical surface-roughening may be effected repeatedly, intermitted by any of etching with an aqueous acid or alkali solution, desmutting with an aqueous acid solution, or cathodic electrolysis of aluminium (alloy) sheets in an aqueous acid or neutral salt solution.

a) Power Supply to Aluminium (Alloy) Sheet:

The power-supply system for the aluminium (alloy) sheet to be processed in an electrolytic cell may be a direct power-supply system with a conductor roll, or an in-liquid power-supply system (indirect supply system) with no conductor roll. The electrolytic solution to pass through the electrolytic cell may run therethrough in the direction parallel to or opposite to the direction of the aluminium web (aluminium (alloy) sheet) traveling therethrough. One or more AC sources may be connected to one electrolytic cell. In the indirect power-supply system, it is desirable that the ratio of the quantity of electricity to be applied to the aluminium (alloy) sheet acting as an anode to the quantity of electricity to be applied to it acting as a cathode is controlled according to the method of using auxiliary anodes described in JP-B 6-37716 and 5-42520. Especially preferably, in this, the current to pass through the auxiliary anodes are controlled by commutators such as thyristors, diodes, GTO. According to the method described in JP-B 6-37716, it is easy to control both the quantity of electricity (current) of AC to be applied to the aluminium (alloy) sheet of which the surface is electrochemically roughened while the sheet acts as an anode relative to the main carbon electrode, and that to be applied thereto while the sheet acts as a cathode. Another advantage of the method is that the power source devices for it are easy to construct and inexpensive, and they receive little influence of magnetic deviation of transformers.

For controlling the current value in the electrochemical surface-roughening treatment with a sine-wave AC, any of transformers and variable inductance regulators may be used. In this case, the current value for the electrolysis is fed back to the variable inductance regulator used. For controlling the current value in this case, a thyristor may be used for phase control, as in JP-A 55-25381.

In the electrochemical surface-roughening treatment, if the distance between the aluminium (alloy) sheet being processed and the counter electrode and also the liquid flow rate in the cell are not kept constant, then the current flow will be localized, and if so, the surface of the aluminium (alloy) sheet will be unevenly processed. The aluminium (alloy) sheets thus unevenly processed are unsuitable for lithographic printing plate supports. To solve the problem, a chamber to store the processing liquid therein may be provided in the line, and the processing liquid may be sprayed onto the aluminium web (sheet) through a liquid supply nozzle having 1 to 5 mm-wide slits aligned in the lateral direction of the aluminium web. More preferably, two or more such liquid storage chambers are provided in the line, and these are connected with each other via a pipe provided with a valve and a liquid meter by which the amount of the processing liquid to be sprayed onto the aluminium web through the slits of the liquid supply nozzle is controlled.

Preferably, the distance between the aluminium web and the electrode falls between 5 and 100 mm, more preferably between 8 and 15 mm. For keeping the distance constant, the system described in JP-B 61-30036 may be used, in which the traveling aluminium web is hydrostatically pressed against a sliding surface on which the web slides while it passes through the electrolytic cell. For this, also employable is the method described in JP-A 8-300843, in which the distance between the electrode and the aluminium (alloy) sheet is kept constant by the use of a large-diameter roller.

For electrochemically surface-roughening aluminium (alloy) sheets in a direct power-supply system, preferred is using the conductor roll described in JP-A 58-177441 in the apparatus described in JP-A 56-123400. The conductor roll may be provided either above or below the aluminium (alloy) sheet to be processed, but it is desirable to provide it above the aluminium (alloy) sheet in such a manner that the thus-disposed conductor roll is pressed against the aluminium (alloy) sheet by means of a nipper. The length for which the aluminium (alloy) sheet is kept in contact with the conductor roll preferably falls between 1 mm and 300 mm in the machine direction. A pass roll is provided on the other side opposite to the side of the conductor roll so that the aluminium (alloy) sheet runs between the two rolls. The pass roll is preferably made of rubber. The pressure of the conductor roll and the hardness of the rubber roll are defined in any desired manner, not causing arc spots in the aluminium (alloy) sheet processed. Providing the conductor roll above the aluminium (alloy) sheet facilitates the exchange and the maintenance of the roll. Preferably, the conductor roll is so designed that the rotor at its edge is driven by a power-supply brush disposed in contact with the rotor.

Also preferably, the conductor roll pressed against the aluminium (alloy) sheet is all the time kept cooled with an electrolytic solution of which the composition and the temperature are the same as those of the electrolytic solution used for electrochemically surface-roughening the sheet, in order to prevent the sheet from having arc spots in its roughened surface. If the electrolytic solution applied to the conductor roll for cooling it is contaminated with impurities, it will cause arc spots in the roughened surface of the aluminium (alloy) sheet. To evade the trouble, it is desirable that the cooling liquid spray is protected by a filter cloth cover or the like, or a fine-mesh filter is disposed in the duct upstream the spray nozzle.

b) Electrochemical Surface-Roughening with Alternating Current:

The alternating current for the AC electrochemical surface-roughening may have any waveform of sine waves, rectangular waves, trapezoidal waves, triangular waves. Of those, preferred are rectangular waves and trapezoidal waves, and more preferred are trapezoidal waves. The frequency of the alternating current preferably falls between 0.1 and 500 Hz, more preferably between 40 and 120 Hz, even more preferably between 45 and 65 Hz.

In case where trapezoidal waves are used, the time, tp, for which the current rises from 0 (zero) to the peak preferably falls between 0.1 and 2 msec, more preferably between 0.2 and 1.5 msec. When the time tp is not shorter than 0.1 msec, then any large source voltage is unnecessary for rising up the current waves, owing to the influence of the power source circuit impedance thereon, and therefore the power equipment cost may be reduced. When the time tp is not longer than 2 msec, then the treatment is hardly influenced by the minor elements in the electrolytic solution and therefore facilitates uniform surface roughening. One cycle of the alternating current for the electrochemical surface-roughening treatment is preferably so designed that the ratio of ta/Ta (this is referred to as "duty" in this invention) falls between 0.33 and 0.66, more preferably between 0.45 and 0.55, even more preferably 0.5, in which ta indicates the anodic reaction time of the aluminium (alloy) sheet being processed, and T indicates the AC current period.

In cathodic reaction, an oxide film of essentially aluminium hydroxide is formed on the surface of the aluminium (alloy) sheet, and the oxide film may be dissolved or broken. When the oxide film is dissolved or broken, then the dissolved or broken part thereof serves as the start point of the pitting reaction in the subsequent anodic reaction of the aluminium (alloy) sheet. Accordingly, appropriately selecting the alternating current duty is a matter of great importance for attaining uniform electrolytic surface-roughening treatment.

The quantity of electricity to be applied to the aluminium (alloy) sheet that is opposite to the main electrode may be so controlled that the ratio of the quantity of electricity Qc of the alternating current applied to the aluminium (alloy) sheet acting as a cathode, to the quantity of electricity Qa thereof applied to the aluminium (alloy) sheet acting as an anode, Qc/Qa falls between 0. 9 and 1, but preferably between 0.92 and 0.98, more preferably between 0.94 and 0.96. When the ratio Qc/Qa falls within the range, then the surface-roughening treatment is free from a problem of uneven treatment and the lithographic printing plate that comprises the surface-roughened sheet as its support satisfies the two necessary requirements, printing durability and printability (staining resistance). Contrary to this, if the ratio Qc/Qa is larger than 1. 0, then the electrodes may dissolve. The electricity quantity ratio may be controlled by controlling the voltage from the power source.

In case where the electrolytic surface-roughening treatment is effected in an AC-electrolytic cell having therein auxiliary electrodes that are for dividing the anode current to the main electrode, the ratio Qc/Qa can be controlled to fall within the defined range by controlling the anode current to be divided toward the auxiliary electrodes, for example, as in JP-A 60-43500, 1-52098.

Preferably, the current density falls between 10 and 200 A/dm$^2$ both for Ia on the anode cycle side and for Ic on the cathode cycle side in terms of the peak value of the trapezoidal wave form. Also preferably, the ratio Ia/Ic falls between 0.5 and 3.

The AC electrolytic cell to be used for the electrochemical surface-roughening treatment in the invention may be any known vertical, flat or radial cell generally used for ordinary surface-roughening treatment. Forit, especially preferred are radical or flat electrolytic cells as in JP-A 5-195300. Also preferably, carbon is used for the main electrode, and ferrite for auxiliary anodes.

An electrolytic surface-roughening device that comprises multiple AC-electrolytic cells connected in series is also preferably used in the invention.

The electrolytic cell with auxiliary anodes therein may be disposed before or after the electrolytic cell with main electrodes therein. Preferably, the electrolytic cell with auxiliary anodes therein for electrochemical surface-roughening in an aqueous solution of essentially hydrochloric acid is disposed before the electrolytic cell with main electrodes therein for reducing the frequency of uneven treatment.

If the distance between the inlet (liquid level) of the electrolytic cell with auxiliary electrodes therein and the inlet (liquid level) of the electrolytic cell with main electrodes therein is too long, the intermetallic compounds in the aluminium (alloy) sheet being processed may dissolve in hydrochloric acid owing to the action of the acid to dissolve the compounds and deep holes may be formed in the sheet. If so, the photosensitive layer to cover the area around the deep holes may be thick, and this may cause uneven printing. To evade the trouble, therefore, it is desirable that the time to be taken by the aluminium (alloy) sheet that travels from the inlet (liquid level) of the electrolytic cell with auxiliary electrodes therein to the inlet (liquid level) of the next electrolytic cell with main electrodes therein is not longer than 3 seconds.

For the electrolytic surface-roughening treatment in one or more AC electrolytic cells, the AC mode is preferably so controlled that it includes at least once the quiescent time for which no alternating current flows between the aluminium (alloy) sheet, which is sandwiched between main electrodes separately connected to power source terminals of different, and these main electrodes polarity in one electrolytic cell, and that the quiescent time falls between 0.001 and 0.6 seconds/once. In the defined condition, uniform honeycomb pits are formed throughout the processed surface of the aluminium (alloy) sheet. More preferably, the time falls between 0.005 and 0.55 seconds, even more preferably between 0.01 and 0.5 seconds.

In case where at least two AC electrolytic cells that are connected in series are sued, the time for which no alternating current flows through the aluminium (alloy) sheet that runs in the space between one AC electrolytic cell and the next AC electrolytic cell is preferably from 0.001 to 20 seconds, more preferably from 0.1 to 15 seconds, even more

preferably from 1 to 12 seconds.

Fig. 1 is a schematic cross-sectional view of one example of an electrolytic surface-roughening device equipped with a flat AC electrolytic cell, which is favorable to the invention. In Fig. 1, 2 is an AC electrolytic cell; 4A, 4B and 4C are main electrodes; 6A and 6B are conveyor rollers; 8A is a feed roller; 8B is a take-out roller; and 100 is an electrolytic surface-roughening device. In the electrolytic surface-roughening device 100, an aluminium web (aluminium (alloy) sheet) W is conveyed almost horizontally and electrolytically surface-roughened with a three-phase alternating current (hereinafter referred to as "three-phase AC") being applied thereto.

The electrolytic surface-roughening device 100 is equipped with a thin box-shaped, open-top AC electrolytic cell 2 that extends in the direction a in which the aluminium web W is conveyed; three tabular main electrodes 4A, 4B and 4C disposed in the web traveling direction a in the vicinity of the bottom of the AC electrolytic cell 2, in parallel to the traveling face T under which the aluminium web W is conveyed; conveyor rollers 6A and 6B for conveying the aluminium web B in the AC electrolytic cell 2, one of which is disposed upstream the traveling direction a inside the cell 2 while the other downstream the traveling direction a inside it; a feed roller 8A positioned above the upstream site of the AC electrolytic cell 2, which is for introducing the aluminium web W into the cell 2; and a take-out roller 8B positioned above the downstream site of the AC electrolytic cell 2, which is for leading the aluminium web W having passed through the cell 2, out of the it. The AC electrolytic cell 2 contains the above-mentioned aqueous acid solution therein.

The main electrodes 4A, 4B and 4C are connected to the terminal U, terminal V and terminal W, respectively, of an AC source Tac that generates a three-phase AC. Accordingly, the phase of the alternating current applied to the main electrodes 4A, 4B and 4C is shifted by 120˚ from each other.

The mechanism of the electrolytic surface-roughening device 100 is described below.

The aluminium web W is led into the AC electrolytic cell by the feed roller 8A, and is conveyed by the conveyor rollers 6A and 6B in the traveling direction a at a constant speed.

In the AC electrolytic cell 2, the aluminium web W runs in parallel to the main electrodes 4A, 4B and 4C, while receiving AC from the main electrodes 4A, 4B and 4C. As a result, the aluminium web W undergoes anodic reaction and cathodic reaction alternately occurring therein. While this takes anodic reaction, honeycomb pits are essentially formed, and while in cathodic reaction, a film of aluminium hydroxide is essentially formed, and the surface of the web W is thereby roughened.

As so mentioned hereinabove, the alternating current applied to the main electrodes 4A, 4B and 4C is shifted from each other by 120˚. Therefore, in the main electrode 4B, the anodic reaction and the cathodic reaction are alternately repeated at a phase (phase V) that lags behind the phase (phase U) of the main electrode 4A by 120˚; and in the main electrode 4C, the anodic reaction and the cathodic reaction are alternately repeated at a phase (phase W) that lags behind the phase of the main electrode 4B by 120˚.

Accordingly, in the aluminium web W, the anodic reaction and the cathodic reaction are repeated at a frequency of 3 times that of a case with a single-phase AC of a constant frequency. Therefore, even when the aluminium web W is electrolytically surface-roughened at a high traveling speed and at a high current density in that condition, few chatter marks running in the cross direction are formed on the roughened surface of the processed web W.

Fig. 2 is a schematic cross-sectional view of another example of an electrolytic surface-roughening device equipped with a flat AC electrolytic cell, which is favorable to the invention. In Fig. 2, the same numeral references as in Fig. 1 indicates the same elements as those in Fig. 1, and the others are as follows: 10 is an auxiliary electrolytic cell; 12 is an auxiliary electrode; 14A and 14B are conveyor rollers; 16A is a feed roller; 16B is a take-out roller; 102 is an electrolytic surface-roughening device; and Th1, Th2 and Th3 are thyristors. The electrolytic surface-roughening device 102 comprises the above-mentioned, electrolytic surface-roughening device 100 and an auxiliary electrolytic cell 10 disposed before the AC electrolytic cell 2 of the device 100.

The auxiliary electrolytic cell 10 is a box-shaped open-top cell, which has a tabular auxiliary electrode 12 disposed at around its bottom in parallel to the face T along which the aluminium web W travels through it.

Conveyor rollers 14A and 14B are disposed in the vicinity of the upstream wall and the downstream wall, respectively, of the cell 10, and they are to convey the aluminium web W that runs above the auxiliary electrode 12. A feed roller 16A is disposed in the upstream site above the auxiliary electrolytic cell 10, and it is to lead the aluminium web W into the cell 10. In the downstream site above the cell 10, a take-out roller 16 B is disposed, and it is to lead the aluminium web W having passed through the cell 10, out of the it. The auxiliary electrolytic cell 10 contains the above-mentioned aqueous acid solution therein.

The phase U, phase V and phase W of the AC source Tac are all connected to the auxiliary electrode 12 via thyristors Th1, Th2 and Th3, respectively, therebetween. These thyristors Th1, Th2 and Th3 are so connected to the auxiliary electrode 12 that a current may run from the AC source Tac to the electrode 12 in ignition. Accordingly, since an anodic current runs through the auxiliary electrode 12 in ignition of any of these thyristors Th1, Th2 and Th3, the level of the anodic current that runs through the auxiliary electrode 12 may be controlled through phase control of the thyristors Th1, Th2 and Th3, and the ratio of Qc/Qa may be thereby controlled.

Fig. 3 is a schematic cross-sectional view of one example of an electrolytic surface-roughening device equipped

with a radial AC electrolytic cell, which is favorable to the invention. In Fig. 3, 20 is an AC electrolytic cell; 26A and 26B are main electrodes; 34 is an auxiliary electrolytic cell; 35 is an upstream guide roller; 36 is an auxiliary electrode; 22 is an AC electrolytic cell body; 22A is an opening; 24 is a feed roller; 28A and 28B are supply nozzles; 30A is an upstream guide roller; 30B is a downstream guide roller; 32 is an overflow cell; 34A is the bottom of the auxiliary electrolytic cell; 104 is an electrolytic surface-roughening device; and Th4 and Th5 are thyristors.

The electrolytic surface-roughening device 104 comprises an AC electrolytic cell 20 equipped with an AC electrolytic cell body 22 to contain an aqueous acid solution therein, and a feed roller 24 which is inside the cell body 22 to be rotatable around its axis extending in the horizontal direction and which is to feed the aluminium web W in the direction of the arrow a, or that is, in the direction of from the left side to the right side in Fig. 3. The AC electrolytic cell body 22 contains the above-mentioned aqueous acid solution therein.

The inner wall of the AC electrolytic cell body 22 is nearly cylindrically formed to surround the feed roller 24, on which are provided semi-cylindrical main electrodes 26A and 26B in such a manner that they sandwich the feed roller 24 therebetween. The main electrodes 26A and 26B each are divided into plural small electrodes that are spaced from each other via an insulating spacer disposed between the adjacent ones. The small electrodes may be made of, for example, graphite or metal, and the spacer may be made of, for example, a polyvinyl chloride resin. The thickness of each spacer preferably falls between 1 and 10 mm. Though not shown in Fig. 3, all those spaced small electrodes of both the main electrodes 26A and 26B are connected to the AC source Tac.

At its top, the AC electrolytic cell 20 is opened to have an opening 22A through which the aluminium web W is led in and out of the cell body 22. Near the opening 22A of the cell body 22, provided is a supply nozzle 28A through which an aqueous acid solution is replenished into the cell body 22. Apart from it, an additional supply nozzle 28B is also provided.

Near the opening 22A above the cell 20, disposed are upstream guide rollers 30A for guiding the aluminium web W into the cell body 22, and downstream guide rollers 30B for guiding the aluminium web W that has been electrolyzed in the cell body 22, outside the cell body 22.

In the AC electrolytic cell 20, the cell body 22 is connected to an overflow cell 32 adjacent to its downstream. The overflow cell 32 contains the above-mentioned aqueous acid solution therein. This acts to once pool therein the aqueous acid solution having overflowed out of the cell body 22 to thereby keep the intended constant liquid level of the aqueous acid solution in the cell body 22.

An auxiliary electrolytic cell 34 is disposed in the former stage (upstream) of the cell body 22. The auxiliary cell 34 is shallower than the cell body 22, and its bottom 34A is flat. On the bottom 34A, provided are a plurality of columnar auxiliary electrodes 36. The auxiliary cell 34 contains the above-mentioned aqueous acid solution therein.

The auxiliary electrodes 36 are preferably made of non-corrosive metal such as platinum or ferrite, and they may be tabular.

The auxiliary electrodes 36 are connected in parallel to the main electrode 26A on the side of the AC source Tac on which the main electrode 26A is connected to the source Tac, and a thyristor Th4 is so connected to them in the midway of the current from the AC source Tac that the current flows from that side toward the auxiliary electrodes 36 in ignition.

Also on the side of the AC source Tac on which the main electrode 26B is connected to the source Tac, the auxiliary electrodes 36 are connected in the same manner as above via a thyristor Th5 therebetween. Concretely, the thyristor Th5 is so connected that the current from the source Tac flows from that side toward the auxiliary electrodes 36 in ignition.

Anytime when any of the thyristors Th4 and Th5 is in ignition, an anodic current flows through the auxiliary electrodes 36. Accordingly, the level of the anodic current that passes through the auxiliary electrodes 36 can be controlled through phase control of the thyristors Th4 and Th5, whereby the ratio Qc/Qa can be controlled in any desired manner.

The mechanism of the electrolytic surface-roughening device 104 is described below.

On the left side in Fig. 3, the aluminium web W is first guided into the auxiliary electrolytic cell 34 by the upstream guide roller 35, and then into the electrolytic cell body 22 by the upstream guide rollers 30A. Then, this is led from the left side to the right side in Fig. 3, by the feed roller 24, and then led out of the cell body 22 by the downstream guide rollers 30B.

In the cell body 22 and the auxiliary cell 34, the aluminium web W is roughened on its surface that faces the main electrodes 26A and 26B, by the alternating current applied to the main electrodes 26A and 26B and the anodic current applied to the auxiliary electrodes 36, and almost uniform honeycomb pits are therefore formed in its surface.

(4) Waste Recycle for Surface-Roughening:

It is desirable that the liquids (wastes) in each surface-roughening treatment are recycled as much as possible. In the aqueous sodium hydroxide solution that contains aluminium ions dissolved therein, aluminium may be separated from sodium hydroxide through crystallization. In the aqueous sulfuric acid solution, the aqueous nitric acid solution or

the aqueous hydrochloric acid solution that contains aluminium ions dissolved therein, sulfuric acid, nitric acid or hydrochloric acid may be recovered through electrodialysis or treatment with ion-exchange resin.

The aqueous hydrochloric acid solution with aluminium ions dissolved therein may be evaporated to recover the acid, for example, as in JP-A 2000-282272.

In the invention, it is desirable that the wastes of the electrolytic solutions used in electrochemical surface-roughening treatment are used for desmutting (first, second and third desmutting).

In desmutting before electrochemical surface-roughening or anodic oxidation, it is desirable that a processing solution of the same type as that in the surface-roughening or anodic oxidation after the desmutting is used, more preferably a processing solution of the same composition is used. In that manner, a rinsing step with water to be effected between the desmutting step and the subsequent step may be omitted, and the equipment may be simplified and the wastes may be reduced.

<Chemical Etching in Aqueous Alkali Solution (second and third alkali etching)>

Preferably, second alkali etching is effected after the first electrochemical surface-roughening and before the second electrochemical surface-roughing. This enables uniform treatment in the second electrochemical surface-roughening, and the aluminium (alloy) sheet thus processed may have a uniform surface profile. The lithographic printing plate that comprises the surface-roughened sheet as its support satisfies both good printing durability and good printability.

Also preferably, third alkali etching is effected after the second electrochemical surface-roughening and before anodic oxidation. Through this treatment, the smut component (of essentially aluminium hydroxide) formed in the second electrochemical surface-roughening treatment may be removed and the thus-processed aluminium (alloy) sheet may have a uniform surface profile. The lithographic printing plate that comprises the surface-roughened sheet as its support satisfies both good printing durability and good printability.

The second alkali etching and the third alkali etching may be effected by contacting the aluminium (alloy) sheet with an alkali solution. For the type of the alkali, and the method and the apparatus for contacting the aluminium (alloy) sheet with the alkali solution, the same as those mentioned hereinabove for the first alkali etching may be referred to.

For the alkali to be in the alkali solution, the same as those mentioned hereinabove for the first alkali etching may be referred to.

The concentration of the alkali solutionmay be determined depending on the intended degree of etching, and is preferably from 0.01 to 80 % by weight. Also preferably, the temperature of the alkali solution falls between 20 and 90˚c, and the processing time falls between 1 and 60 seconds.

In the second alkali etching, the degree of dissolution of the roughened surface of the aluminium (alloy) sheet is preferably from 0.001 to 30 g/m$^2$, more preferably from 0.1 to 2 g/m$^2$, even more preferably from 0.1 to 0.6 g/m$^2$.

In the third alkali etching, the degree of dissolution of the roughened surface of the aluminium (alloy) sheet is preferably from 0.001 to 30 g/m$^2$, more preferably from 0.1 to 4 g/m$^2$, even more preferably from 0.2 to 1.5 g/m$^2$.

<Desmutting in Aqueous Acid Solution (second and third desmutting)>

Preferably, second desmutting is effected after the second alkali etching. This enables uniform treatments in the second electrochemical surface-roughening step.

Also preferably, third desmutting is effected after the third alkali etching. In this, the hydroxide formed in the third alkali etching may be removed. Thus processed, the aluminium (alloy) sheet is favorable for supports in lithographic printing plates, as its adhesiveness to the overlying photosensitive layer is high.

The second and third desmutting may be effected, for example, by contacting the aluminium (alloy) sheet with an acid solution of phosphoric acid, hydrochloric acid, nitric acid, sulfuric acid or the like having a concentration of from 0.5 to 30 % by weight. For the method of contacting the aluminium (alloy) sheet with such an acid solution, referred to are the same as those mentioned hereinabove for the first desmutting treatment.

Preferably, the waste of sulfuric acid solution in anodic oxidation that will be mentioned hereinunder is used for the acid solution for the second and third desmutting. In place of the waste, also usable is a sulfuric acid solution having a sulfuric acid concentration of from 100 go 600 g/liter, an aluminium ion concentration of from 1 to 10 g/liter and a liquid temperature falling between 60 and 90˚C.

Preferably, the liquid temperature in the second and third desmutting falls between 25 and 90˚C. Also preferably, the processing time for the second and third desmutting falls between 1 and 180 seconds. The acid solution for the second and third desmutting may contain aluminium and aluminium-alloying components dissolved therein.

<Anodic Oxidation>

For enhancing its surface abrasion resistance, the aluminium (alloy) sheet is subjected to anodic oxidation. The electrolyte to be used for anodic oxidation of the aluminium (alloy) sheet may be any and every one capable of forming a porous oxide film on the aluminium (alloy) sheet. In general, it is sulfuric acid, phosphoric acid, oxalic acid, chromic acid or a mixed acid of these.

The electrolyte concentration is determined depending on the type of the electrolyte used.

The condition for anodic oxidation could not be indiscriminately defined, as varying depending on the electrolyte used. In general, however, the electrolyte concentration may be from 1 to 80 % by weight; the liquid temperature may fall between 5 and 70˚C; the current density may be from 5 to 60 A/dm$^2$; the voltage may be from 1 to 100 V; and the time for electrolyte may be from 10 seconds to 300 seconds. Sulfuric acid-assisted anodic oxidation is generally effected with direct current, but alternating current may also be employed for it. The amount of the oxide film to be formed through anodic oxidation is suitably from 1 to 5 g/m$^2$. If the amount is smaller than 1.0 g/m$^2$, the printing durability of the printing plate that comprises the processed aluminium (alloy) sheet as its support will be not good, and the non-image area of the printing plate will be readily scratched. If so, ink will adhere to the scratches of the printing plate and will cause "stains" in the prints produced. If, however, the amount of the oxide film formed through anodic oxidation is too much, then the oxide film will concentrate in the aluminium-etched area. Therefore, the difference in the amount of the oxide film between the etched area and the center area of the aluminium (alloy) sheet is preferably at most 1 g/m$^2$.

Anodic oxidation in an aqueous sulfuric acid solution is described in detail in JP-A 54-128453, 45303. Preferably, the sulfuric acid concentration is from 10 to 300 g/liter, and the aluminium ion concentration is from 1 to 25 g/liter. More preferably, aluminium sulfate is added to an aqueous sulfuric acid solution having an acid concentration of from 50 to 200 g/liter to thereby make the resulting solution have an aluminium ion concentration of from 2 to 10 g/liter.

The liquid temperature preferably falls between 15 and 60˚C. In the direct current method for anodic oxidation, the current density preferably falls between 1 and 60 A/cm$^2$, more preferably between 4 and 40 A/cm$^2$. In case where the aluminium (alloy) sheet is continuously processed for anodic oxidation, the profile of the current density to be applied thereto is preferably so controlled that the current density is kept low, falling between 5 and 10 A/cm$^2$ in the initial stage, and then gradually increased in the latter stage to reach 30 to 50 A/cm$^2$ or more, in order to prevent local current concentration that will partly yellow the processed plate. In this mode, it is desirable that the current density is gradually increased in 5 to 15 steps. Also preferably, an independent power source is provided in each step, and the current density to be applied to the aluminium (alloy) sheet is suitably controlled to have the intended profile as above, by controlling the current from the independent power sources. For the power supply, preferred is an in-liquid power-supply system with no conductor roll. One example of the anodic oxidation device is described in JP-A 2001-11698.

Needless-to-say, the aqueous sulfuric acid solution for anodic oxidation may contain minor elements that are in the aluminium (alloy) sheet, dissolved therein. During anodic oxidation, aluminium dissolves out into the aqueous sulfuric acid solution being used in the process. For the process control, the sulfuric acid concentration and the aluminium ion concentration of the processing solution must be monitored. In the process, if the aluminium ion concentration of the processing solution, aqueous sulfuric acid solution is set too low, the solution must be frequently exchanged. If so, the waste increases, and it is uneconomical and problematic in point of the protection of the environment. On the contrary, if the aluminium ion concentration of the processing solution is set high, the voltage for electrolysis increases, and it is uneconomical as the power cost increases. Preferred embodiments of the sulfuric acid concentration, the aluminium ion concentration and the liquid temperature in anodic oxidation are mentioned below.

Embodiment 1:

Sulfuric acid concentration: 100 to 200 g/liter (more preferably 130 to 180 g/liter).
Aluminium ion concentration: 2 to 10 g/liter (more preferably 3 to 7 g/liter).
Liquid temperature: 15 to 40˚C (more preferably 33 to 38˚C).

Embodiment 2:

Sulfuric acid concentration: 50 to 125 g/liter (more preferably 80 to 120 g/liter).
Aluminium ion concentration: 2 to 10 g/liter (more preferably 3 to 7 g/liter).
Liquid temperature: 40 to 70˚C (more preferably 50 to 60˚C).

For power supply to the aluminium (alloy) sheet to be processed for anodic oxidation, employable is any of a direct power-supply system in which the power is directly applied to the sheet via a conductor roll, and an in-liquid power-supply system in which the power is indirectly applied to the sheet via the electrolytic solution therein.

For the direct power-supply system, generally used is a low-speed low-current anodic oxidation device in which the aluminium (alloy) sheet is conveyed at a relatively low line speed of 30 m/min or lower; and for the indirect power-supply system, generally used is a high-speed high-current anodic oxidation device in which the sheet is conveyed at a high line speed of higher than 30 m/min.

For the indirect power-supply system, employable is a mountain-shaped or straight cell layout, for example, as in Continuous Surface Processing Technology (by the General Technology Center of Japan, September 30, 1986), page 289. High-speed high-current devices are unsuitable to the direct power-supply system with a conductor roll, as causing sparks between the conductor roll and the aluminium (alloy) sheet running around the roll.

In both the direct power-supply system and the indirect power-supply system, it is desirable that the anodic oxidation step is divided into at least two stages for reducing the energy loss to be caused by the voltage drop inside the aluminium (alloy) sheet, and more preferably, a direct current power source is provided to connect the power supply cell and the oxidation cell or the conductor roll and the oxidation cell in each electrolytic device.

In the direct power-supply system, the conductor roll is generally formed of aluminium. For prolonging their life, it is desirable that the rolls are produced by homogenizing cast rolls of industrial pure aluminium at a high temperature to thereby convert the Al-Fe crystal matter in the surface thereof into a single phase of $Al_3Fe$ to improve the corrosion resistance of the rolls, as in JP-B 61-50138.

A large current is applied to the aluminium (alloy) sheet in the step of anodic oxidation of the sheet. In the step, therefore, the aluminium (alloy) sheet receives the Lorentz's force from the magnetic field generated by the current running through the bus bar in the device. One problem with it in that condition is that the aluminium (alloy) sheet meanders while processed for anodic oxidation. To solve the problem, preferred is the method described in JP-A 57-51290.

In addition, from the magnetic field generated by the large current running through it, the aluminium (alloy) sheet further receives Lorentz's force that acts toward the center of the sheet in the cross direction thereof. In that condition, therefore, the aluminium (alloy) sheet is often bent while processed for anodic oxidation. To solve the problem, it is desirable to provide plural pass rollers having a diameter of from 100 to 200 mm in each anodic oxidation cell at pitch intervals of from 100 to 3000 mm in such a manner that they overlap at an angle of from 1 to 15 degrees to thereby prevent the aluminium (alloy) sheet from being bent owing to the Lorentz's force which the sheet has received.

The amount of the oxide film formed on the aluminium (alloy) sheet through anodic oxidation varies in the cross direction of the sheet. Concretely, it is larger at the edges of the sheet, and the oxide film formed around the edges thereof is thicker. One problem with it is that the aluminium (alloy) sheet could not be well wound up in a winding device. To solve the problem, the processing solution in the anodic oxidation device is stirred, for example, as in JP-B 62-30275 and 55-21840. If the problem could not be well solved even by the method, it is desirable to oscillate the sheet-winding device in the cross direction of the sheet, at a frequency of from 0.1 to 10 Hz to a degree of amplitude of from 5 to 50 mm. Combining the solution stirring method and the device oscillating method is especially preferred for completely solving the problem.

Sulfuric acid-assisted anodic oxidation is generally effected with direct current, but alternating current may also be employed for it. The amount of the oxide film to be formed through anodic oxidation is suitably from 1 to 10 $g/m^2$. For the materials of ordinary lithographic printing plates, the amount of the oxide film to be formed through anodic oxidation is from 1 to 5 $g/m^2$. When the amount is at least 1 $g/m^2$, then the printing durability of the printing plate that comprises the processed aluminium (alloy) sheet as its support is good and the non-image area of the printing plate is hardly scratched. In the case, in addition, ink will not adhere to the scratches of the printing plate to cause "stains" in the prints produced. If, however, the amount of the oxide film formed through anodic oxidation is too much, then the oxide film will concentrate in the aluminium-etched area. Therefore, the difference in the amount of the oxide film between the etched area and the center area of the aluminium (alloy) sheet is preferably at most 1 $g/m^2$. For continuous anodic oxidation, generally employed is the in-liquid power-supply system. For the anode via which a current is applied to the aluminium (alloy) sheet, usable is any one made of lead, iridium oxide, platinum or ferrite. For it, especially preferred is an iridium oxide-based anode. The base material for the anode is coated with iridium oxide. For the base to be coated with iridium oxide to give the coated anode, preferred are bulb metals such as titanium, tantalum, niobium and zirconium. For it, more preferred are titanium and niobium. The bulb metals have relatively large electric resistance. Therefore, it is more desirable that a core of copper is cladded with such a bulb metal to form the base. In case where a copper core is cladded with such abulbmetal, it is difficult to construct a base having a too much complicated structure. In such a case, in general, some divided electrode parts are separately coated with iridium oxide and assembled with bolts and nuts into the desired structure.

In the invention, it is desirable that the acid waste in the anodic oxidation is used in the desmutting treatment (first, second and third desmutting) for simplifying the desmutting liquid supply system and the concentration control

system, and for reducing the equipment cost.

<Hydrophilication>

The aluminium (alloy) sheet thus processed in the manner as above may be hydrophilicated in any desired manner generally employed in producing aluminium supports for lithographic printing plates. Preferably, it is processed with alkali metal silicate. This is described in detail hereinunder.

After processed for anodic oxidation, the aluminium (alloy) sheet is washed with water and then further processed in the manner mentioned below for preventing the oxide film from dissolving in developer, for preventing the photosensitive component from remaining after development, for increasing the mechanical strength of the oxide film, for enhancing the hydrophilicity of the oxide film and for increasing the adhesiveness of the aluminium sheet support to the overlying photosensitive layer. One is silicate treatment of contacting the oxide film of the aluminium (alloy) sheet with an aqueous solution of alkali metal silicate. In this case, the concentration of the alkali metal silicate in the solution may be generally from 0.1 to 30 % by weight, preferably from 0.5 to 5 % by weight. The aluminium (alloy) sheet is contacted with the aqueous solution having a pH at 25˚C of from 10 to 13.5, for 0.5 to 120 seconds at a temperature falling between 5 and 80˚C, preferably between 10 and 70˚C, more preferably between 15 and 50˚C. For contacting them, employable is any mode of dipping or spraying. If the pH of the aqueous solution of alkali metal silicate is lower than 10, the solution may gel; but if higher than 13.5, the solution may dissolve the oxide film.

The alkali metal silicate for use in the invention includes, for example, sodium silicate, potassium silicate, lithium silicate. A hydroxide is used for controlling the pH of the aqueous solution of alkali metal silicate, and it includes, for example, sodium hydroxide, potassium hydroxide, lithium hydroxide. The processing solution may additionally contain an alkaline earth metal salt or a Group IVA (Group 4) metal salt. The alkaline earth metal salt includes, for example, nitrates such as calcium nitrate, strontium nitrate, magnesium nitrate, barium nitrate; and other water-soluble salts such as sulfates, hydrochlorides, phosphate, acetate, oxalates, borates. The Group IVA (Group 4) metal salt includes, for example, titanium tetrachloride, titanium trichloride, potassium titanium fluoride, potassium titanium oxalate, titanium sulfate, titanium tetraiodide, zirconium oxychloride. One or more different types of such alkaline earth metal or Group IVA (Group 4) metal salts may be used either singly or as combined. The amount of the metal salt that may be in the processing solution is preferably from 0.01 to 10 % by weight, more preferably from 0.05 to 5.0 % by weight.

The Si deposition on the processed aluminium (alloy) sheet is preferably from 1.0 to 12.0 $mg/m^2$, more preferably from 2.0 to 9. 0 $mg/m^2$. When it is at least 1.0 $mg/m^2$, then the sensitivity of the printing plate that comprises the processed aluminium (alloy) sheet as its support is good; and when it is at most 12.0$mg/m^2$, then the printing durability, especially the printing durability after burning of the printing plate is good.

The Si deposition may be measured, for example, in a calibration curve method to be attained by the use of a fluorescent X-ray analyzer in which the amount is measured in terms of the amount of the Si atom in a sample ($mg/m^2$). Concretely, a fluorescent X-ray analyzer, Rigaku Denki's RIX3000 is used, and the amount of the Si atom in a sample is determined from the peak height of the Si-K$\alpha$ spectral pattern of the sample, under the condition mentioned below.

Device: Rigaku Denki Kogyo's RIX3000
X-ray bulb: Rh
Spectrum for measurement: Si-K$\alpha$
Bulb voltage: 50 kV
Bulb current: 50 mA
Slit: Coarse
Analyzing crystal: RX4
Detector: F-PC
Area for analysis: 30 mm$\phi$
Peak position (2 $\theta$): 144.7d deg.
Background (2 $\theta$): 140.70 deg., 146.85 deg.
Total time: 80 sec/sample

<Pore-Sealing>

In addition, the processed aluminium (alloy) sheet may be further processed for pore-sealing which is well known as a treatment of pore-sealing of oxide film formed in ordinary anodic oxidation. For example, various modes of pore-sealing with steam, pore-sealing with boiling water (hot air), pore-sealing with metal salt (chromate/bichromate, or nickel acetate), pore-sealing by dipping in oil or fat, pore-sealing with synthetic resin, or pore-sealing at low temperature (with red prussiate of potash, or alkaline earth metal) may be employed herein. In view of the properties (adhesiveness to photosensitive layer, and hydrophilicity) of the sheet as supports for printing plates, and of rapid processability,

inexpensiveness and environmental protection, pore-sealing with steam is relatively preferred. Concretely, pressurized or normal-pressure steam is continuously or non-continuously applied to the oxide film of the aluminium (alloy) sheet that has been processed for anodic oxidation, for example, as in JP-A 4-176690. The relative humidity may be at least 70 %, the steam temperature may be 95˚C or higher, and the processing time may fall between 2 and 180 seconds or so. Apart from the method, any other pore-sealing method is also employable herein. For example, the aluminium (alloy) sheet is dipped in hot water or aqueous alkaline solution at 80 to 100˚C or so or sprayed with it, or alternatively to it or successively to it, the sheet is dipped in or sprayed with a nitrite solution. Preferred examples of the nitrite and others that may be in the nitrite solution are $LiO_2$, $NaNO_2$, $KNO_2$, $Mg(NO_2)_2$, $Ca(NO_2)_2$, $Zn(NO_3)_3$, $Al(NO_2)_3$, $Zr(NO_2)_4$, Sn $(NO_2)_3$, $Cr(NO_2)_3$, $Co(NO_2)_2$, $Mn(NO_2)_2$, $Ni(NO_2)_2$. More preferred are alkali metal nitrates. Two ormore different types of such nitrites may be combined for use herein.

The processing condition could not be indiscriminately determined, as varying depending on the condition of the aluminium (alloy) sheet to be processed and on the type of the alkali metal used. For example, when sodium nitrite is used, its concentration may be generally from 0.001 to 10 % by weight, preferably from 0.01 to 2 % by weight, its bath temperature may be generally from room temperature to about 100˚C or so, preferably from 60 to 90˚C, and the processing time may fall generally between 15 and 300 seconds, preferably between 10 and 180 seconds. Preferably, the pH of the aqueous nitrite solution is controlled to fall between 8.0 and 11.0, more preferably between 8.5 and 9.5. For controlling the pH of the aqueous nitrite solution to fall within the range, for example, alkali buffer is preferably used. The alkali buffer is not specifically defined, but its preferred examples are an aqueous solution of a mixture of sodium hydrogencarbonate and sodium hydroxide, an aqueous solution of a mixture of sodium carbonate and sodium hydroxide, an aqueous solution of a mixture of sodium carbonate and sodium hydrogencarbonate, an aqueous solution of a mixture of sodium chloride and sodium hydroxide, an aqueous solution of a mixture of hydrochloric acid and sodium carbonate, and an aqueous solution of a mixture of sodium tetraborate and sodium hydroxide. The alkali buffer may contain a salt of alkali metal except sodium, for example, potassium salt. After processed with silicate or processed for pore-sealing in the manner as above, the aluminium (alloy) sheet may be still further processed with an aqueous acid solution or may be subbed for hydrophilication as in JP-A 5-278362, or may be coated with an organic layer as in JP-A 4-282637 and 7-314937, for further increasing its adhesiveness to the overlying photosensitive layer.

The process of producing the aluminium support for the lithographic printing plate of the invention may further include any additional steps such as those mentioned below, in addition to the above-mentioned treatments.

<Method of Washing Aluminium (Alloy) Sheet with Water>

After the aluminium (alloy) sheet has been processed in an aqueous alkali solution or mechanically surface-roughened with abrasive, it is generally washed for removing the chemical and the abrasive from the surface of the sheet.

In general, the washing treatment is effected between the processing tanks that differ in the type or the composition of the chemical therein. Preferably, the time after the previous processing tank to the washing step, or the time after the washing step to the next processing tank is not longer than 10 seconds, more preferably from 0.1 to 10 seconds. So far as the time is not longer than 10 seconds, the surface of the sheet being processed does not undergo any chemical change and will be therefore free from a trouble of uneven treatment.

The distance between the processing tanks that are adjacent to each other via the washing step therebetween corresponds to the time for which the aluminium (alloy) sheet being processed travels between the two tanks, and it is preferably at most 15 seconds, more preferably at most 5 seconds. So far as the time is not longer than 15 seconds, the surface of the sheet being processed does not undergo any chemical change and it may be uniformly roughened in the subsequent step.

For washing the aluminium (alloy) sheet, the methods mentioned below are preferred. Especially preferred is the washing system with dry ice powder for the purpose of reducing the water drainage.

(1) Washing with water:

For washing the aluminium support for lithographic printing plates, generally employed is a method of wiping the aluminium (alloy) sheet for the support with nip rollers followed by spraying water thereon from a spray tip. Preferably, water is sprayed on the aluminium (alloy) sheet at an angle of from 45 to 90 degrees in the downstream direction in which the sheet travels. The spray pressure of water may fall generally between 0.5 and 5 $kg/cm^2$ in terms of the pressure just below the spray nozzle, and the liquid temperature preferably falls between 10 and 80˚C. Also preferably, the traveling speed of the aluminium (alloy) sheet is from 20 to 200 m/min. Also preferably, the amount of water to be sprayed on the aluminium (alloy) sheet is from 0.1 to 10 liters/m2 in one washing step. In one washing tank, at least two sprays are provided both on the surface side of the sheet and on the back side thereof, and water is sprayed on the sheet through these sprays. One spray nozzle has from 5 to 30 spray tips disposed at pitch intervals of from 50 to 200 mm. The spray angle of the spray tip is preferably from 10 to 150 degrees, and the distance between the aluminium (alloy)

sheet and the spray tip is preferably from 10 to 250 mm. The cross-sectional profile (spray pattern) of the spray tip may be ring-like, circular, oval, square or rectangular, but is preferably circular, oval, square or rectangular. The flow rate distribution (the distribution of water sprayed on the surface of the aluminium (alloy) sheet) may be circular, uniform or mountain-shaped distribution. In case where plural spray nozzles are disposed in parallel and water is sprayed through their spray tips, then the flow rate distribution is preferably mountain-like one that facilitates uniform spraying on the entire surface region of the sheet. The flow rate distribution varies, depending on the spray pressure and on the distance between the spray tips and the aluminium (alloy) sheet. The grain size of the spray water also varies, depending on the structure of the spray tips, the spraying pressure and the spraying amount. Preferably, it is from 10 to 10000 $\mu$m, more preferably from 100 to 1000 $\mu$m. Also preferably, the material of the spray nozzles is resistant to abrasion by the liquid that runs through them at high speed. Concretely, brass, stainless and ceramics may be used for it. Especially preferred for use herein are ceramic nozzles.

The spray nozzles with such spray tips may be disposed at an angle of from 45 to 90 degrees in the direction in which the aluminium (alloy) sheet travels. Preferably, they are so disposed that the longer center line of the spray pattern may be perpendicular to the sheet traveling direction.

The washing time for which the aluminium (alloy) sheet passes through the washing step is preferably not longer than 10 seconds, more preferably from 0.5 to 5 seconds from the industrial viewpoint.

(2) Washing with Dry Ice Powder:

The aluminium (alloy) sheet may also be washed with dry ice powder by spraying it on the both surfaces of the sheet. For it, for example, a known shot-blasting device as in JP-A 10-66905 may be used. Known jet nozzles as in JP-A 10-28901 and 10-28902 may be disposed on both sides of the aluminium (alloy) sheet. They may be disposed in one line in the cross direction, but are preferably disposed obliquely so that the spray patterns may partly overlap with each other in the cross direction of the aluminium (alloy) sheet. The distance between the jet nozzles and the aluminium (alloy) sheet is preferably from 1 to 100 mm, more preferably from 10 to 50 mm.

For producing the powdery dry ice for use herein, for example, employable is the apparatus described in JP-UM-A7-38104. The jet gas may be $GN_2$ gas or air. The powdery dry ice is from 1 to 1000 $\mu$m in size, and its mean grain size is preferably from 10 to 100 $\mu$m. The amount of $LCO_2$ (liquefied carbon dioxide) to be fed into the system through one jet nozzle is preferably from 0.1 to 1 kg/min, and its supply pressure is preferably from 1 to 20 MPa. The washing pressure on the aluminium (alloy) sheet is preferably from 1 to 20 MPa.

<Material of Pass Roll>

The pass roll may be selected from metal rolls, resin rolls, rubber rolls and nonwoven fabric rolls that are used in continuous production lines formetal-platedor lined known steel products, plated products, electrolytic capacitors, PS plates and others.

The material of the roll and the physical properties of its surface are determined in accordance with the chemical to be used and the condition of the aluminium surface to be processed and in consideration of the corrosion resistance, the abrasion resistance, the heat resistance and the chemical resistance of the roll. The metal roll is generally a hard chromium-plated roll. The rubber roll is generally formed of natural rubber, isoprene rubber, styrene-butadiene rubber, butadiene rubber, butyl rubber, chloroprene rubber, chlorosulfonated polyethylene, nitrile rubber, acrylic rubber, epichlorohydrin rubber, urethane rubber, polysulfide rubber, fluoro-rubber or the like, optionally with minor additives thereto. Preferably, the hardness of the rubber roll is from 60 to 90.

According to the method of producing aluminium supports for lithographic printing plates of the invention described hereinabove, even low-purity aluminium alloy sheets (aluminium alloy sheets containing a large amount of alloying components, or aluminium alloy sheets of which the alloying components are not controlled) may be well processed into aluminium supports that are uniformly surface-roughened and are therefore suitable for lithographic printing plates. In addition, when the aluminium support thus obtained according to the production method of the invention is incorporated in a photosensitive lithographic printing plate precursor having a photosensitive layer formed on the support therein and when the precursor is processed to give a lithographic printing plate, then the printing plate has good printability and good printing durability.

[B. Subbing Layer]

In the invention, an inorganic subbing layer of a water-soluble metal salt such as zinc borate or an organic subbing layer may be formed, if desired, on the support produced in the manner as above, before a photosensitive layer is formed thereon.

The organic compound that may be used for the organic subbing layer includes, for example, carboxymethyl

cellulose; dextrin; gum arabic; polymer and copolymer having a sulfonic acid group in its side branches; copolymer having an onium salt or acid group in its side branches; polyacrylic acid; amino group-having phosphonic acids such as 2-aminoethylphosphonic acid; optionally-substituted organic phosphonic acids such as phenylphosphonic acid, naphthylphosphonic acid, alkylphosphonic acid, glycerophosphonic acid, methylenediphosphonic acid, ethylenediphosphonic acid; optionally-substituted organic phosphoric acids such as phenylphosphoric acid, naphthylphosphoric acid, alkylphosphoric acid, glycerophosphoric acid; optionally-substituted phosphinic acids such as phenyl phosphinic acid, naphthylphosphinic acid, alkylphosphinic acid, glycerophosphinic acid; amino acids such as glycine, β-alanine; hydroxyl group-having amine hydrochlorides such as triethanolamine hydrochloride; and yellow dyes. One or more of these may be used either singly or as combined.

The organic subbing layer may be formed by dissolving the above-mentioned organic compound in water or an organic solvent such as methanol, ethanol or methyl ethyl ketone, or a mixed solvent of these, and applying the resulting solution onto an aluminium (alloy) sheet and drying it. The concentration of the solution of the above-mentioned organic compounddissolved therein is preferably from 0.005 to 10 % by weight. The coating method is not specifically defined. For example, employable is any method of bar coating, spin coating, spraying, curtain coating or the like.

The dry amount of the organic subbing layer is preferably from 2 to 200 mg/$m^2$, more preferably from 5 to 100 mg/$m^2$. Within the range, the printing durability of the printing plate fabricated herein is good.

The dry amount of the inorganic subbing layer is preferably from 0.1 to 100 mg/$m^2$, more preferably from 0.5 to 20 mg/$m^2$.

[C. Photopolymerization Layer]

The photopolymerizing photosensitive composition that constitutes the photopolymerization layer to be in the photosensitive lithographic printing plate of the invention comprises, as the indispensable components thereof, a polymer binder, an addition-polymerizable ethylenic unsaturated bond-having compound, and a photopolymerization initiator (system), and optionally contains other various compounds such as colorant, plasticizer, thermal polymerization inhibitor, etc.

<a. Polymer Binder>

The polymer binder should function as a film-forming agent for the photopolymerizing photosensitive composition in the photopolymerization layer, and in addition, it should dissolve in an alkali developer. For it, therefore, organic polymers that are soluble or swellable in aqueous alkali are used. For example, when the organic polymers are soluble in water, then the printing plate is developable with water. The organic polymers of the type are, for example, addition polymers having a carboxylic acid group in the side branches thereof such as those described in JP-A 59-44615; JP-B 54-34327, 58-12577, 54-25957, JP-A 54-92723, 59-53836, 59-71048. Their examples aremethacrylicacidcopolymer, acrylic acid copolymer, itaconic acid copolymer, crotonic acid copolymer, maleic acid copolymer, and partially-esterified maleic acid copolymer.

Acid cellulose derivatives having a carboxylic acid group in the side branches thereof are also usable for the polymer binder. In addition, additive derivatives prepared by adding a cyclic acid anhydride to hydroxyl group-having addition polymers are usable for it. Of those, especially preferred for use herein are [benzyl (meth)acrylate/(meth)acrylic acid/optional other addition-polymerizable vinyl monomer] copolymer, and [allyl (meth)acrylate/(meth)acrylic acid/optional other addition-polymerizable vinyl monomer] copolymer. Apart from these, also usable are water-soluble organic polymers such as polyvinylpyrrolidone and polyethylene oxide. In addition, alcohol-soluble polyamides, and polyethers of 2,2-bis-(4-hydroxyphenyl)-propane and epichlorohydrin ether are effective for enhancing the strength of cured films. Further, the polyurethane resins described in JP-B 7-120040, 7-120041, 7-120042, 8-12424, and JP-A 63-287944, 63-287947, 1-271741, 11-352691 are favorable for the use of the invention.

Introducing a radical-reactive group into the side branches of these organic polymers increases the strength of cured films. The group includes an addition-polymerizable functional group such as an ethylenic unsaturated group, an amino group, an epoxy group; a functional group capable of forming a radical through exposure to light, such as a mercapto group, a thiol group, a halogen atom, a triazine structure, an onium salt structure; and a polar group such as a carboxyl group, an imido group. For the addition-polymerizable functional group, especially preferred is an ethylenic unsaturated group such as an acrylic group, a methacrylic group, an allyl group, a styryl group. For it, also usable is a functional group selected from an amino group, a hydroxyl group, a phosphonic acid group, a phosphoric acid group, a carbamoyl group, an isocyanate group, an ureido group, a ureylene group, a sulfonic acid group, and an ammonio group.

For ensuring good developability of the photosensitive layer, it is desirable that the polymer binder has a suitable molecular weight and a suitable acid value. Concretely, the weight-average molecular weight of the polymer binder may be generally from 5000 to 1,000,000, preferably from 5000 to 300,000; and the acid value thereof may be generally from 0.1 to 5.0 meq/g.

Any desired amount of the polymer binder may be mixed in the composition for the photosensitive layer. Concretely, it may be at most 90 % by weight for good results in point of the strength of the image to be formed. Preferably, it is from 10 to 90 % by weight, more preferably from 30 to 80 % by weight.
The ratio by weight of the photopolymerizable ethylenic unsaturated bond-having compound to the polymer binder preferably falls between 1/9 and 9/1, more preferably between 2/8 and 8/2, even more preferably between 3/7 and 7/3.
In the photosensitive lithographic printing plate of the first aspect of the invention, at least one of organic polymer compounds having an amido group in the side branches thereof and polyurethane resins is used for the polymer binder.

<a. Organic Polymer Compound with amido group in side branches>

The organic polymer compound having an amido group in the side branches thereof (hereinafter referred to as "amino group-having polymer binder") is a polymer binder which has an amido group in the side branches thereof and which is substantially soluble in aqueous alkali.
The weight-average molecular weight of the amido group-having polymer binder is preferably from 10,000 to 1,000,000. The amido group-having polymer binder may be prepared through ordinary radical polymerization of a radical-polymerizing compound that has an amido group in its side branches or of a radical-polymerizing compound that has an amido group in its side branches and any other polymerizing compound, for which generally employed is a mode of suspension polymerization or solution polymerization.
The effect of the side-branch amido group is that the hydrogen-bonding property of the amido group reinforces intermolecular aggregation of polymer molecules to give tough films, and therefore the image strength after photopolymerization is high and the printing durability of the printing plate is thereby improved, and, in addition, the hydrophilic property of the amido group gives photopolymerizing compositions of good developability.
The amido group-having polymer binder is preferably a polymer that has an amido group of the following formula (M1) in the side branches thereof, more preferably an amido group-having polymer binder that additionally has an alkenyl-containing group of the following formula (M2), even more preferably an amido group-having polymer binder that additionally has a carboxyl group along with the alkenyl-containing group of the following formula (M2).

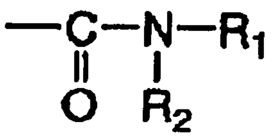

(M1)

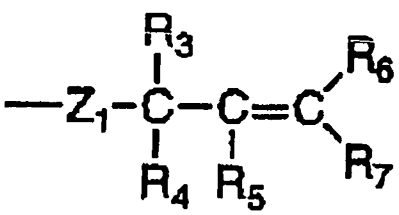

(M2)

In formula (M1), $R_1$ and $R_2$ each independently represent a hydrogen atom, or an optionally-substituted alkyl, alkenyl, alkynyl, aryl or heterocyclic group, or a substituted sulfonyl group, and $R_1$ and $R_2$ may bond to each other to form a cyclic structure. In formula (M2), $R_3$ to $R_7$ each independently represent a hydrogen atom, a halogen atom, a carboxyl group, a sulfonato group, a nitro group, a cyano group, an amido group, an amino group, or an optionally-substituted alkyl, alkenyl, alkynyl or aryl group, or a substituted oxy group, or a substituted sulfonyl group, $Z_1$ represents an oxygen atom, a sulfur atom, or $NR_8$ (where $R_8$ represents a hydrogen atom or an alkyl group).
The part of formula (M2) contributes to improving the sensitivity, the ink acceptability, the image gradation and the printing durability of the printing plate; and the carboxyl group to improving the developability thereof.
The polymer that has an amido group of formula (M1), an alkenyl-containing group of formula (M2) and a carboxyl group in the side branches thereof is especially preferred for the amido group-having polymer binder for use herein. More preferably, the polymer of the type is prepared through ordinary radical polymerization of the following monomers i) to iii) :

i) radical-polymerizing compound having a group of formula (M1),

ii) radical-polymerizing compound having a group of formula (M2),

iii) radical-polymerizing group having a carboxyl group.

Regarding the preferred content of the respective groups in the polymer, i) is from 5 to 80 mol%, more preferably from 10 to 80 mol%, ii) is from 10 to 90 mol%, more preferably from 20 to 80 mol%, and iii) is from 3 to 30 mol%, more preferably from 5 to 25 mol%, all in terms of the amount of the respective group-having radical-polymerizing compounds to be fed into a reactor.

The amido group of formula (M1) and the alkenyl-containing group of formula (M2) are described below.

Preferred examples of $R_1$ to $R_7$ in formulae (M1) and (M2) are described in detail. The alkyl group for $R_1$ to $R_7$ may be a linear, branched or cyclic alkyl group having from 1 to 20 carbon atoms, concretely including a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group. Of those, more preferred are a linear alkyl group having from 1 to 12 carbon atoms, a branched alkyl group having from 3 to 12 carbon atoms, and a cyclic alkyl group having from 5 to 10 carbon atoms.

The substituent for the substituted alkyl group for $R_1$ to $R_7$ is a monovalent non-metallic atomic group except hydrogen atom, and its preferred examples are a halogen atom (-F, -Br, -Cl, -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, an ureido group, an N'-alkylureido group, an N',N'-dialkylureido group, an N'-arylureido group, N', N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N, N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugate base group (referred to as "sulfonato group"), an alkoxysulfonylgroup,an aryloxysulfonylgroup,asulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugate base group (referred to as "phosphonato group"), a dialkylphosphono group ($-PO_3(alkyl)_2$), a diarylphosphono group ($-PO_3(aryl)_2$), an alkylarylphosphonogroup ($-PO_3(alkyl)(aryl)$), a monoalkylphosphono group ($-PO_3H(alkyl)$) and its conjugate base group (referred to as "alkylphosphonato group"), a monoarylphosphono group ($-PO_3H(aryl)$) and its conjugate base group (referred to as "arylphosphonato group"), a phosphonoxy group ($-OPO_3H_2$) and its conjugate base group (referred to as "phosphonatoxy group"), a dialkylphosphonoxy ($-OPO_3(alkyl)_2$), a diarylphosphonoxy group ($-OPO_3(aryl)_2$), an alkylarylphosphonoxy group ($-OPO_3(alkyl)(aryl)$), a monoalkylphosphonoxy group ($-OPO_3H(alkyl)$) and is conjugate base group (referred to as "alkylphosphonatoxy group"), a monoarylphosphonoxy group ($-OPO_3H(aryl)$) and is conjugate base group (referred to as "arylphosphonatoxy group"), a cyano group, a nitro group, an aryl group, an alkenyl group, an alkynyl group, a heterocyclic group, a silyl group.

For specific examples of the alkyl group in these substituents, referred are the alkyl groups mentioned above. Specific examples of the aryl group are a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a cyanophenyl group, a sulfophenyl group, a sulfonatophenyl group, a phosphonophenyl group, a phosphonatophenyl group.

Examples of the alkenyl group are a vinyl group, a 1-propenyl group, a 1-butenyl group, a cinnamyl group, a 2-chloro-1-ethenyl group; and examples of the alkynyl group are an ethynyl group, a 1-propynyl group, a 1-butynyl group, a trimethylsilylethynyl group.

$R_{01}$ in the acyl group ($R_{01}CO-$) may be a hydrogen atom or the above-mentioned alkyl or aryl group. Of those

substituents, more preferred are a halogen atom (-F, -Br, -Cl, -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonoxy group, a phosphonatoxy group, an aryl group, and an alkenyl group. The heterocyclic group includes a pyridyl group and a piperidyl group. The silyl group includes a trimethylsilyl group, etc.

The alkylene group in the substituted alkyl group may be a divalent organic residue that is derived from the above-mentioned alkyl group having from 1 to 20 carbon atoms by removing any one hydrogen atom from it. Preferably, it includes a linear alkylene group having from 1 to 12 carbon atoms, a branched alkylene group having from 3 to 12 carbon atoms, and a cyclic alkylene group having from 5 to 10 carbon atoms. Combining any of the substituents as above with the alkylene group of the type gives the substituted alkyl group, and its preferred examples are a chloromethyl group, a bromomethyl group, a 2-chloroethyl group, a trifluoromethyl group, a methoxymethyl group, an isopropoxymethyl group, a butoxymethyl group, a s-butoxybutyl group, a methoxyethoxyethyl group, an allyloxymethyl group, a phenoxymethyl group, a methylthiomethyl group, a tolylthiomethyl group, a pyridylmethyl group, a tetramethylpiperidinylmethyl group, an N-acetyltetramethylpiperidinylmethyl group, a trimethylsilylmethyl group, a methoxyethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonoxypropyl group, a phosphonatoxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, 3-butynyl group. The aryl group for $R_1$ to $R_7$ includes a condensed ring of from 1 to 3 benzene rings, or a condensed ring of a benzene ring with a 5-membered unsaturated ring. Its specific examples are a phenyl group, a naphthyl group, an anthryl group, a phenanthryl group, an indenyl group, acenaphthenyl group, a fluorenyl group. Of those, more preferred are a phenyl group and a naphthyl group.

The substituted aryl group for $R_1$ to $R_7$ may be derived from the above-mentioned aryl group by substituting any one ring-forming carbon atom of the group with a monovalent non-metallic atomic group except hydrogen atom. Preferred substituents for it are the above-mentioned alkyl group and substituted alkyl group, and the substituents mentioned hereinabove for the substituted alkyl group. Preferred examples of the substituted aryl group are a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyoxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propylphenyl group, a 2-butynylphenyl group, a 3-butynylphenyl group.

For the alkenyl group, the substituted alkenyl group, the alkynyl group and the substituted alkynyl group ($-C(R_{02})=C(R_{03})(R_{04})$, and $-C\equiv C(R_{05})$), $R_{02}$, $R_{03}$, $R_{04}$ and $R_{05}$ each may be a monovalent non-metallic atomic group. Preferred examples of $R_{02}$, $R_{03}$, $R_{04}$ and $R_{05}$ are a hydrogen atom, a halogen atom, an alkyl group, a substituted alkyl group, an aryl group, and a substituted aryl group. For specific examples of these, referred to are those mentioned

hereinabove. More preferred examples of $R_{02}$, $R_{03}$, $R_{04}$ and $R_{05}$ are a hydrogen atom, a halogen atom, and a linear, branched or cyclic alkyl group having from 1 to 10 carbon atoms. Preferred examples of the alkenyl group, the substituted alkenyl group, the alkynyl group and the substituted alkynyl group for $R_1$ to $R_7$ are a vinyl group, a 1-propenyl group, a 1-butenyl group, a 1-pentenyl group, a 1-hexenyl group, a 1-octenyl group, a 1-methyl-1-propenyl group, a 2-methyl-1-propenyl group, a 2-methyl-1-butenyl group, a 2-phenyl-1-ethenyl group, a 2-chloro-1-ethenyl group, an ethynyl group, a 1-propynyl group, a 1-butynyl group, and a phenylethynyl group.

In the substituted oxy group ($R_{06}O$-) for $R_3$ to $R_7$, $R_{06}$ may be a monovalent non-metallic atomic group except hydrogen atom. Preferred examples of the substituted oxy group are an alkoxy group, an aryloxy group, an acyloxy group, a carbamoyloxy group, an N-alkylcarbamoyloxy group, an N-arylcarbamoyloxy group, an N,N-dialkylcarbamoyloxygroup, anN,N-diarylcarbamoyloxygroup, an N-alkyl-N-arylcarbamoyloxy group, an alkylsulfoxy group, an arylsulfoxy group, a phosphonoxy group, a phosphonatoxy group. For the alkyl group and the aryl group in these, referred to are those mentioned hereinabove for the above alkyl group, substituted alkyl group, aryl group and substituted aryl group. For $R_{07}$ in the acyl group ($R_{07}CO$-) in the acyloxy group, referred to are those mentioned hereinabove for the alkyl group, the substituted alkyl group, the aryl group or the substituted aryl group for $R_1$ to $R_7$. Of those substituents, more preferred are an alkoxy group, an aryloxy group, an acyloxy group, and an arylsulfoxy group.

Concretely, preferred examples of the substituted oxy group are a methoxy group, an ethoxy group, a propyloxy group, an isopropyloxy group, a butyloxy group, a pentyloxy group, a hexyloxy group, a dodecyloxy group, a benzyloxy group, an allyloxy group, a phenethyloxy group, a carboxyethyloxy group, a methoxycarbonylethyloxy group, an ethoxycarbonylethyloxy group, a methoxyethoxy group, a phenoxyethoxy group, a ethoxyethoxyethoxy group, an ethoxyethoxyethoxy group, a morpholinoethoxy group, a morpholinopropyloxy group, an allyloxyethoxyethoxy group, a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, an acetyloxy group, a benzoyloxy group, a naphthyloxy group, a phenylsulfonyloxy group, a phosphonoxy group, a phosphonatoxy group.

In the substituted amino group ($R_{08}NH$-, ($R_{09}$) ($R_{010}$)N-) that may optionally contain an amido group for $R_3$ to $R_7$, $R_{08}$, $R_{09}$ and $R_{010}$ may be a monovalent non-metallic atomic group except hydrogen atom. $R_{09}$ and $R_{010}$ may bond to each other to form a ring. Preferred examples of the substituted amino group are an N-alkylamino group, an N,N-dialkylamino group, an N-arylamino group, an N,N-diarylamino group, an N-alkyl-N-arylamino group, an acylamino group, an N-alkylacylamino group, an N-arylacylamino group, an ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N'-alkyl-N'-arylureido group, an N',N'-dialkyl-N-alkylureido group, an N',N'-dialkyl-N'-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group. For the alkyl group and the aryl group in these, referred to are those mentioned hereinabove for the above alkyl, substituted alkyl, aryl and substituted aryl groups. $R_{07}$ in the acyl group ($R_{07}CO$-) in the acylamino group, the N-alkylacylamino group and the N-arylacylamino group may have the same meaning as above. Of those, more preferred are an N-alkylamino group, an N,N-dialkylamino group, an N-arylamino group, an acylamino group. Preferred examples of the substituted amino group are a methylamino group, an ethylamino group, a diethylamino group, a morpholino group, a piperidino group, a pyrrolidino group, a phenylamino group, a benzoylamino group, an acetylamino group.

$R_{011}$ in the substituted sulfonyl group ($R_{011}$-$SO_2$-) for $R_1$ to $R_7$ may be a monovalent non-metallic atomic group. More preferred examples of the group are an alkylsulfonyl group and an arylsulfonyl group. For the alkyl group and the aryl group in these, referred to are those mentioned hereinabove for the above alkyl, substituted alkyl, aryl and substituted aryl groups. Specific examples of the substituted sulfonyl group are a butylsulfonyl group, a phenylsulfonyl group, a chlorophenylsulfonyl group. For the heterocyclic group for $R_1$ and $R_2$, referred to are those mentioned hereinabove for the substituents for the substituted alkyl group, for example, a pyridyl group.

The sulfonato group ($-SO_3^-$) for $R_3$ to $R_7$ means a conjugate base anion of a sulfo group ($-SO_3H$), as so mentioned hereinabove. In general, it is preferably combined with a pair cation. The pair cation may be any known one, including, for example, various oniums (e.g., ammoniums, sulfoniums, phosphoniums, iodoniums, aziniums), and metal ions (e.g., $Na^+$, $K^+$, $Ca^{2+}$, $Zn^{2+}$).

The ring to be formed by $R_1$ and $R_2$ bonding to each other in formula (M1) includes, for example, morpholine, piperazine, pyrrolidine, pyrrole, indole. These may be substituted with any of the above-mentioned substituents. More preferably, the ring to be formed by them is an alicyclic ring.

In formula (M1), $R_1$ and $R_2$ each are preferably an alkyl group, an alkenyl group, an aryl group, or a substituted sulfonyl group. Also preferably, $R_1$ and $R_2$ may form an alicyclic ring.

In formula (M2), $R_3$ to $R_7$ are preferably hydrogen atoms, and $Z_1$ is preferably an oxygen atom.

More preferred examples of i) are the following compounds, which, however, are not limitative.

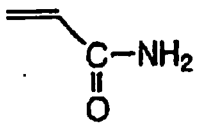
(M-1)

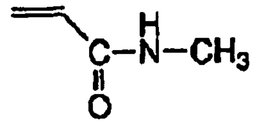
(M-2)

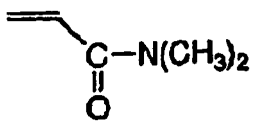
(M-3)

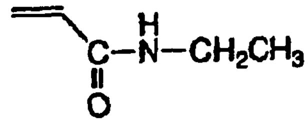
(M-4)

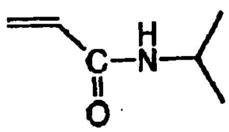
(M-5)

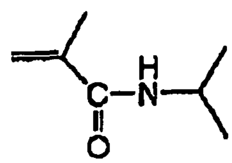
(M-6)

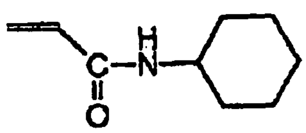
(M-7)

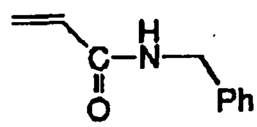
(M-8)

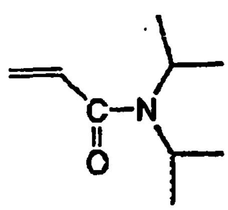
(M-9)

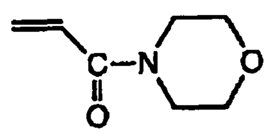
(M-10)

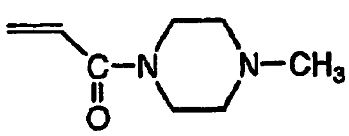
(M-11)

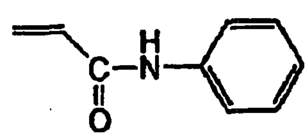
(M-12)

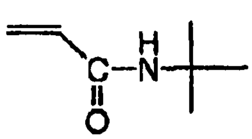
(M-13)

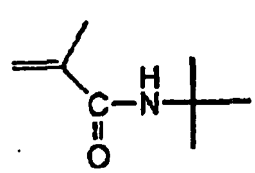
(M-14)

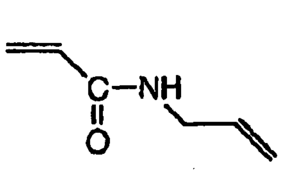
(M-15)

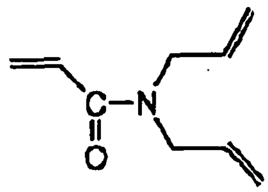
(M-16)

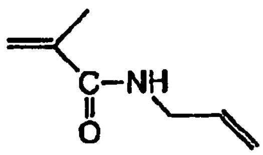
(M-17)

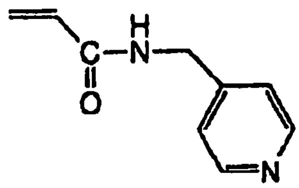
(M-18)

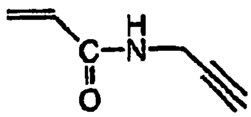
(M-19)

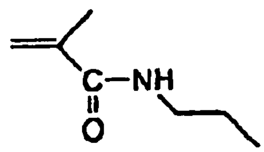
(M20)

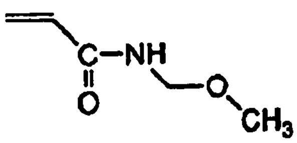
(M-21)

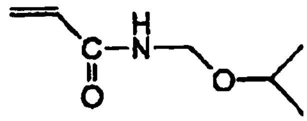
(M-22)

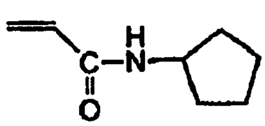
(M-23)

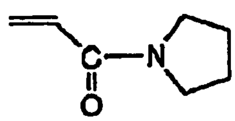
(M-24)

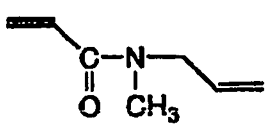
(M-25)

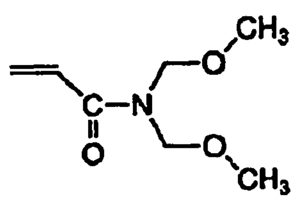
(M-26)

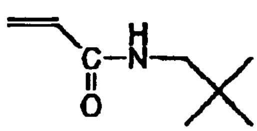
(M-27)

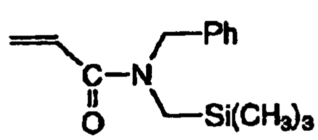
(M-28)

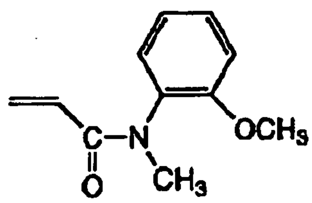 (M-29)

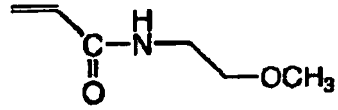 (M-30)

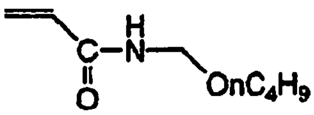 (M-31)

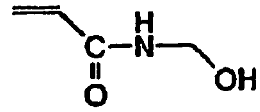 (M-32)

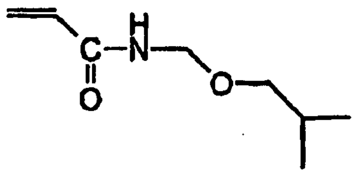 (M-33)

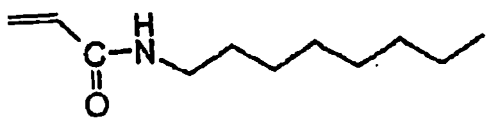 (M-34)

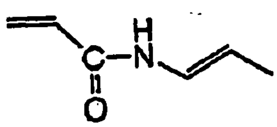 (M-35)

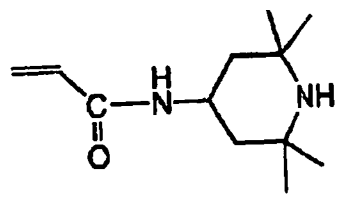 (M-36)

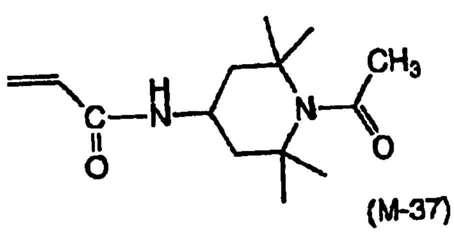 (M-37)

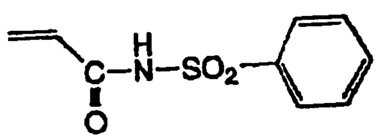 (M-38)

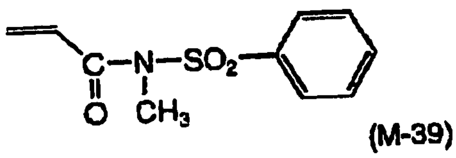 (M-39)

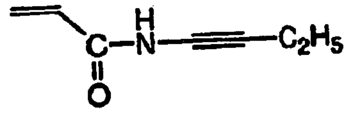 (M-40)

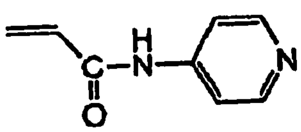

(M-41)

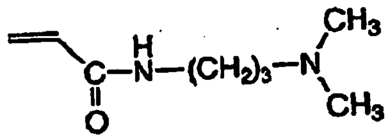

(M-42)

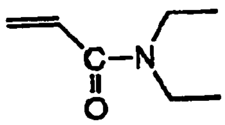

(M-43)

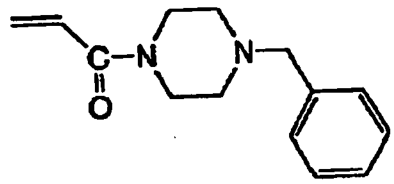

(M-44)

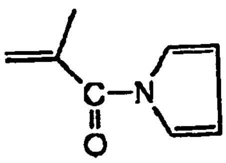

(M-45)

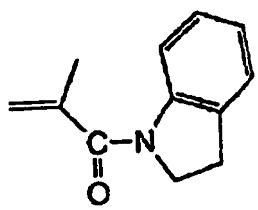

(M-46)

More preferred examples of ii) are allyl acrylate and allyl methacrylate. More preferred examples of iii) are acrylic acid and methacrylic acid.

Specific examples of the copolymer are shown in the following Production Examples.

The amount of the amido group-having polymer binder to be in the photopolymerization layer may be generally from 10 to 90 % by weight, preferably from 20 to 80 % by weight, more preferably from 30 to 70 % by weight of all the components of the layer.

The amido group-having polymer binder may be combined with any other polymer binder for use herein. The content of the other polymer binder may be generally at most 100 % by weight, but preferably at most 50 % by weight of the amido group-having polymer binder.

For ensuring good developability of the photosensitive layer, it is desirable that the amido group-having polymer binder has a suitable molecular weight and a suitable acid value. Concretely, it is effective that the weight-average molecular weight of the polymer binder is from 5000 to 300,000 and the acid value thereof is from 0.1 to 5.0 meq/g. Any desired amount of the amido group-having polymer binder may be mixed in the composition for the photosensitive layer.

The ratio by weight of the photopolymerizable ethylenic unsaturated bond-having compound to the overall polymer binder preferably falls between 1/9 and 9/1, more preferably between 2/8 and 8/2, even more preferably between 3/7 and 7/3.

<b. Polyurethane Resin>

Next described is the polyurethane resin for use herein.

The polyurethane resin that serves as the polymer binder is a polyurethane resin binder that is produced from at least the following compounds (i), (ii), (iii) and (iv). The polyurethane resin binder of the type has a polyurethane structure that comprises at least the following compounds (i), (ii), (iii) and (iv).

(i) At least one diisocyanate compound,
(ii) at least one diol compound having at least one carboxyl group,
(iii) at least one diol having a value log P of smaller than 0, and
(iv) at least one diol compound having a value log P of larger than 0,

provided that the compounds (iii) and (iv) are except carboxyl group-having diol compounds.

Containing the polyurethane resin binder, the advantage of the photopolymerization layer is that, even though the acid value of the layer is low, the development damage in the exposed area of the layer may be retarded, not detracting from the developability of the non-exposed area thereof, and therefore the printing plate produced may have good staining resistance and good printing durability.

(i) Diisocyanate Compound:

The diisocyanate compound is, for example, one represented by the following formula (1):

OCN-L-NCO (1)

wherein L represents an optionally-substituted, divalent aliphatic or aromatic hydrocarbon group, and, if desired, L may have any other functional group not reacting with an isocyanate group, for example, a carbonyl, ester, urethane, amido or ureido group.

More concretely, L represents a single bond, or a divalent aliphatic or aromatic hydrocarbon group that may be optionally substituted (for example, preferably with any of an alkyl group, an aralkyl group, an aryl group, an alkoxy group or a halogeno group). Preferably, it is an alkylene group having from 1 to 20 carbon atoms, or an arylene group having from 6 to 15 carbon atoms, even more preferably an alkylene group having from 1 to 8 carbon atoms. If desired, L may have a functional group not reacting with an isocyanate group, for example, a carbonyl, ester, urethane, amido, ureido or ether group.

Concretely, the following compounds are usable herein.

They are aromatic diisocyanate compounds such as 2, 4-tolylene diisocyanate, dimer of 2, 4-tolylene diisocyanate, 2,6-tolylenediisocyanate,p-xylylenediisocyanate,m-xylylene diisocyanate, 4,4'-diphenylmethane diisocyanate, 1,5-naphthylene diisocyanate, 3,3'-dimethylbiphenyl 4,4'-diisocyanate; aliphatic diisocyanate compounds such as hexamethylene diisocyanate, trimethylhexamethylene diisocyanate, lysine diisocyanate, dimer acid diisocyanate; alicyclic diisocyanate compounds such as isophorone diisocyanate, 4,4'-methylenebis(cyclohexyl isocyanate), methylcyclohexane 2,4 (or 2,6)-diisocyanate, 1,3-(isocyanatomethyl)cyclohexane; and other diisocyanate compounds of reaction products of diols and diisocyanates, such as adduct of 1 mol of 1, 3-butylene glycol and 2 mols of tolylene diisocyanate.

One or more of diisocyanate compounds may be used herein either singly or as combined. In view of good balance of printing durability and staining resistance of the printing plate, it is desirable that two or more diisocyanate compounds are combined for use herein. Especially preferably, at least one of aromatic diisocyanate compound (where L is an aromatic group) and at least one aliphatic diisocyanate compound (where L is an aliphatic group) are combined.

The amount of the diisocyanate compound to be used in producing the resin is preferably from 0.8 to 1.2, more preferably from 0. 9 to 1.1 in terms of the ratio thereof by mol to the diol compound. When an excess diisocyanate compound is used relative to the diol compound and when an isocyanate group remains in the polymer terminal, then it is desirable that the polymer is processed with any of alcohols or amines after the urethanation reaction in order that no isocyanate group remains in the final polymer.

(ii) At least one diol compound having at least one carboxyl group:

At least one diol compound having at least one carboxyl group is diol compounds of the following formulae (2), (3) and (4) and/or compounds prepared through ring-cleaving reaction of a tetracarboxylic acid dianhydride with a diol compound. The diol compound that is used for the ring-cleaving reaction of tetracarboxylic acid dianhydride may be the diol compound of formula (iii) or (iv) to be mentioned hereinunder.

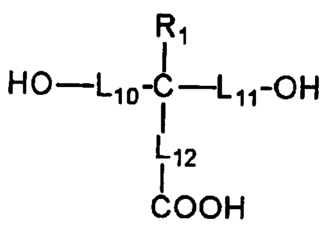

(2)

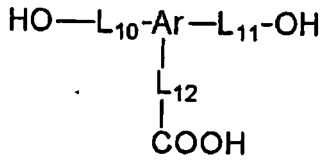

(3)

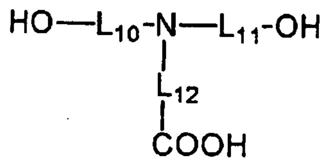

(4)

$R_1$ represents a hydrogen atom, or an alkyl, aralkyl, aryl, alkoxy or aryloxy group that may be optionally substituted (for example, with any of a cyano group, a nitro group, a halogen atom (-F, -Cl, -Br, -I), $-CONH_2$, $-COOR_{113}$, $-OR_{113}$, $-NHCONHR_{113}$, $-NHCOOR_{113}$, $-NHCOR_{113}$, $-OCONHR_{113}$ (where $R_{113}$ represents an alkyl group having from 1 to 10 carbon atoms, or an aralkyl group having from 7 to 15 carbon atoms)), and is preferably a hydrogen atom, an alkyl group having from 1 to 8 carbon atoms, or an aryl group having from 6 to 15 carbon atoms.

$L_{10}$, $L_{11}$ and $L_{12}$ may be the same or different, and each represents a single bond, or a divalent aliphatic or aromatic hydrocarbon group that maybe optionally substituted (for example, preferably with any of an alkyl group, an aralkyl group, an aryl group, an alkoxy group or a halogeno group). Preferably, they are any of an alkylene group having from 1 to 20 carbon atoms, or an arylene group having from 6 to 15 carbon atoms, more preferably an alkylene group having from 1 to 8 carbon atoms. If desired, $L_{10}$, $L_{11}$ and $L_{12}$ may have any other functional group not reacting with an isocyanate group, for example, a carbonyl, ester, urethane, amido, ureido or ether group. Two or three of $R_1$, $L_{10}$, $L_{11}$ and $L_{12}$ may form a ring.

Ar represents an optionally-substituted, trivalent aromatic hydrocarbon group, preferably an aromatic group having from 6 to 15 carbon atoms.

Specific examples of the carboxyl group-having diol compounds of formula (2), (3) or (4) are mentioned below.

They are 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis (hydroxymethyl)butyric acid, 4,4-bis(4-hydroxyphenyl)pentanoic acid, tartaric acid, N,N-dihydroxyethylglycine, N,N-bis (2-hydroxyethyl)-3-carboxypropionamide.

Preferred examples of the tetracarboxylic acid dianhydride that is used in producing at least one diol compound having at least one carboxyl group are those of the following formulae (5), (6) and (7):

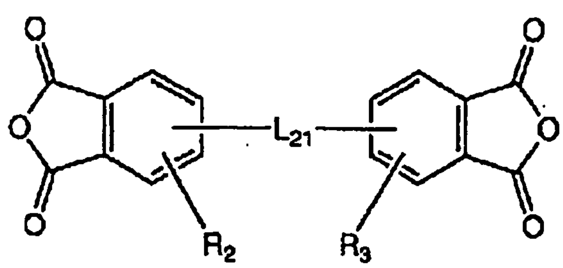

(5)

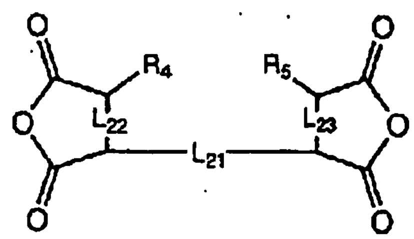

(6)

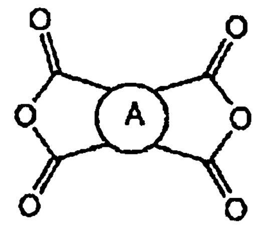

(7)

In these formulae, $L_{21}$ represents a single bond, or a divalent aliphatic or aromatic hydrocarbon group that is optionally substituted (for example, optionally with any of an alkyl group, an aralkyl group, an aryl group, an alkoxy group, a halogeno group, an ester group or an amido group), or -CO-, -SO-, $-SO_2-$, -O- or -S-, preferably a single bond, or a divalent aliphatic hydrocarbon group having from 1 to 15 carbon atoms, or -CO-, $-SO_2-$, -O- or -S-. $R_2$ and $R_3$ may be the same or different, and each represents a hydrogen atom, an alkyl group, an aralkyl group, an aryl group, an alkoxy group, or a halogeno group. Preferably, they are a hydrogen atom, an alkyl group having from 1 to 8 carbon atoms, an aryl group having from 6 to 15 carbon atoms, an alkoxy group having from 1 to 8 carbon atoms, or a halogeno group. Two of $L_{21}$, $R_2$ and $R_3$ may bond to each other to form a ring. $R_4$ and $R_5$ may be the same or different, and each represents a hydrogen atom, an alkyl group, an aralkyl group, an aryl group, or a halogeno group. Preferably, they are a hydrogen atom, an alkyl group having from 1 to 8 carbon atoms, or an aryl group having from 6 to 15 carbon atoms. Two of $L_{21}$, $R_4$ and $R_5$ may bond to each other to form a ring. $L_{22}$ and $L_{23}$ may be the same or different, and each represents a single bond, a double bond, or a divalent aliphatic hydrocarbon group. Preferably, they are a single bond, a double bond, or a methylene group. A represents a monocyclic or polycyclic aromatic ring. Preferably, it is an aromatic ring having from 6 to 18 carbon atoms.

Concrete examples of the compounds of formula (5), (6) or (7) are mentioned below.

They are aromatic tetracarboxylic acid dianhydrides such as pyromellitic dianhydride, 3,3',4,4'-benzophenonetetracarboxylic acid dianhydride, 3,3',4,4'-diphenyltetracarboxylic acid dianhydride, 2,3,6,7-naphthalenetetracarboxylic acid dianhydride, 1,4,5,8-naphthalenetetracarboxylic acid dianhydride, 4,4'-sulfonyldiphthalic dianhydride, 2,2-bis(3,4-dicarboxyphenyl)propane dianhydride, bis(3,4-dicarboxyphenyl) ether dianhydride, 4,4'-[3,3'-(alkylphosphoryldiphenylene)-bis(iminocarbonyl)]diphthalic anhydride, adduct of hydroquinone diacetate and trimellitic anhydride, and adduct of diacetyldiamine and trimellitic anhydride; alicyclic tetracarboxylic acid dianhydrides such as 5-(2,5-dioxotetrahydrofuryl)-3-methyl-3-cyclohexene-1,2-dic arboxylic acid anhydride (Epiclon B-4400 by Dai-Nippon Ink & Chemicals), 1,2,3,4-cyclopentanetetracarboxylic acid dianhydride, 1,2,4,5-cyclohexanetetracarboxylic acid dianhydride, tetrahydrofurantetracarboxylic acid dianhydride; aliphatic tetracarboxylic acid dianhydrides such as 1,2,3,4-butanetetracarboxylic acid dianhydride, 1,2,4,5-pentanetetracarboxylic acid dianhydride.

These tetracarboxylic acid dianhydrides are ring-cleaved with diol compounds to give (ii) at least one diol compound having at least one carboxyl group. However, when a diol compound is first reacted with a diisocyanate compound (i) and the reaction product is reacted with the above-mentioned tetracarboxylic acid dianhydride, then it may also give the polyurethane resin for use in the invention. This method is within the scope of the invention. Specifically, the following methods may be employed for introducing the structural unit derived from a tetracarboxylic acid dianhydride and a diol compound into a polyurethane resin.

a) A tetracarboxylic acid dianhydride is ring-cleaved with a diol compound, and the resulting alcohol-terminated compound is then reacted with a diisocyanate compound.

b) A diisocyanate compound is reacted with an excess diol compound, the resulting alcohol-terminated urethane compound is then reacted with a tetracarboxylic acid dianhydride.

For at least one diol compound having at least one carboxyl group, more preferred is the compound of formula

(2) since its solubility in solvent is high and since its production is easy. At least one diol compound having at least one carboxyl group is introduced into the polyurethane resin binder for use herein in such a controlled manner that the resulting polyurethane resin binder may have a carboxyl group within a range of from 0.2 to 4.0 meq/g, preferably from 0.3 to 3.0 meq/g, more preferably from 0.4 to 2. 0 meq/g, even more preferably from 0. 5 to 1. 5 meq/g, most preferably from 0. 6 to 1.2 meq/g. Accordingly, the content of the structure derived from (ii) at least one diol compound having at least one carboxyl group, in the polyurethane resin binder may be suitably determined depending on the number of the carboxyl group in the compound, the type of the other diol component to be used, the acid value and the molecular weight of the polyurethane resin binder to be obtained, and the composition and the pH of the developer to be used, and for example, it may be from 5 to 45 mol%, preferably from 10 to 40 mol%, more preferably from 15 to 35 mol%.

(iii) At least one diol compound having a value log P of smaller than 0:

The value log P as referred to for the diol compounds of (iii) and (iv) has the same meaning as that defined for the nonionic surfactant in a developer that will be mentioned hereinunder, and it may be computed from known data like that of the surfactant.

The diol compound having a value log P of smaller than 0 is not specifically defined for use herein. However, it does not include carboxyl group-having diol compounds having a value log P of smaller than 0. The diol compound having a value log P of smaller than 0 includes, for example, ethylene glycol compounds of a formula (A'):

$$HO\text{-}(CH_2CH_2O)_n\text{-}H \qquad (A')$$

where n indicates an integer of 1 or more.

Further mentioned for the diol compound of the type are OH-terminated ethylene oxide/propylene oxide random copolymers and block copolymers having a value log P of smaller than 0.

Also usable for the compound are bisphenol A/(27-100) ethylene oxide adducts, bisphenol F/(22-100) ethylene oxide adducts, hydrogenated bisphenol A/(23-100) ethylene oxide adducts, and hydrogenated bisphenol F/(18-100) ethylene oxide adducts. One or more of diol compounds having a value log P of smaller than 0 may be used herein either singly or as combined. In view of the stability (sensitivity, printing durability) of the printing plate, single use of one compound of the type is preferred.

It is desirable that the diol compound having a value log P of smaller than 0 has a log P of from -10 to -0.5, more preferably from -8 to -1, even more preferably from -5 to -1.2 in view of the staining resistance of the printing plate. More concretely, the ethylene glycol compounds of formula (A') are preferred in view of the staining resistance of the printing plate. More preferred are those with n of from 2 to 50; even more preferred are those with n of from 3 to 30; still more preferred are those with n of from 4 to 10. The content of at least one diol compound having a value log P of smaller than 0, in the polyurethane resin binder for use herein may be suitably determined, depending on the value log P of the diol compound, the type of the other diol component to be used, the acid value and the molecular weight of the polyurethane resin binder to be obtained, and the composition and the pH of the developer to be used, and preferably it is from 1 to 45 ml%, more preferably from 5 to 40 mol%, even more preferably from 10 to 35 mol%, still more preferably from 15 to 30 mol%.

(iv) At least one diol compound having a value log P of larger than 0:

Any one having a value log P of larger than 0 may be used for at least one diol compound having a value log P of larger than 0. However, at least one diol compound having a value log P of larger than 0 does not include diol compounds having a carboxyl group.

Concretely, it includes, for example, 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having a mean molecular weight of 400, polypropylene glycol having a mean molecular weight of 700, polypropylene glycol having a mean molecular weight of 1000, polypropylene glycol having a mean molecular weight of 2000, polypropylene glycol having a mean molecular weight of 3000, polypropylene glycol having a mean molecular weight of 4000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, bisphenol A/ethylene oxide adducts with at most 26 ethylene oxides, bisphenol F/ethylene oxide adducts with at most 21 ethylene oxides, hydrogenated bisphenol A/ethylene oxide adducts with at most 22 ethylene oxides, hydrogenated bisphenol F/ethylene oxide adducts with at most 17 ethylene oxides, bisphenol A/propylene oxide adducts, bisphenol F/propylene oxide adducts, hydrogenated bisphenol A/propylene oxide adducts, hydrogenated bisphenol F/propylene oxide adducts, hydroquinone

dihydroxyethyl ether, p-xylylene glycol, dihydroxyethyl sulfone, bis(2-hydroxyethyl)-2,4-tolylene dicarbamate, 2,4-tolylene-bis(2-hydroxyethylcarbamide), bis(2-hydroxyethyl)-m-xylylene dicarbamate, bis(2-hydroxyethyl) isophthalate.

Also preferred for use herein are polyether diol compounds of formulae (A), (B), (C), (D) and (E) having a value log P of larger than 0.

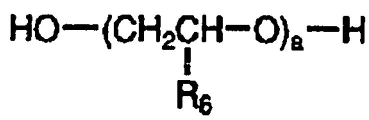

(A)

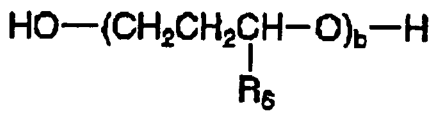

(B)

$HO-(CH_2CH_2CH_2CH_2-O)_c-H$ (C)

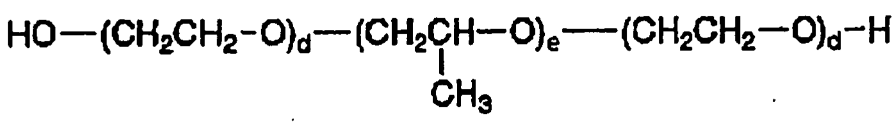

(D)

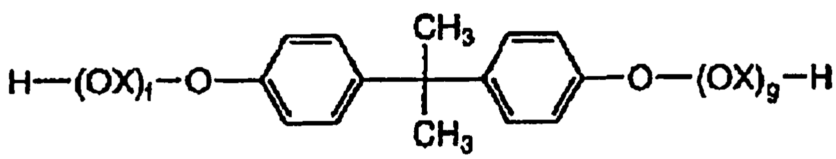

(E)

In these formulae, $R_6$ represents a hydrogen atom or a methyl group. In formula (A), however, $R_6$ is a methyl group. X represents the following group:

$-CH_2CH_2-$

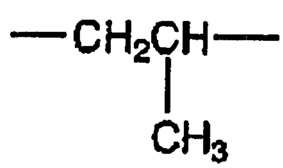

a, b, c, d, e, f and g each indicate an integer of 2 or more, preferably an integer of from 2 to 100.

Polyester diol compounds of formulae (8) and (9) having a value log P of larger 0 are also examples of the diol compound (iv).

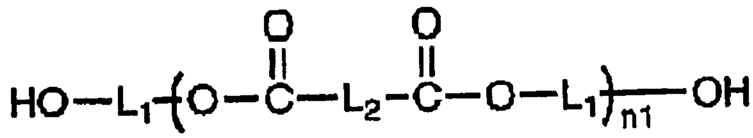 (8)

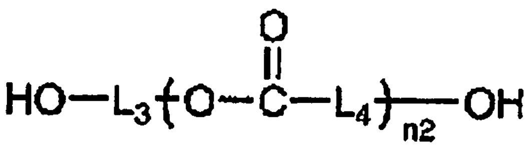 (9)

In these formulae, $L_1$, $L_2$ and $L_3$ may be the same or different, and each represents divalent aliphatic or aromatic hydrocarbon group; $L_4$ represents a divalent aliphatic hydrocarbon group. Preferably, $L_1$, $L_2$ and $L_3$ each are an alkylene group, an alkenylene group, an alkynylene group, or an arylene group; and $L_4$ is an alkylene group. $L_1$, $L_2$, $L_3$ and $L_4$ may contain any other functional group not reacting with an isocyanate group, for example, an ether, carbonyl, ester, cyano, olefin, urethane, amido or ureido group, or a halogen atom. n1 and n2 each are an integer of 2 or more, preferably an integer of from 2 to 100.

Polycarbonate diol compounds of formula (10) having a value log P of larger than 0 are also examples of the diol compound (iv).

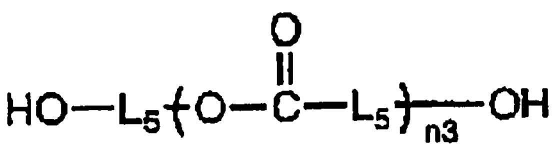 (10)

wherein $L_5$'s may be the same or different, and each represents a divalent aliphatic or aromatic hydrocarbon group. Preferably, $L_5$ is an alkylene group, an alkenylene group, an alkynylene group, or an arylene group. $L_5$ may contain any other functional group not reacting with an isocyanate group, for example, an ether, carbonyl, ester, cyano, olefin, urethane, amido or ureido group, or a halogen atom. n3 is an integer of 2 or more, preferably an integer of from 2 to 100.

Examples of the diol compounds of formulae (8), (9) and (10) are mentioned below, in which n is an integer of 2 or more.

(No.1)

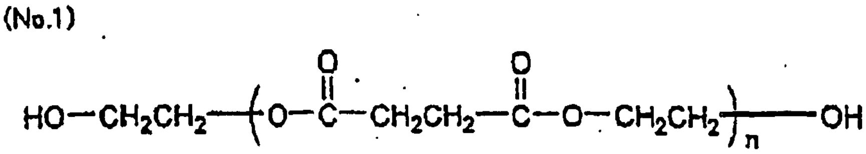

(No.2)

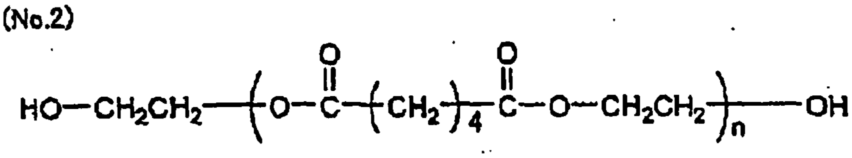

(No.3)

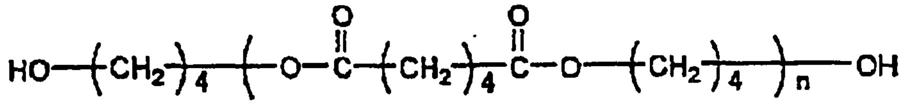

(No.4)

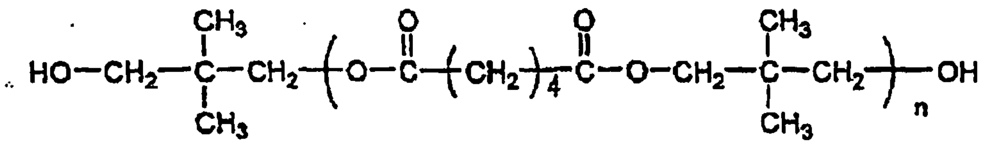

(No.5)

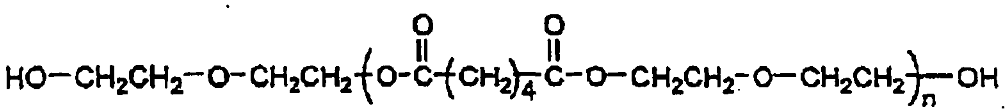

(No.6)

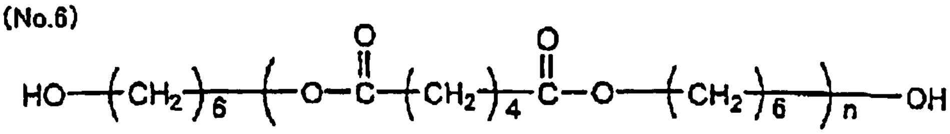

(No.7)

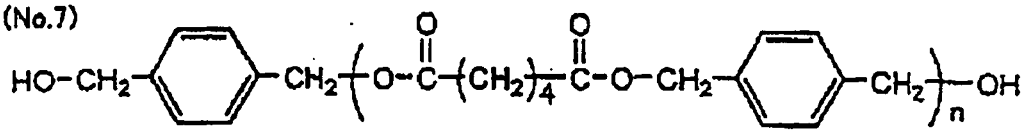

(No.8)

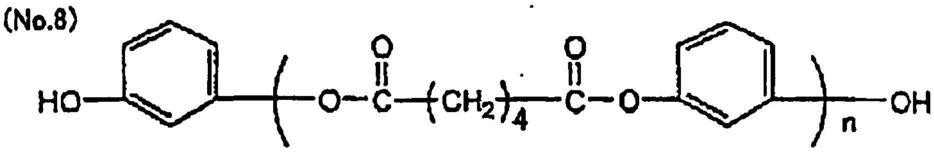

(No.9)

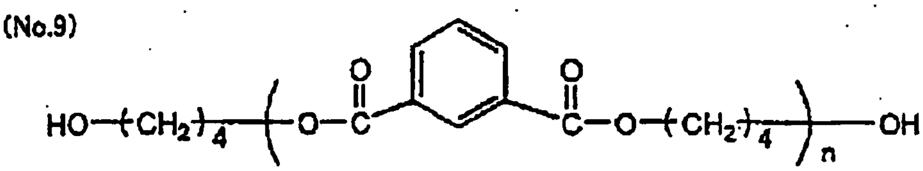

(No.10)

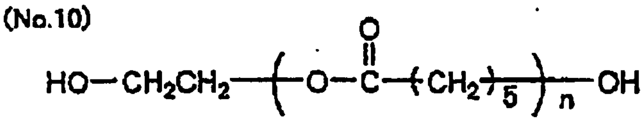

(No.11)

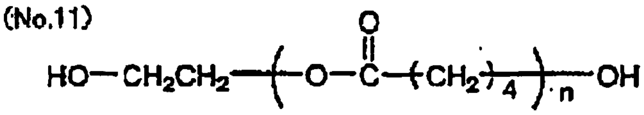

(No.12)

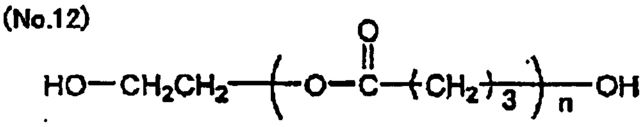

(No.13)

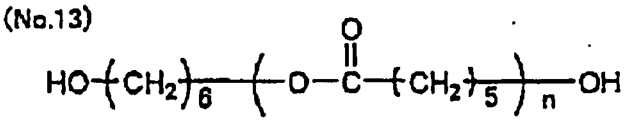

(No.14)

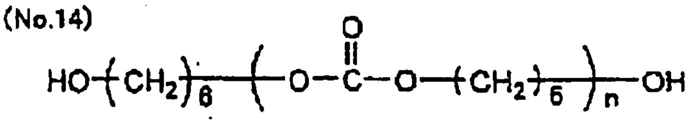

(No.15)

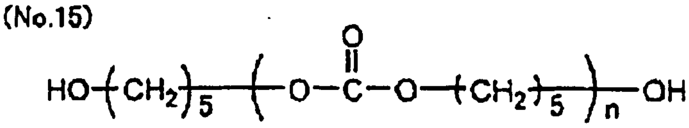

(No.16)

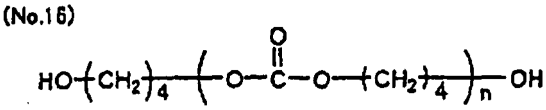

(No.17)

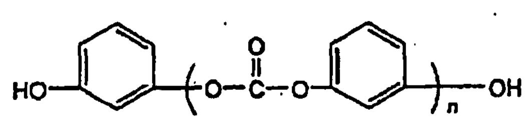

(No.18)

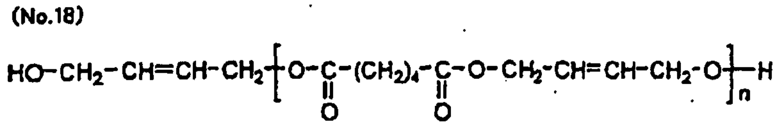

(No.19)

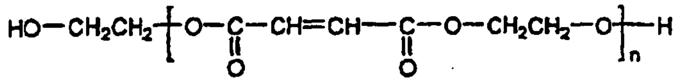

(No.20)

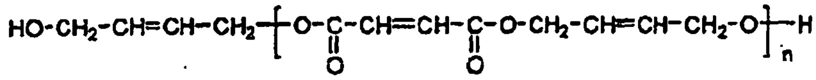

(No.21)

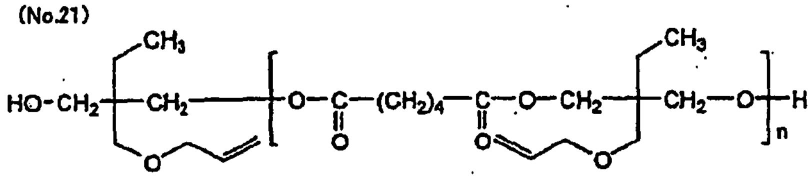

(No.22)

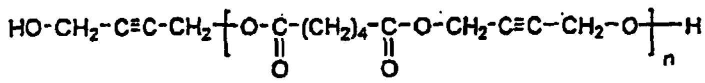

(No.23)

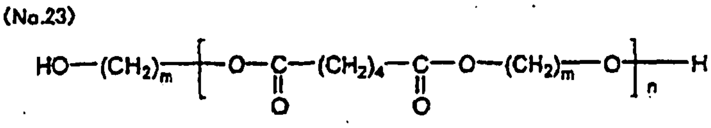

m=2,4

Any other diol compounds having a value log P of larger than 0 and optionally having any other substituent that does not have a carboxyl group and does not react with isocyanate are also usable herein.

The diol compounds of the type include, for example, the following:

$$HO\text{-}L_6\text{-}O\text{-}CO\text{-}L_7\text{-}CO\text{-}O\text{-}L_6\text{-}OH \qquad (11)$$

$$HO\text{-}L_7\text{-}CO\text{-}O\text{-}L_6\text{-}OH \qquad (12)$$

In these formulae, $L_6$ and $L_7$ may be the same or different, and each represents a divalent aliphatic hydrocarbon, aromatic hydrocarbon or heterocyclic group that may be optionally substituted (for example, with any of an alkyl group, an aralkyl group, an aryl group, an alkoxy group, an aryloxy group, or a halogen atom (-F, -Cl, -Br, -I)). If desired, $L_6$ and $L_7$ may have any other functional group not reacting with an isocyanate group, for example, a carbonyl, ester, urethane, amido or ureido group. $L_6$ and $L_7$ may form a ring.

Specific examples of the compounds of formulae (11) and (12) are mentioned below.

(No.101)

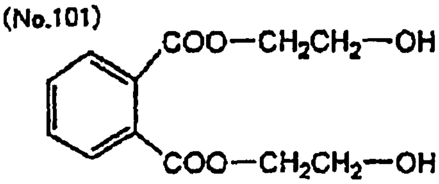

(No.102)

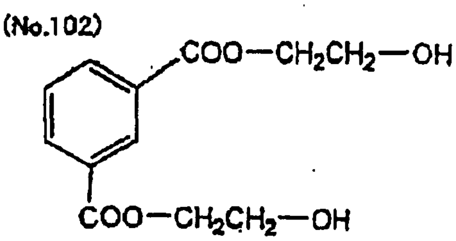

(No.103)

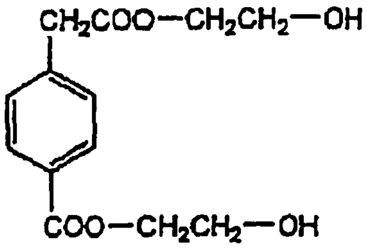

(No.104)

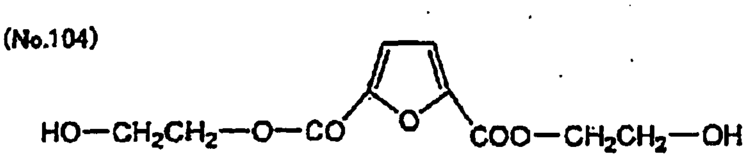

(No.105) $HO-CH_2CH_2-O-CO-CH=CH-COO-CH_2CH_2-OH$

(No.106) $HO-CH_2CH_2-O-COC_{11}H_{22}COO-CH_2CH_2-OH$

(No.107) $HO-CH_2CH_2-O-COC_{12}H_{24}COO-CH_2CH_2-OH$

(No.108) $HO-CH_2CH_2-O-COC_{14}H_{28}COO-CH_2CH_2-OH$

(No.109)

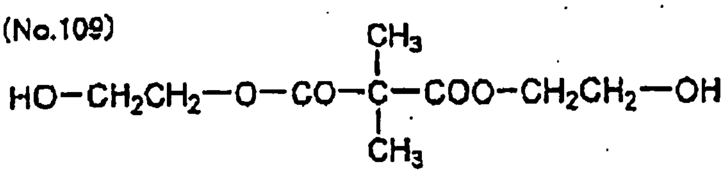

(No.110) $HO-CH_2CH_2-O-CO-C\equiv C-COO-CH_2CH_2-OH$

(No.111)

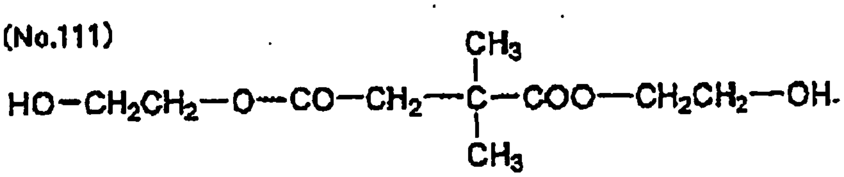

(No.112)

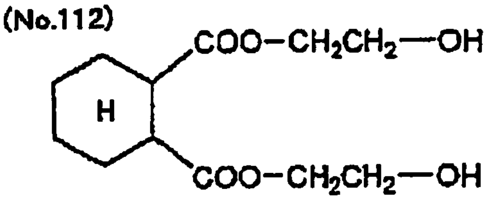

(No.113) HO-$CH_2CH_2$-O-CO-$CH_2$-O-$CH_2$-COO-$CH_2CH_2$-OH

(No.114)

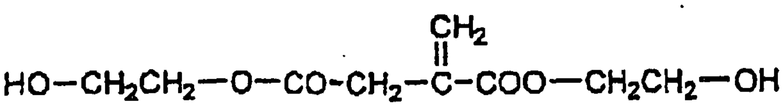

(No.115)

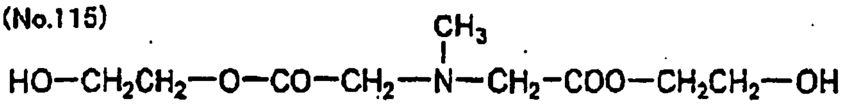

(No.116)

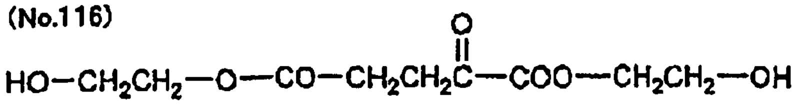

(No.117)

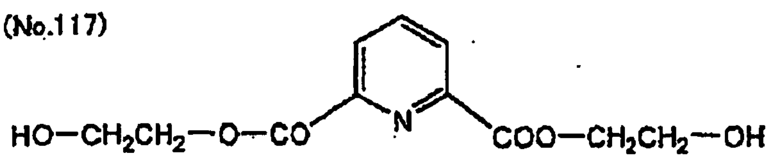

(No.118)

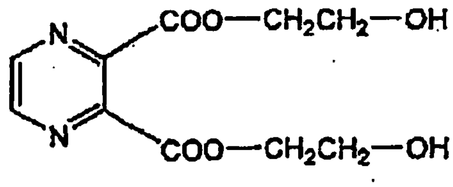

(No.119)

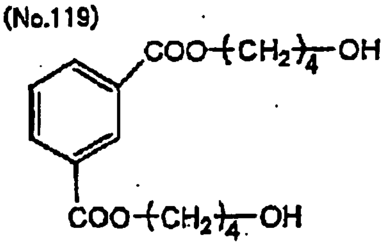

(No.120)

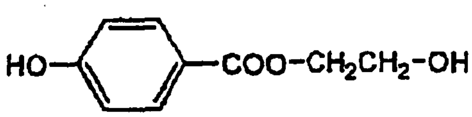

(No.121)

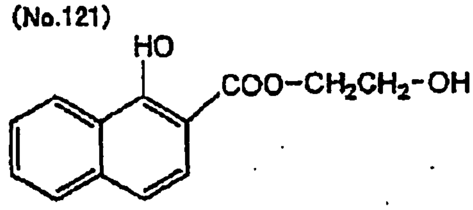

(No.122)

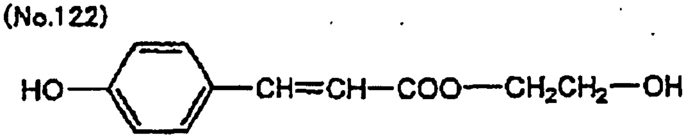

(No.123) $HO-CH_2CH_2-COO-CH_2CH_2-OH$

(No.124)

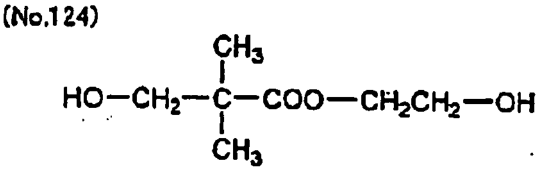

(No.125)

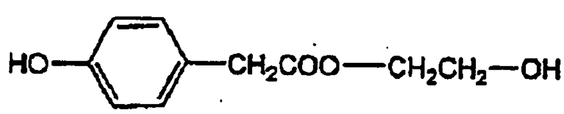

(No.126)

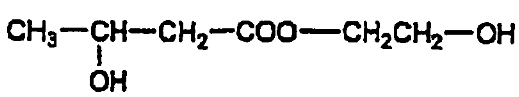

(No.127)

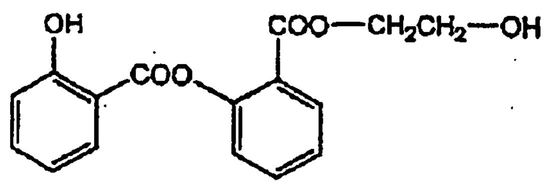

(No.128)

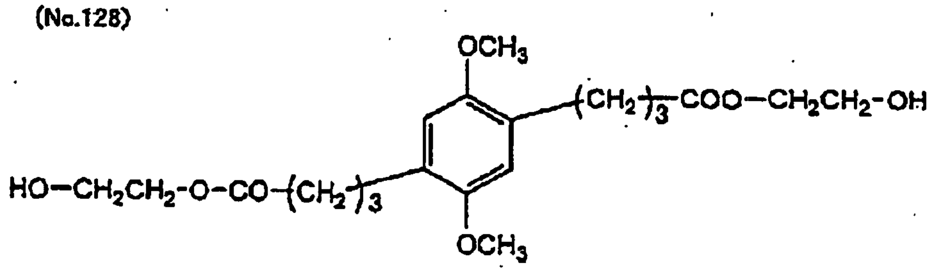

The following diol compounds are also favorably used herein.

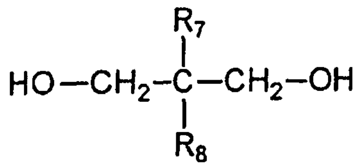

(16)

$HO-CH_2-C\equiv C-CH_2-O_H$ (17)

$HO-CH_2-CH=CH-CH_2-OH$ (18)

In these formulae, $R_7$ and $R_8$ may be the same or different, and each represents an optionally-substituted alkyl group, preferably an alkyl group having from 1 to 10 carbon atoms and optionally substituted with any of a cyano group, a nitro group, a halogen atom (-F, -Cl, -Br, -I), $-CONH_2$, -COOR, or -OR (where R may be the same or different, representing an alkyl group having from 1 to 10 carbon atoms, or an aryl or aralkyl group having from 7 to 15 carbon atoms).

Specific examples of the diol compounds of formula (16) are mentioned below.

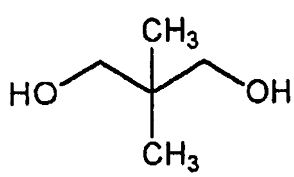

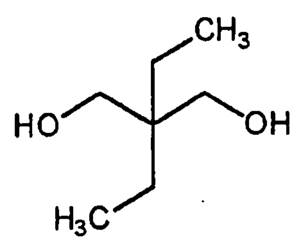

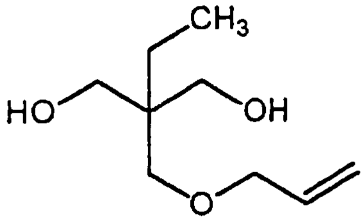

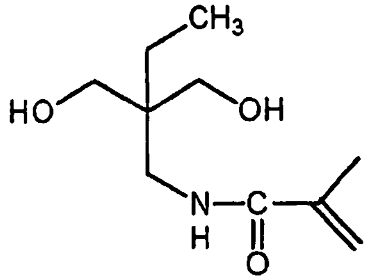

Compounds of formula (17) include, for example, 2-butene-1,4-diol; and compounds of formula (18) include, for example, cis-2-butene-1,4-diol, trans-2-butene-1,4-diol.

The following diol compounds are also favorable to the invention.

$$HO\text{-}L_8\text{-}NH\text{-}CO\text{-}L_9\text{-}CO\text{-}NH\text{-}L_8\text{-}OH \qquad (19)$$

$$HO\text{-}L_9\text{-}CO\text{-}NH\text{-}L_8\text{-}OH \qquad (20)$$

In these formulae, $L_8$ and $L_9$ may be the same or different, and each represents a divalent aliphatic hydrocarbon, aromatic hydrocarbon or heterocyclic group that may be optionally substituted (for example, with any of an alkyl group, an aralkyl group, an aryl group, an alkoxy group, an aryloxy group, or a halogen atom (-F, -Cl, -Br, -I)). If desired, $L_8$ and $L_9$ may contain any other functional group not reacting with an isocyanate group, for example, a carbonyl, ester, urethane, amido or ureido group. $L_8$ and $L_9$ may form a ring.

Examples of the compounds of formulae (19) and (20) are mentioned below.

(No.201)

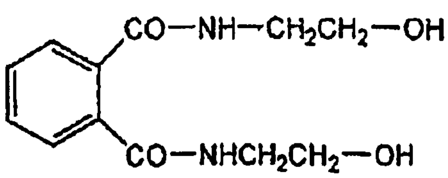

(No.202)

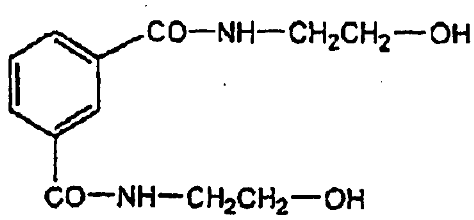

(No.203) $HO\text{-}CH_2CH_2\text{-}NH\text{-}CO\text{-}CH{=}CH\text{-}CO\text{-}NH\text{-}CH_2CH_2\text{-}OH$

(No.204) $HO\text{-}CH_2CH_2\text{-}NH\text{-}CO\text{-}C{\equiv}C\text{-}CO\text{-}NH\text{-}CH_2CH_2\text{-}OH$

(No.205) $HO\text{-}CH_2CH_2\text{-}NH\text{-}CO\text{-}(CH_2)_2\text{-}CO\text{-}NH\text{-}CH_2CH_2\text{-}OH$

(No.206) $HO\text{-}CH_2CH_2\text{-}NH\text{-}CO\text{-}(CH_2)\text{-}CO\text{-}NH\text{-}CH_2CH_2\text{-}OH$

(No.207) $HO\text{-}CH_2CH_2\text{-}NH\text{-}CO(CH_2)_5\text{-}CO\text{-}NH\text{-}CH_2CH_2\text{-}OH$

(No.208)

$$HO{-}CH_2CH_2{-}NH{-}CO{-}(CH_2)_8{-}CO{-}NH{-}CH_2CH_2{-}OH$$

(No.209)

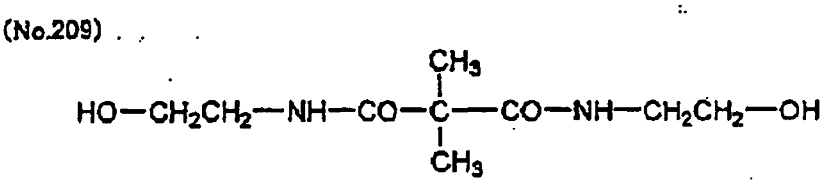

(No.210)

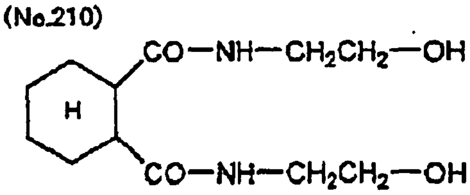

(No.211)

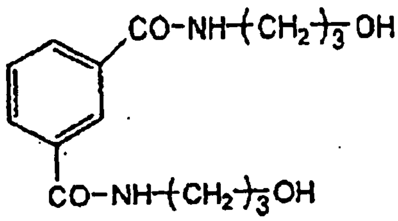

(No.212)

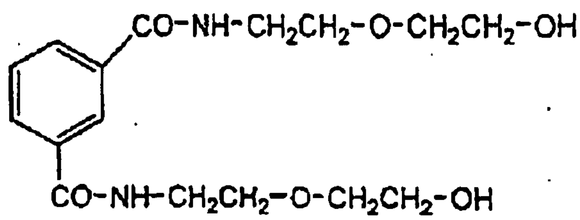

(No.213)

$HO-(CH_2)_3-NH-(CH_2)_3-NH-CO-(CH_2)_2-CO-NH-(CH_2)_3-OH$

(No.214)

$HO-CH_2CH_2-O-CH_2CH_2-NH-CO-(CH_2)_4-CO-NH-CH_2CH_2-O-CH_2CH_2-OH$

(No.215) $HO-CH_2CH_2-NH-CO-CH_2-O-CH_2-CO-MH-CH_2CH_2-OH$

(No.216)

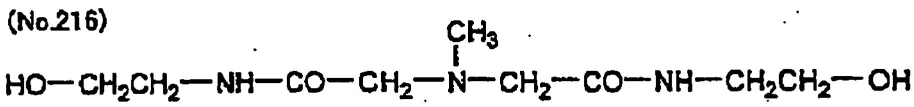

(No.217)

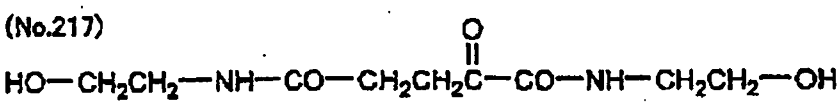

(No.218) $HO-OH_2CH_2-NH-CO-CH_2-S-CH_2-CO-NH-CH_2CH_2-OH$

(No.219)

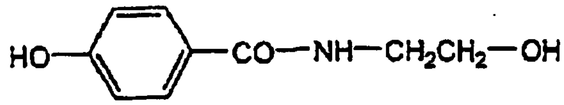

(No.220)

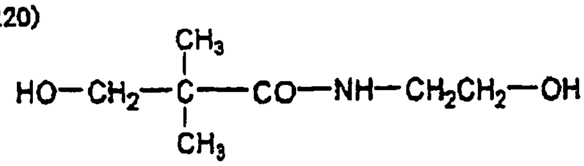

The following diol compounds are also favorable to the invention.

$$HO\text{-}Ar_2\text{-}(L_{16}\text{-}Ar_3)^n\text{-}OH \qquad (21)$$

$$HO\text{-}Ar_2\text{-}L_{16}\text{-}OH \qquad (22)$$

In these formulae, $L_{16}$ represents a divalent aliphatic hydrocarbon group optionally substituted (for example, preferably with any of an alkyl, aralkyl, aryl, alkoxy, aryloxy or halogeno group). If desired, $L_{16}$ may contain any other functional group not reacting with an isocyanate group, for example, an ester, urethane, amido or ureido group.

$Ar_2$ and $Ar_3$ may be the same or different, and each represents an optionally-substituted divalent aromatic hydrocarbon group, preferably an aromatic group having from 6 to 15 carbon atoms.

n is an integer of from 0 to 10.

Examples of the diol compounds of formulae (21) and (22) are mentioned below.

They are catechol, resorcinol, hydroquinone, 4-methylcatechol, 4-t-butylcatechol, 4-acetylcatechol, 3-methoxycatechol, 4-phenylcatechol, 4-methylresorcinol, 4-ethylresorcinol, 4-t-butylresorcinol, 4-hexylresorcinol, 4-chlororesorcinol, 4-benzylresorcinol, 4-acetylresorcinol, 4-carbomethoxyresorcinol, 2-methylresorcinol, 5-methylresorcinol, t-butylhydroquinone, 2,5-di-t-butylhydroquinone, 2,5-di-t-amylhydroquinone, tetramethylhydroquinone, tetrachlorohydroquinone, methylcarboaminohydroquinone, methylureidohydroquinone, methylthiohydroquinone, benzonorborene-3,6-diol, bisphenol A, bisphenol S, 3,3'-dichlorobispheonol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-(p-hydroxyphenyl)propyl)benzene, bis (4-hydroxyphenyl) methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybenzyl alcohol, 4-hydroxybenzyl alcohol, 2-hydroxy-3,5-di-t-butylbenzyl alcohol, 4-hydroxy-3,5-di-t-butylbenzyl alcohol, 4-hydroxyphenethyl alcohol, 2-hydroxyethyl 4-hydroxybenzoate, 2-hydroxyethyl-4-hydroxyphenyl acetate, resorcinol mono-2-hydroxyethyl ether. The following diol compounds are also favorably used herein.

Preferably, the diol compound having a value log P of larger than 0 has log P of from 0.5 to 30, more preferably from 1 to 20, even more preferably from 2 to 15, still more preferably from 3 to 15 in view of the printing durability of the printing plate of the invention. In particular, the compounds of formulae (A) to (E) are preferred as they ensure good printing durability of the printing plate. Above all, polypropylene glycols of formula (A) where $R_6$ is a methyl group are more preferred. Of the polypropylene glycols of formula (A) where $R_6$ is a methyl group, even more preferred are those where a is from 5 to 50, even more preferably from 10 to 40, still more preferably from 15 to 30, in view of the good balance of printing durability and staining resistance of the printing plate.

The content of the structure derived from at least one diol compound having a value log P of larger than 0, in the polyurethane resin binder for use herein may be suitably determined, depending on the value log P of the diol compound used, the type of the other diol component to be used, the acid value and the molecular weight of the polyurethane resin binder to be obtained, and the composition and the pH of the developer to be used, and preferably it is from 1 to 45 ml%, more preferably from 5 to 40 mol%, evenmore preferably from 10 to 35 mol%, still more preferably from 15 to 30 mol%.

One or more of diol compounds having a value log P of larger than 0 may be used herein either singly or as combined. In view of the stability (sensitivity, printing durability) of the printing plate, single use of one compound of the type is preferred.

(v) Other amino group-having compound:

For the polyurethane resin binder for use in the invention, the following amino group-having compounds may be combined and reacted with the diisocyanate compound of formula (1) to form an urea structure, and it may be introduced into the structure of the polyurethane resin.

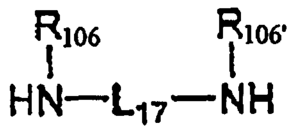

(31)

(32)

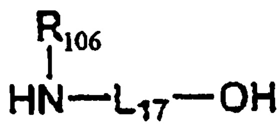

In these formulae, $R_{106}$ and $R_{106'}$ may be the same or different, and each represents a hydrogen atom, or an alkyl, aralkyl or aryl group optionally substituted (for example, with any of a halogen atom (-F, -Cl, -Br, -I), an ester group or a carboxyl group), and is preferably a hydrogen atom, or an alkyl group having from 1 to 8 carbon atoms or an aryl group having from 6 to 15 carbon atoms that is optionally substituted with a carboxyl group. $L_{17}$ represents a divalent aliphatic hydrocarbon, aromatic hydrocarbon or heterocyclic group optionally substituted (for example, with any of an alkyl group, an aralkyl group, an aryl group, an alkoxy group, an aryloxy group, a halogen atom (-F, -Cl, -Br, -I), or a carboxyl group). If desired, $L_{17}$ may have any other functional group not reacting with an isocyanate group, for example, a carbonyl, ester, urethane or amido group. Two of $R_{106}$, $L_{17}$ and $R_{106'}$ may form a ring.

Examples of the compounds of formulae (31) and (32) are mentioned below.

They are aliphatic diamine compounds such as ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine, isophoronediamine; aromatic diamine compounds such as o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl) sulfone, 4-carboxy-o-phenylenediamine, 3-carboxy-m-phenylenediamine, 4,4'-diaminophenyl ether, 1,8-naphthalenediamine; heterocyclic amine compounds such as 2-aminoimidazole, 3-aminotriazole, 5-amino-1H-tetrazole, 4-aminopyrazole, 2-aminobenzimidazole, 2-amino-5-carboxy-triazole, 2,4-diamino-6-methyl-S-triazine, 2,6-diaminopyridine, L-histidine, DL-tryptophane, adenine; aminoalcohol or aminophenol compounds such as ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol, L-tyrosine.

The polyurethane resin for use in the invention may be produced by heating the above-mentioned isocyanate compound and diol compound in an aprotic solvent in the presence of a known catalyst that corresponds to the reactivity of each reactant and is added to the reaction system. The molar ratio of the diisocyanate compound (i) to all the diol compounds (total of (ii), (iii) and (iv)), or when the reaction system additionally contains (v) any other amino group-having compound, the molar ratio of the diisocyanate compound (i) to all the other compounds than the diisocyanate compound (total of (ii), (iii), (iv) and (v)) preferably falls between 0.8/1 and 1.2/1. In case where an isocyanate group has remained at the terminal of the polymer, then the polymer may be processed with any of alcohols or amines so that the final polymer may have no isocyanate group remaining therein.

For the polyurethane resin that is one essential component of the photosensitive layer in the invention, preferred are those having a carboxyl group content of from 0.2 to 4.0 meq/g, more preferably from 0.3 to 3.0 meq/g, even more preferably from 0.4 to 2.0 meq/g, still more preferably from 0.5 to 1.5 meq/g, most preferably from 0.6 to 1.2 meq/g.

For the polyurethane resin binder for use in the invention, preferred are those produced from the following <1> to <4> and having an acid value of from 0.6 to 1.2 meq/g.

<1> At least two diisocyanate compounds that are a combination of at least one aliphatic diisocyanate compound (where L is an aliphatic group) and at least one aromatic diisocyanate compound (where L is an aromatic group),
<2> at least one diol compound having a carboxyl group of formula (2),
<3> at least one diol compound having a value log P of from -5 to -1.2, and
<4> at least one diol compound having a value log P of from 3 to 10.

One or more of these polyurethane resins may be used herein either singly or as combined.
The polyurethane resin content of the photosensitive resin composition may be from 10 to 90 % by weight, but preferably from 15 to 80 % by weight, more preferably from 20 to 70 % by weight, even more preferably from 25 to 60 % by weight, most preferably from 30 to 50 % by weight.
i) More preferred examples of the polyurethane resin for use herein are given in Tables 1 to 3, which, however, are not limitative. Most of these examples are shown as a combination of the diisocyanate compound and the diol compound used. The carboxyl group content of each resin is shown in terms of the acid value thereof.

Table 1 - Polyurethane Resins

| | Diisocyanate Compound Used (mol%) | Diol Compound Used (mol%) | Acid Value (meq/g) |
|---|---|---|---|
| (1) | (i)-1 (50) | (ii)-1 (20)<br>(iii)-6 (20)<br>(iv)-4 (10) | 0.42 |
| (2) | (i)-2 (50) | (ii)-2 (10)<br>(iii)-1 (15)<br>(iv)-9 (25) | 0.56 |
| (3) | (i)-3 (30)<br>(i)-5 (20) | (ii)-3 (15)<br>(iii)-3 (15)<br>(iv)-1 (20) | 0.70 |
| (4) | (i)-2 (5)<br>(i)-6 (45) | (ii)-4 (20)<br>(iii)-2 (20)<br>(iv)-11 (5)<br>(v)-1 (5) | 0.88 |
| (5) | (i)-1 (40)<br>(i)-4 (10) | (ii)-1 (40)<br>(iii)-5 (5)<br>(iv)-5 (5) | 1.49 |
| (6) | (i)-2 (25)<br>(i)-5 (25) | (ii)-3 (30)<br>(iii)-4 (10)<br>(iv)-7 (10) | 0.93 |
| (7) | (i)-1 (40)<br>(i)-2 (10) | (ii)-1 (25)<br>(iii)-2 (15)<br>(iv)-12 (10) | 0.90 |
| (8) | (i)-5 (25)<br>(i)-6 (25) | (ii)-1 (35)<br>(iii)-3 (10)<br>(iv)-9 (5) | 1.84 |
| (9) | (i)-2 (10)<br>(i)-6 (40) | (ii)-1 (40)<br>(iii)-1 (5)<br>(iv)-2 (5) | 2.46 |

Table 2

| | Diisocyanate Compound Used (mol%) | Diol Compound Used (mol%) | Acid Value (meq/g) |
|---|---|---|---|
| (10) | (i)-5 (50) | (ii)-2 (20)<br>(iii)-1 (10) | 0.68 |

(continued)

| | Diisocyanate Compound Used (mol%) | Diol Compound Used (mol%) | Acid Value (meq/g) |
|---|---|---|---|
| | | (iv)-13 (10)<br>(v)-2 (10) | |
| (11) | (i)-1 (40)<br>(i)-2 (10) | (ii)-1 (40)<br>(iii)-3 (5)<br>(iv)-16 (5) | 1.40 |
| (12) | (i)-1 (40)<br>(i)-2 (10) | (ii)-1 (20)<br>(iii)-5 (20)<br>(iv)-14 (10) | 0.32 |
| (13) | (i)-1 (40)<br>(i)-2 (10) | (ii)-1 (25)<br>(iii)-6 (15)<br>(iv)-17 (10) | 0.62 |
| (14) | (i)-1 (40)<br>(i)-2 (10) | (ii)-4 (35)<br>(iii)-5 (5)<br>(iv)-3 (10) | 1.08 |
| (15) | (i)-1 (40)<br>(i)-2 (10) | (ii)-1 (30)<br>(iii)-4 (10)<br>(iv)-15 (10) | 0.86 |
| (16) | (i)-1 (40)<br>(i)-2 (10) | (ii)-1 (25)<br>(iii)-1 (15)<br>(iv)-10 (10) | 1.42 |
| (17) | (i)-1 (40)<br>(i)-2 (10) | (ii)-1 (10)<br>(iii)-4 (10)<br>(iv)-2 (20)<br>(v)-6 (10) | 0.89 |
| (18) | (i)-1 (40)<br>(i)-2 (10) | (ii)-1 (20)<br>(iii)-2 (15)<br>(iv)-4 (5)<br>(v)-11 (10) | 0.74 |

Table 3

| | Diisocyanate Compound Used (mol%) | Diol Compound Used (mol%) | Acid Value (meq/g) |
|---|---|---|---|
| (19) | (i)-1 (40)<br>(i)-2 (10) | (ii)-1 (20)<br>(iii)-2 (15)<br>(iv)-4 (10)<br>(iv)-15 (5) | 0.78 |
| (20) | (i)-1 (90)<br>(i)-2 (10) | (ii)-1 (25)<br>(iii)-5 (10)<br>(iv)-6 (15) | 0.68 |
| (21) | (i)-1 (40)<br>(i)-2 (10) | (ii)-3 (40)<br>(iii)-3 (5)<br>(iv)-12 (5) | 1.27 |
| (22) | (i)-1 (40)<br>(i)-2 (10) | (ii)-1 (20)<br>(iii)-2 (10)<br>(iv)-9 (20) | 0.93 |

(continued)

| | Diisocyanate Compound Used (mol%) | Diol Compound Used (mol%) | Acid Value (meq/g) |
|---|---|---|---|
| (23) | (i)-1 (40)<br>(i)-2 (10) | (ii)-1 (25)<br>(iii)-5 (5)<br>(iv)-7 (20) | 0.91 |
| (24) | (i)-1 (40)<br>(i)-2 (10) | (ii)-1 (30)<br>(iii)-1 (10)<br>(iv)-12 (10) | 1.15 |
| (25) | (i)-1 (40)<br>(i)-2 (10) | (ii)-1 (10)<br>(ii)-2 (10)<br>(iii)-2 (10)<br>(iii)-3 (10)<br>(iv)-12 (10) | 0.69 |

(i) Diisocyanate Compound:

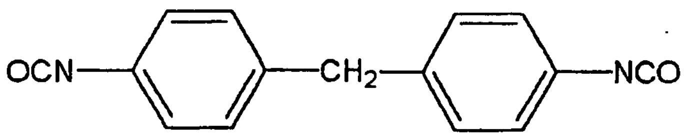

(i)-1

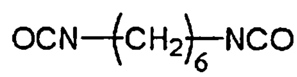

(i)-2

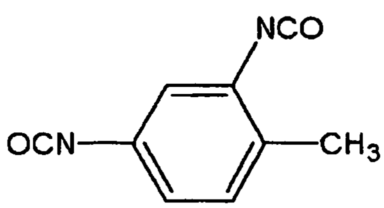

(i)-3

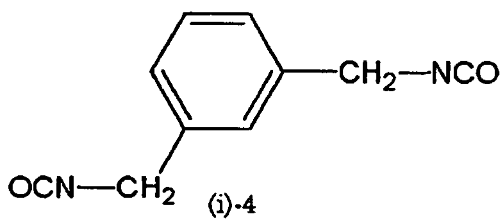

(i)-4

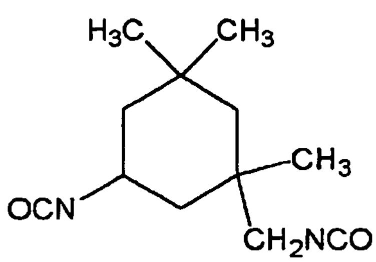

(i)-5

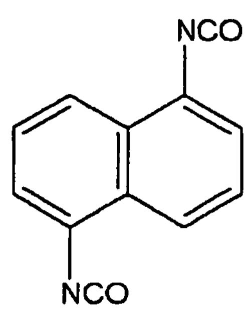

(i)-6

(ii) Carboxyl Group-Having Diol Compound:

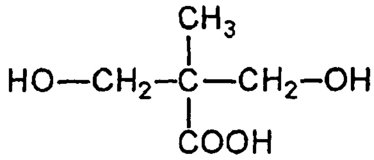

(ii)-1

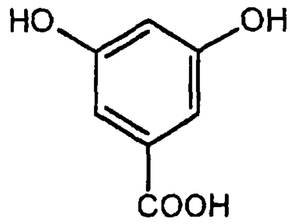

(ii)-2

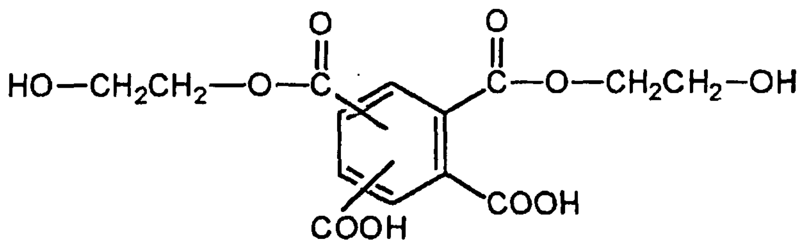

(ii)-3

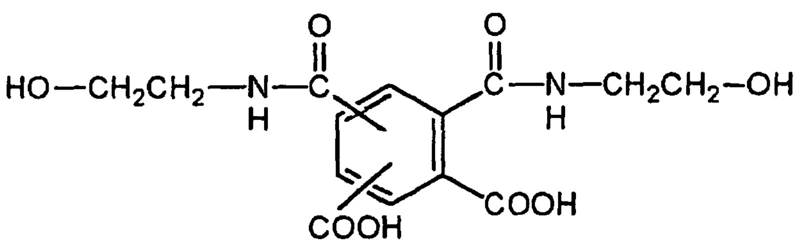

(ii)-4

(iii) Diol Compound with log P of smaller than 0:

$$HO-(CH_2CH_2O)_n-H$$

| | | log P |
|---|---|---|
| n = 2 | (iii)-1 | -0.87 |
| n = 4 | (iii)-2 | -1.20 |
| polyethylene glycol with number-average molecular weight of 300 | (iii)-3 | -1.60 |
| polyethylene glycol with number-average molecular weight of 1000 | (iii)-4 | -4.22 |
| polyethylene glycol with number-average molecular weight of 2000 | (iii)-5 | -7.97 |

(continued)

| | | log P |
|---|---|---|
| 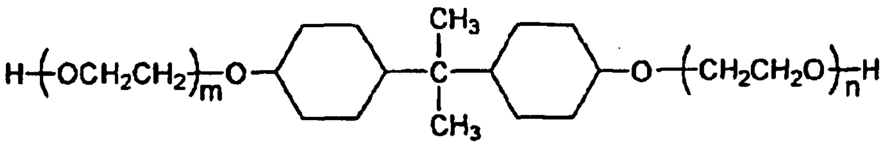 | | |
| m+n ≒ 30 (hydroxyl value 72 mg KOH/g) | (iii)-6 | -1.78 |

(iv) Diol Compound with log P of larger than 0:

log P

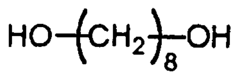

(iv)-1

1.38

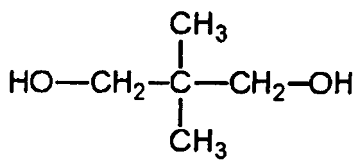

(iv)-2

0.45

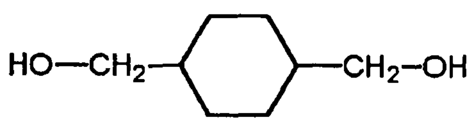

(iv)-3

0.89

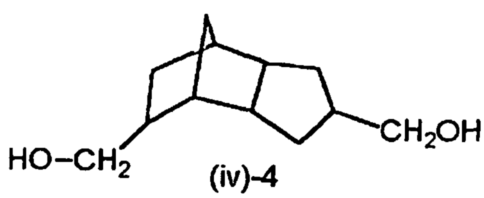

(iv)-4

1.20

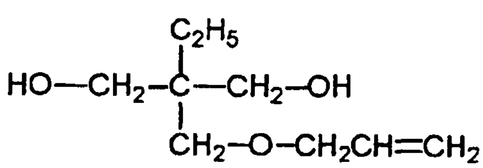

(iv)-5

0.86

(continued)

log P

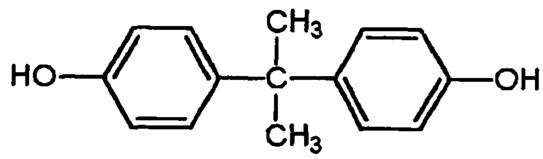

(iv)-6 — 4.32

$HO-CF_2CF_2-OH$ (iv)-7 — 1.20

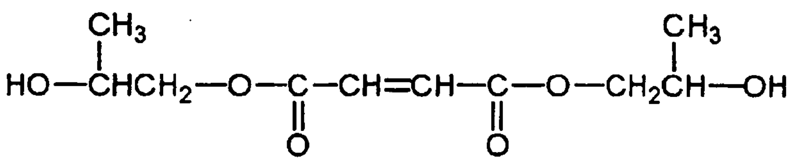

(iv)-8 — 0.05

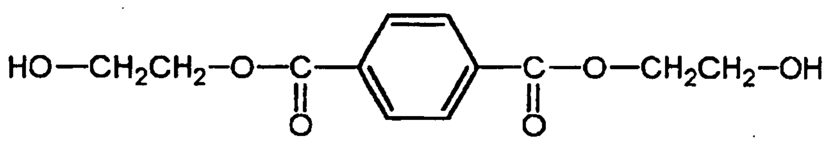

(iv)-9 — 0.62

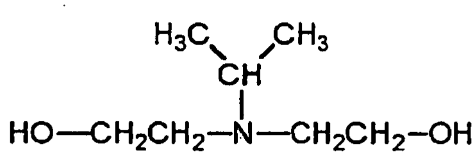

(iv)-10 — 0.03

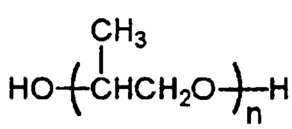

| | | |
|---|---|---|
| number-average molecular weight 425 | (iv)-11 | 1.19 |
| number-average molecular weight 1000 | (iv)-12 | 3.65 |

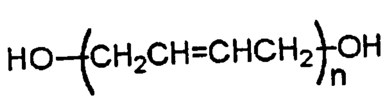

| | | |
|---|---|---|
| number-average molecular weight 1200 (hydroxyl value 95 mg KOH/g) | (iv)-13 | 26.6 |

(continued)

log P

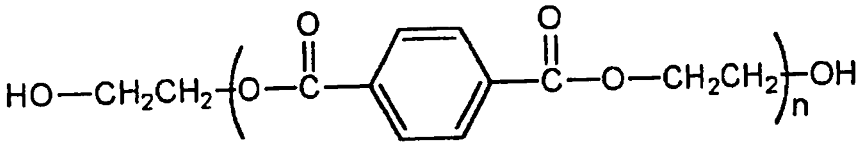

(iv)-14

4.61

number-average molecular weight 850
(hydroxyl value 135 mg KOH/g)

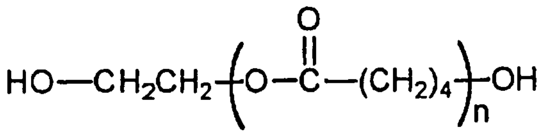

(iv)-15

3.08

number-average molecular weight 1000
(hydroxyl value 112 mg KOH/g)

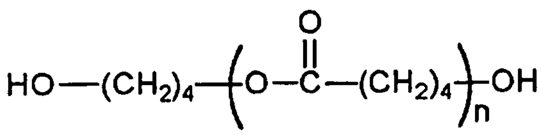

(iv)-16

7.49

number-average molecular weight 2000
(hydroxyl value 56 mg KOH/g)

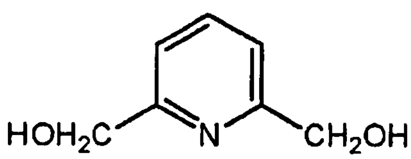

(iv)-17

0.46

(v) Other amino group-having compound:

$HO-CH_2CH_2-NH_2$ (v)-1

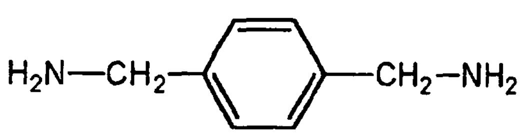

(v)-2

It is desirable that the polyurethane binder has a suitable molecular weight and a suitable acid value for ensuring good developability and good printing durability of the printing plate of the invention. The molecular weight and the acid value of the binder may be suitably determined depending on the pH and the composition of the developer to be used and the necessary properties of the printing plate. In general, the molecular weight, in terms of polystyrene measured

through GPC, is from 5,000 to 500,000, preferably from 10,000 to 30,000, more preferably from 20,000 to 150,000. When the molecular weight of the binder is 5, 000 ormore, it enables good printing durability of the printing plate; and when 500, 000 or less, it ensures good developability not causing stains in prints. On the other hand, the acid value of the binder resin may be from 0.2 to 4.0 meq/g, but preferably from 0.3 to 3.0 meq/g, more preferably from 0.4 to 2.0 meq/g, even more preferably from 0.5 to 1.5 meq/g, most preferably from 0.6 to 1.2 meq/g. When the acid value of the binder is at least 0.2 meq/g, then it ensures good developability of the printing plate not causing stains in prints; and when at most 6.0 meq/g, it enables good printing durability.

Any desired amount of the polyurethane resin binder may be in the photosensitive composition. Concretely, it may be at most 90 % by weight of the composition in view of the strength of the image to be formed. Preferably, it is from 10 to 90 % by weight, more preferably from 30 to 80 % by weight.

The polyurethane resin binder mentioned above may be combined with any other polymer binder for use in the invention. The content of the other polymer binder may be generally at most 100 % by weight, but preferably at most 50 % by weight of the polyurethane resin binder.

Preferably, the ratio by weight of the photopolymerizable ethylenic unsaturated compound to the overall polymer binder falls between 1/9 and 9/1, more preferably between 2/8 and 8/2, even more preferably between 3/7 and 7/3.

<Acid Value of Photosensitive Layer>

The acid value of the photosensitive layer as referred to herein is meant to indicate the equivalent of the acid having a pKa of at most 9, per gram of the photosensitive composition to form a photosensitive layer (not including overcoat layer such as oxygen-blocking layer to be formed on the photosensitive layer) on the support of a photosensitive lithographic printing plate (precursor). In experiments, it may be directly obtained through titration of the photosensitive layer with an aqueous sodium hydroxide solution. Alternatively, it may be computed from the content of the compound having an acid group and having a pKa of at most 9 in the photosensitive composition.

Concretely, for varying the acid value of the photosensitive layer, employable is a method of changing the content ratio of the components of the photosensitive layer, crosslinking monomer/acid group-having binder polymer (linear polymer), or using a binder polymer of which the acid group content is small and the acid value is therefore low.

The binder polymer having a low acid value may be used within a range of from 0.2 to 4.0 meq/g, preferably from 0.3 to 3.0 meq/g, more preferably from 0.4 to 2.0 meq/g, even more preferably from 0.5 to 1.5 meq/g, most preferably from 0.6 to 1.2 meq/g.

Preferably, the acid value of the photosensitive layer in the invention is at most 1.0 meq/g. The invention is more effective for lithographic printing plates in which the photosensitive layer has an acid value of from 0.20 to 0.60 meq/g. In view of the image formability thereof, it is more desirable that the photosensitive layer has an acid value of from 0.30 to 0.50 meq/g

<b. Ethylenic Unsaturated Bond-Having Compound>

The ethylenic unsaturated bond-having compound is a compound with an ethylenic unsaturated bond that undergoes addition polymerization by the action of a photopolymerization initiator thereon when the photopolymerizable composition containing it is exposed to active rays, to thereby crosslink and cure. The addition-polymerizable, ethylenic unsaturated bond-containing compound may be selected in any desired manner from compounds having at least one, but preferably 2 or more terminal ethylenic unsaturated bonds. For example, they may be in any chemical morphology of monomers, prepolymers, that is, dimers, trimers or oligomers, or their mixtures and copolymers.

Examples of monomers and their copolymers are esters of unsaturated carboxylic acids (e.g., acrylic acid, methacrylic acid, itaconic acid, crotonic acid, isocrotonic acid, maleic acid) with aliphatic polyalcohol compounds, and amides of unsaturated carboxylic acids with aliphatic polyamine compounds.

Examples of the monomers of the esters of unsaturated carboxylic acids with aliphatic polyalcohol compounds are acrylates such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritoltetraacrylate, dipentaerythritol diacrylate, dipentaerythritol pentaacrylate, dipentaerythritolhexaacrylate, sorbitoltriacrylate, sorbitol tetraacrylate, sorbitol pentaacrylate, sorbitol hexaacrylate, tri(acryloyloxyethyl) isocyanurate, polyester acrylate oligomer.

For their examples, methacrylates include tetramethylene glycol dimethacrylate, triethylene glycol dimethacrylate, neopentyl glycol dimethacrylate, trimethylolpropane triacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane bis[p-(methacryloxyethoxy)phenyl]dimethylmethane.

Itaconates include ethylene glycol diitaconate, propylene glycol diitaconate, 1,5-butanediol diitaconate, 1,4-butanedioldiitaconate,tetramethylene glycoldiitaconate, pentaerythritol diitaconate, sorbitol tetraitaconate.

Crotonates include ethylene glycol dicrotonate, tetramethylene glycol dicrotonate, pentaerythritol dicrotonate, sorbitol tetracrotonate.

Isocrotonates include ethylene glycol diisocrotonate, pentaerythritol diisocrotonate, sorbitol tetraisocrotonate.

Maleates include ethylene glycol dimaleate, triethylene glycol dimaleate, pentaerythritol dimaleate, sorbitol tetramaleate. Mixtures of these ester monomers are also usable herein.

Examples of the amides of unsaturated carboxylic acids with aliphatic polyamine compounds are methylenebisacrylamide, methylenebismethacrylamide, 1,6-hexamethylenebisacrylamide, 1,6-hexamethylenebismethacrylamide, diethylenetriamine-trisacrylamide, xylylenebisacrylamide, xylylenebismethacrylamide.

Other examples also usable herein are vinylurethane compounds having at least two polymerizable vinyl group in one molecule, which are produced by adding a hydroxyl group-having vinyl monomer of the following formula (A) to a polyisocyanate compound having at least two isocyanate groups in one molecule, as in JP-B 48-41708.

$$CH_2=C(R)COOCH_2CH(R')OH \qquad (A)$$

wherein R and R' each represent H or $CH_3$.

Also usable herein are urethane acrylates as in JP-A 51-37193 and JP-B 2-32293; and polyfunctional acrylates and methacrylates such as polyester acrylates and epoxy acrylates produced through reaction of epoxy resin and (meth) acrylic acid, as in JP-A 48-64183, and JP-B49-43191, 52-30490. Further usable are photocurable monomers and oligomers introduced in the Journal of Adhesive Association of Japan, Vol. 20, No. 7, pp. 300-308, 1984. The amount of the ethylenic unsaturated bond-having compound to be in the photopolymerizing photosensitive layer is from 5 to 80 % by weight, preferably from 30 to 70 % by weight of the layer.

<c. Photopolymerization Initiator>

The photopolymerization initiator to be in the photopolymerizing photosensitive layer in the photosensitive lithographic printing plate of the invention may be selected from various photopolymerization initiators known in patent references or other references or from combinations of two or more photopolymerization initiators (initiator systems), depending on the wavelength of the light source to be used. Some examples are mentioned below, to which, however, the invention is not limited. Various photopolymerization initiator systems are proposed for light sources of visible rays of 400 nm or longer, Ar laser, second harmonics of semiconductor laser, or SHG-YAG laser. For example, there are mentioned photoreducing dyes of some type, such as rose bengal, eosine, erythrosine as in USP 2, 850, 445; as well as combination systems of dyes and initiators, for example, composite system of dye and amine (JP-B 44-20189), combination system of hexaarylbiimidazole and radical generator and dye (JP-B 45-37377), system of hexaarylbiimidazole and p-dialkylaminobenzylidene ketone (JP-B 47-2528, JP-A 54-155292), system of cyclic cis-$\alpha$-dicarbonyl compound and dye (JP-A 48-84183), system of cyclic triazine and merocyanine dye (JP-A 54-151024), system of 3-ketocoumarin and activator (JP-A 52-112681,58-15503), system ofbiimidazole,styrene derivative and thiol (JP-A 59-140203), system of organic peroxide and dye (JP-A 59-1504, 59-140203, 59-189340, 62-174203, JP-B 62-1641, USP 4,766,055), system of dye and active halogen compound (JP-A 63-258903, 2-63054), system of dye and borate compound (JP-A 62-143044, 62-150242, 64-13140, 64-13141, 64-13142, 64-13143, 64-13144, 64-17048, 1-22-003, 1-298348, 1-138204), system of rhodanine ring-having dye and radical generator (JP-A 2-179643, 2-244050), system of titanocene and 3-ketocoumarin dye (JP-A 63-221110), system of titanocene, xanthene dye, and amino group or urethane group-having, addition-polymerizable ethylenic unsaturated bond-having compound (JP-A 4-221958, 4-219756), system of titanocene and specific merocyanine dye (JP-A6-295061), system of titanocene and benzopyran ring-having dye (JP-A 8-334897).

Laser (violet laser) to generate 400 to 410 nm waves has been developed recently, and high-sensitivity photoinitiator systems sensitive to waves not longer than 450 nm have been developed for it. These photoinitiator systems are also usable in the invention. For example, they are cationic dye/borate system (JP-A 11-84647), merocyanine dye/titanocene system (JP-A 2000-147763), and carbazole dye/titanocene system (JP-A 2001-42524).

Optionally, a hydrogen-donating compound of, for example, thiol compounds such as 2-mercaptobenzothiazole, 2-mercaptobenzimidazole, 2-mercaptobenzoxazole, or amine compounds such as N-phenylglycine, N,N-dialkylamino-aromatic alkyl esters may be added to the photopolymerization initiator, and it is known that adding the compound thereto enhances the photoinitiation performance of the initiator. The amount of the photopolymerization initiator (system) to be in the photopolymerization layer may be from 0.005 to 100 parts by weight, but preferably from 0.1 to 70 parts by weight, more preferably from 0.2 to 50 parts by weight relative to 100 parts by weight of the ethylenic unsaturated bond-having compound in the layer.

The photopolymerization layer in the photosensitive lithographic printing plate of the second aspect of the invention contains a sensitizing dye within a range within which the optical density of the photopolymerization layer containing it is from 0.2 to 1.0 at exposure wavelength.

Though not specifically defined, the sensitizing dye is preferably a compound of the following formula (SD-1) or (SD-2) :

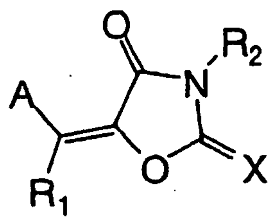

(SD-1)

wherein A represents an optionally-substituted aromatic or heterocyclic ring; X represents an oxygen or sulfur atom, or -N($R_3$)-; $R_1$, $R_2$ and $R_3$ each independently represent a hydrogen atom, or a monovalent non-metallic atomic group; A and $R_1$, and $R_2$ and $R_3$ may bond to each other to form an aliphatic or aromatic ring.

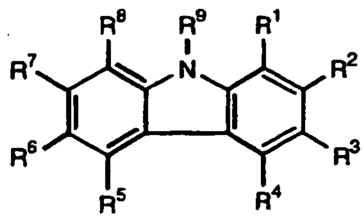

(SD-2)

wherein $R^1$, $R^2$, $R^3$, $R^4$, $R^5$, $R^6$, $R^7$, $R^8$ and $R^9$ each independently a hydrogen atom, or a monovalent non-metallic atomic group, provided that at least one of $R^1$ and $R^3$ is a monovalent organic residue represented by the following partial structural formula (a), and $R^1$, $R^2$, $R^3$, $R^4$, $R^5$, $R^6$, $R^7$, $R^8$ and $R^9$ may independently bond to each other to form an aliphatic or aromatic ring:

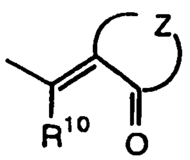

(a)

wherein $R^{10}$ represents a hydrogen atom, or a monovalent non-metallic atomic group; Z represents a divalent non-metallic atomic group necessary for forming a 5-membered acidic nucleus along with the adjacent atoms; $R^{10}$ may bond to any of $R^1$, $R^2$, $R^3$, $R^4$, $R^5$, $R^6$, $R^7$, $R^8$ or $R^9$ to form an aliphatic or aromatic ring.

Formula (SD-1) is described in detail. $R_1$, $R_2$ and $R_3$ each independently represent a hydrogen atom, or a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxyl group, or a halogen atom.

Preferred examples of $R_1$, $R_2$ and $R_3$ are described concretely. Preferably, the alkyl group is a linear, branched or cyclic alkyl group having from 1 to 20 carbon atoms, including, for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group. Of those, preferred are a linear alkyl group having from 1 to 12 carbon atoms, a branched alkyl group having

from 3 to 12 carbon atoms, and a cyclic alkyl group having from 5 to 10 carbon atoms.

The substituent for the substituted alkyl group may be a monovalent nonmetallic atomic group except hydrogen. Its preferred examples are a halogen atom (-F, -Br, -Cl, -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N, N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, an ureido group, an N'-alkylureido group, an N',N'-dialkylureido group,
an N'-arylureido group, N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group,
an alkoxycarbonyl group, an aryloxycarbonyl group, a carbamoyl group,an N-alkylcarbamoylgroup,an N,N-dialkylcarbamoylgroup, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugate base group (referred to as "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugate base group (referred to as "phosphonato group"), a dialkylphosphono group ($-PO_3(alkyl)_2$), a diarylphosphono group ($-PO_3(aryl)_2$), an alkylarylphosphono group ($-PO_3$ (alkyl) (aryl)), a monoalkylphosphono group ($-PO_3H$ (alkyl)) and its conjugate base group (referred to as "alkylphosphonato group"), a monoarylphosphono group ($-PO_3H$ (aryl)) and its conjugate base group (referred to as "arylphosphonato group"), a phosphonoxy group ($-OPO_3H_2$) and its conjugate base group (referred to as "phosphonatoxy group"), a dialkylphosphonoxy ($-OPO_3(alkyl)_2$), a diarylphosphonoxy group ($-OPO_3(aryl)_2$), an alkylarylphosphonoxy group ($-OPO_3$(alkyl)(aryl)), a monoalkylphosphonoxy group ($-OPO_3H$(alkyl)) and is conjugate base group (referred to as "alkylphosphonatoxy group"), a monoarylphosphonoxy group ($-OPO_3H$(aryl)) and is conjugate base group (referred to as "arylphosphonatoxy group"), a cyano group, a nitro group, an aryl group, a heteroaryl group, an alkenyl group, an alkynyl group.

For specific examples of the alkyl group in these substituents, referred are the alkyl groups mentioned above. Specific examples of the aryl group are a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group, a phosphonatophenyl group.

The heteroaryl group may be derived from a monocyclic or polycyclic hetero ring that has at least one of nitrogen, oxygen and sulfur atoms. Preferred examples of the heteroaryl group are thiophene, thianthrene, furan, pyran, isobenzofuran, chromene, xanthene, phenoxazine, pyrrole, pyrazole, isothiazole, isoxazole, pyrazine, pyrimidine, pyridazine, indolidine, isoindolidine, indole, indazole, purine, quinolidine, isoquinoline, phthalazine, naphthyridine, quinazoline, cinnoline, pteridine, carbazole, carboline, phenanthrene, acridine, pyrimidine, phenanthroline, phthalazine,phenarsazine,phenoxazine,furazane,phenoxazine. These may be benzo-condensed or may have substituent.

Examples of the alkenyl group are a vinyl group, a 1-propenyl group, a 1-butenyl group, a cinnamyl group, a 2-chloro-1-ethenyl group; and examples of the alkynyl group are an ethynyl group, a 1-propynyl group, a 1-butynyl group, a trimethylsilylethynyl group. $G_1$ in the acyl group ($G_1CO$-) may be a hydrogen atom or the above-mentioned alkyl or aryl group. Of those substituents, more preferred are a halogen atom (-F, -Br, -Cl, -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonoxy group, a phosphonatoxy group, an aryl group, and an alkenyl group.

The alkylene group in the substituted alkyl group may be a divalent organic residue that is derived from the above-mentioned alkyl group having from 1 to 20 carbon atoms by removing any one hydrogen atom from it. Preferably, it includes a linear alkylene group having from 1 to 12 carbon atoms, a branched alkylene group having from 3 to 12 carbon atoms, and a cyclic alkylene group having from 5 to 10 carbon atoms.

Combining any of the substituents as above with the alkylene group of the type gives the substituted alkyl group for $R_1$, $R_2$ and $R_3$, and its preferred examples are a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonoxypropyl group, a phosphonatoxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, 3-butynyl group.

The aryl group for $R_1$, $R_2$ and $R_3$ is preferably a condensed ring of from 1 to 3 benzene rings, or a condensed ring of a benzene ring with a 5-membered unsaturated ring. Its specific examples are a phenyl group, a naphthyl group, an anthryl group, a phenanthryl group, an indenyl group, acenaphthenyl group, a fluorenyl group. Of those, more preferred are a phenyl group and a naphthyl group.

The substituted aryl group for $R_1$, $R_2$ and $R_3$ may be derived from the above-mentioned aryl group by substituting any one ring-forming carbon atom of the group with a monovalent non-metallic atomic group except hydrogen. Preferred substituents for it are the above-mentioned alkyl group and substituted alkyl group, and the substituents mentioned hereinabove for the substituted alkyl group. Preferred examples of the substituted aryl group are a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyoxyphenyl group, an acetylaminophenyl group, an N-methylbenzoylaminophenyl group, a carboxyphenyl group, a methoxycarbonylphenyl group, an allyloxycarbonylphenyl group, achlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, adiphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propylphenyl group, a 2-butynylphenyl group, a 3-butynylphenyl group.

A in formula (SD-1) is described. A is an optionally-substituted aromatic ring or hetero ring. Examples of the optionally-substituted aromatic ring or hetero ring may be the same as those mentioned hereinabove for $R_1$, $R_2$ and $R_3$ in formula (SD-1).

The sensitizing dyes of formula (SD-1) for use in the invention are produced through condensation of the above-mentioned acid nucleus or an active methylene-having acid nucleus with a substituted or unsubstituted, aromatic or heterocyclic ring. These may be produced with reference to the description in JP-B 59-28329.

Preferred examples (D1) to (D28) of the compounds of formula (SD-1) are mentioned below, to which, however, the invention is not limited. Isomers with a double bond that bonds an acid nucleus and a basic nucleus are not clarified, and the invention is not limited to any specific isomers.

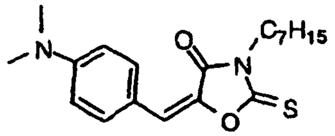

(D1)

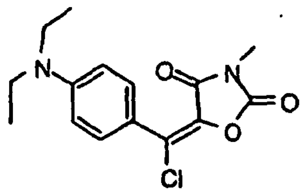

(D2)

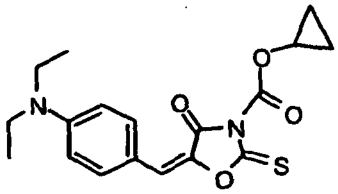

(D3)

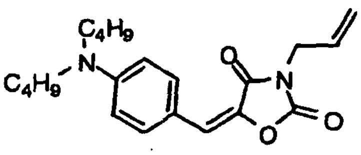

(D4)

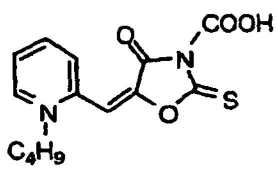

(D5)

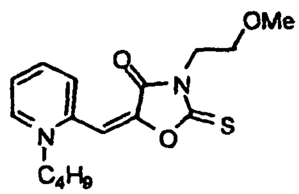

(D6)

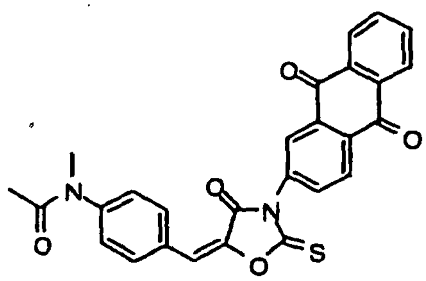

(D7)

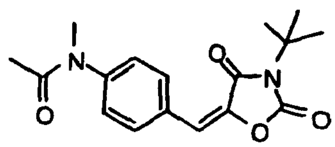

(D8)

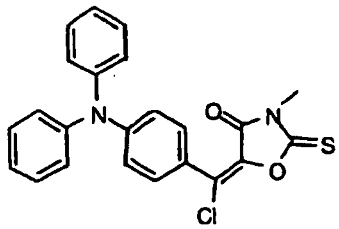

(D9)

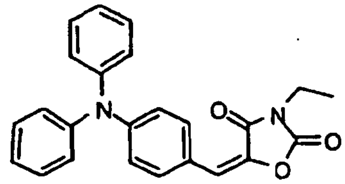

(D10)

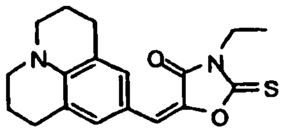

(D11)

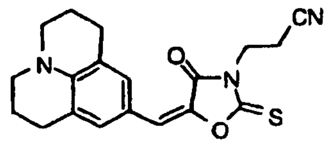

(D12)

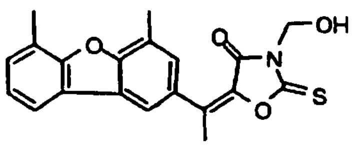

(D13)

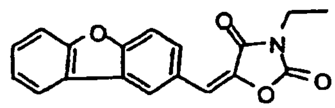

(D14)

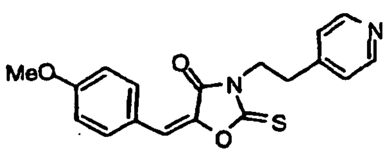

(D15)

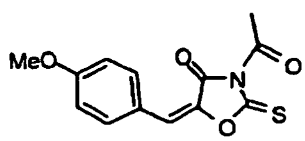

(D16)

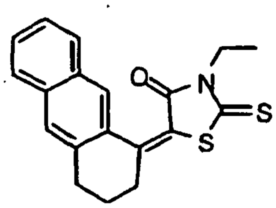

(D17)

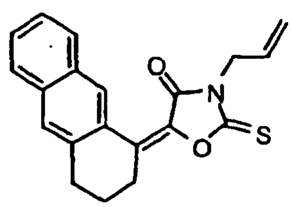

(D18)

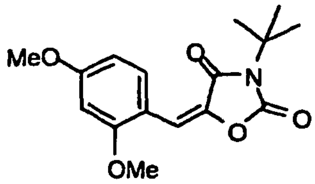

(D19)

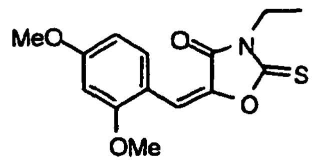

(D20)

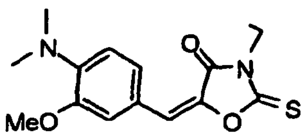

(D21)

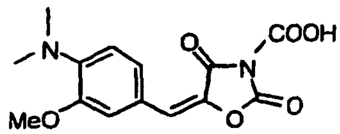

(D22)

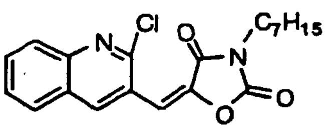

(D23)

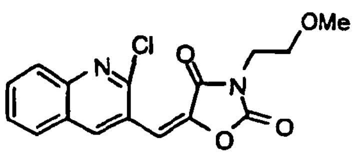

(D24)

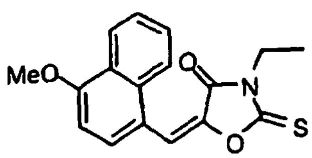

(D25)

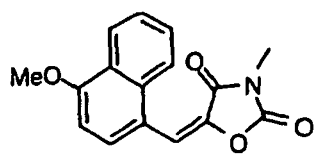

(D26)

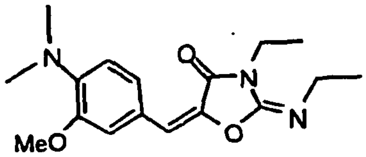

(D27)

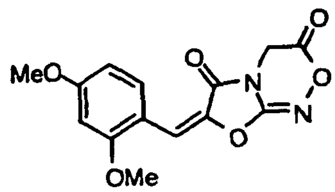

(D28)

Formula (SD-2) and partial structural formula (a) are described in detail. Like $R_1$, $R_2$ and $R_3$ in formula (SD-1) mentioned above, $R^1$, $R^2$, $R^3$, $R^4$, $R^5$, $R^6$,$R^7$, $R^8$ and $R^9$ each independently a hydrogen atom, or a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxyl group, or a halogen atom.

Preferred examples of $R^1$, $R^2$, $R^3$, $R^4$, $R^5$, $R^6$, $R^7$, $R^8$ and $R^9$ may be the same as those mentioned hereinabove for $R_1$, $R_2$ and $R_3$ in formula (SD-1).

Z in partial structural formula (a) is described below. Z represents a divalent non-metallic atomic group necessary for forming a 5-membered acidic nucleus along with the adjacent atoms. Specific examples of the acidic nucleus are 1,3-dicarbonyl nucleus (e.g., 1,3-indanedione, 1,3-dioxane-4,6-dione), pyrazolinone nucleus (e.g., 3-methyl-1-phenyl-2-pyrazolin-5-one, 1-phenyl-2-pyrazolin-5-one, 1-(2-benzothiazolyl)-3-methyl-2-pyrazolin-5-one), isoxazoline nucleus (e.g., 3-phenyl-2-isoxazolin-5-one, 3-methyl-2-isoxazolin-5-one), oxyindole nucleus (e.g., 1-alkyl-2,3-dihydro-2-oxyindole), 2-thio-2,4-thiazolidinedione nucleus (e.g., rhodanine and its N-substituted derivatives, such as 3-methylrhodanine, 3-ethylrhodanine, 3-phenylrhodanine, 3-allylrhodanine, 3-benzylrhodanine, 3-carboxymethylrhodanine, 3-carboxyethylrhodanine, 3-methoxycarbonylmethylrhodanine, 3-hydroxyethylrhodanine, 3-morpholinoethylrhodanine), 2-thio-2,4-oxazolidinedione nucleus (e.g., 2-thio-2,4-(3H,4H) oxazoledione nucleus such as 2-ethyl-2-thio-2,4-oxazolidinedione), thianaphthenone nucleus (e.g., 3(2H)-thianaphthenone, 3(2H)-thianaphthenone-2,2-dioxide), 2-thio-2,5-thiazolidinedione nucleus (e.g., 3-ethyl-2-thio-2,5-thiazolidinedione), 2,4-thiazolidinedione nucleus (e.g., 2,4-thiazolidinedione, 3-ethyl-4-thiazolidinedione, 3-phenyl-2,4-thiazolidinedione),thiazolidinone nucleus (e.g., 4-thiazolidinone, 3-ethyl-4-thiazolidinone, 2-ethylmercapto-4-thiazolidinone, 2-methylphenylamino-4-thiazolidinone), 2-imino-2-oxazolin-4-one nucleus (e.g., pseudohydantoin nucleus), 2,4-imidazolidinedione nucleus (e.g., hydantoin nucleus such as 2,4-imidazolidinedione, 3-ethyl-2,4-imidazolidinedione, 1,3-diethyl-2,4-imidazolidinedione), 2-thio-2,4-imidazolidinedione nucleus (e.g., thiohydantoin nucleus such as 2-thio-2,4-imidazolidinedione, 3-ethyl-2-thio-2,4-imidazolidinedione, 1,3-diethyl-2-thio-2,4-imidazolidinedione), imidazolin-5-one nucleus (e.g., 2-propylmercapto-2-imidazolin-5-one), furan-5-one nucleus, thioindoxyl nucleus (e,g., 5-methylthioindoxyl). These acidic nuclei may be substituted.

Of the carbazole-type sensitizing dyes of formula (SD-2) with partial structural formula (a), those having the structure of any of the following formulae (SD-3) to (SD-7) are especially preferred as their sensitizing ability is good and they give photosensitive compositions of extremely good storage stability.

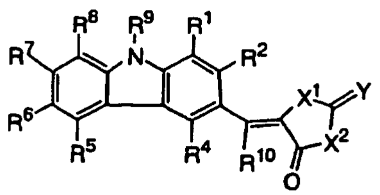

(SD-3)

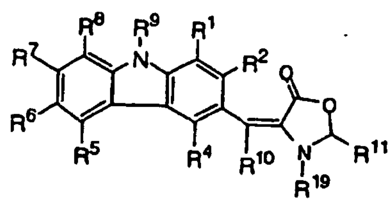

(SD-4)

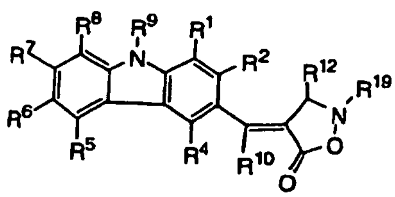

(SD-5)

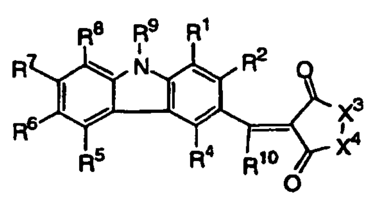

(SD-6)

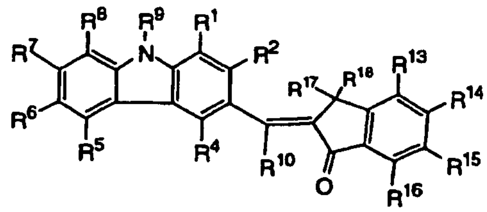

(SD-7)

In formulae (SD-3) to (SD-7), $R^1$, $R^2$, $R^3$, $R^4$, $R^5$, $R^6$, $R^7$, $R^8$, $R^9$ and $R^{10}$ have the same meanings as those in formula (SD-2) and partial structural formula (a) mentioned above; $X^1$, $X^2$, $X^3$ and $X^4$ each independently represent an O atom, an S atom or $NR^{20}$; Y represents an O atom, an S atom or $NR^{21}$; $R^{11}$ to $R^{21}$ each independently represent a hydrogen atom, or a monovalent nonmetallic atomic group, and they may bond to each other to form an optionally-substituted aliphatic or aromatic ring.

Formulae (SD-3) to (SD-7) are described in detail. In formulae (SD-3) to (SD-7), $R^1$, $R^2$, $R^3$, $R^4$, $R^5$, $R^6$, $R^7$, $R^8$, $R^9$ and $R^{10}$ have the same meanings as those in formula (SD-2); $R^{11}$ to $R^{21}$ each independently represent a hydrogen atom or a monovalent nonmetallic atomic group, preferably a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxyl group or a halogen atom. $R^{13}$ to $R^{19}$ may bond to each other to form an optionally-substituted aliphatic or aromatic ring. For preferred examples of $R^{11}$ to $R^{21}$, referred to are the same as those mentioned hereinabove for $R^1$, $R^2$, $R^3$, $R^4$, $R^5$, $R^6$, $R^7$, $R^8$, $R^9$ and $R^{10}$ in formula (SD-2).

In formulae (SD-3) to (SD-7), $X^1$, $X^2$, $X^3$ and $X^4$ each independently represent an O atom, an S atom or $NR^{20}$, and Y represents an O atom, an S atom or $NR^{21}$.

Sensitizing dyes of formulae (SD-2) to (SD-5) may be obtained through condensation of the above-mentioned acidic nuclei or an active methylene-having acidic nuclei with a substituted or unsubstituted carbazole-carbaldehyde. In addition, they may also be produced with reference to JP-B 59-28329.

Preferred examples (D31) to (D61) of the compounds of formula (SD-2) are mentioned below, to which, however, the invention is not limited. Isomers with a double bond that bonds an acid nucleus and a carbazole nucleus are not clarified, and the invention is not limited to any specific isomers.

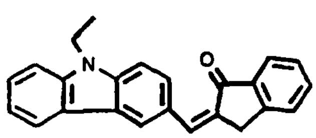

(D31)

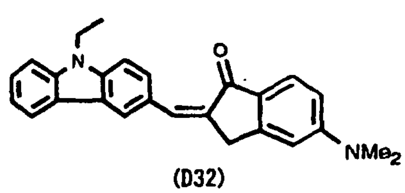

(D32)

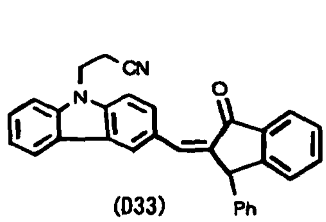

(D33)

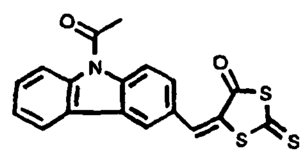

(D34)

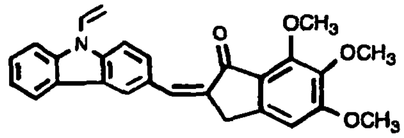

(D35)

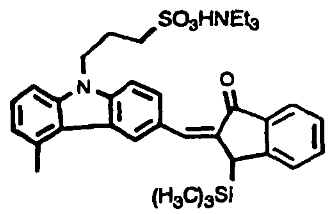

(D36)

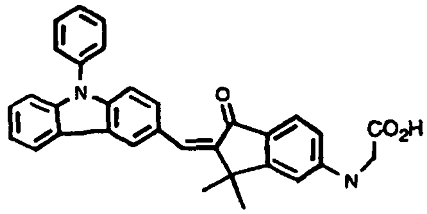

(D37)

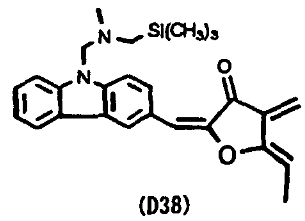

(D38)

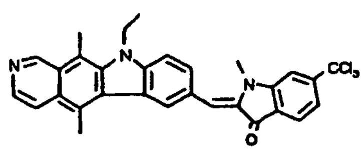

(D39)

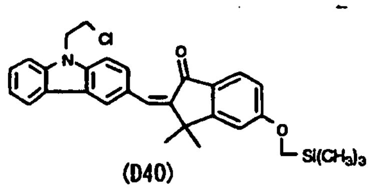

(D40)

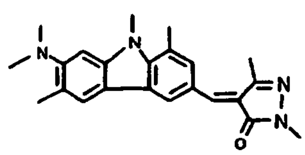

(D41)

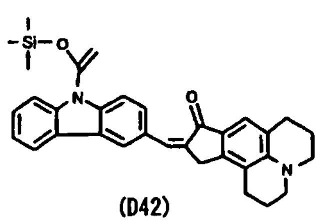

(D42)

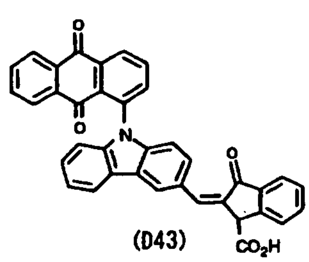

(D43)

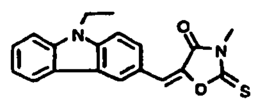

(D44)

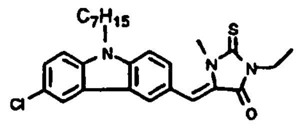

(D45)

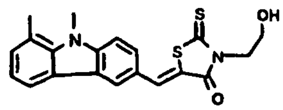

(D46)

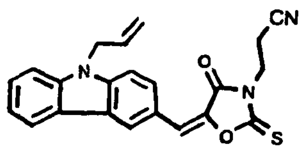

(D47)

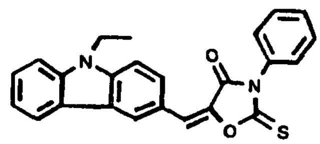

(D48)

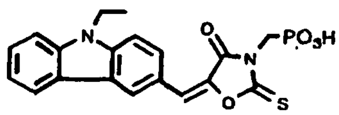

(D49)

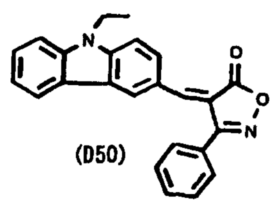

(D50)

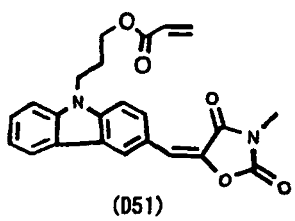

(D51)

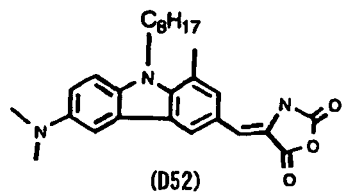

(D52)

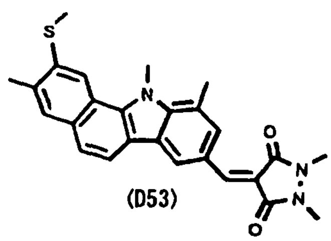

(D53)

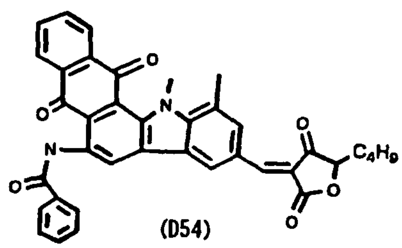

(D54)

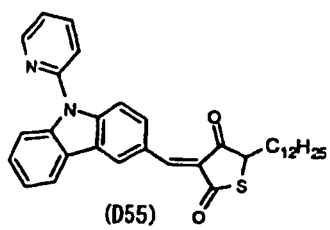

(D55)

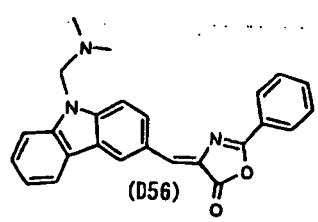

(D56)

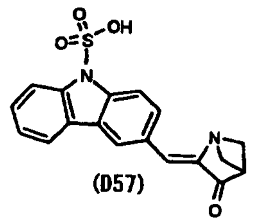

(D57)

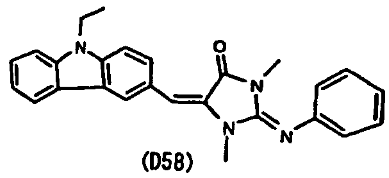

(D58)

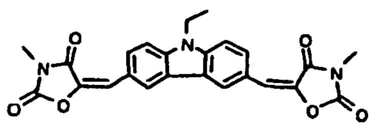

(D59)

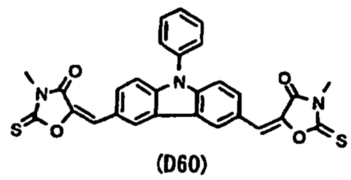

(D60)

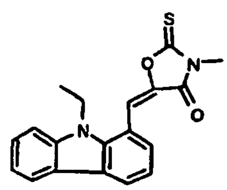

(D61)

The sensitizing dyes of formula (SD-1)and those of formula (SD-2) may be chemically modified in any desired manner for improving the properties of the photosensitive layer that contains any of them. For example, an addition-polymerizable compound structure (e.g., acryloyl group, methacryloyl group) may be bonded to the dyes in a mode of covalent bonding, ionic bonding or hydrogen bonding to thereby increase the strength of the exposed film or to prevent undesirable deposition of dye in the exposed film. In addition, the sensitizing dye may bond to the above-mentioned photopolymerization initiator or to any other radical generation part (e.g., reduction-cleavage site such as alkyl halide, onium, peroxide, biimidazole; oxidation-cleavage site such as borate, amine, trimethylsilylmethyl, carboxylmethyl, carbonyl, imine), thereby significantly increasing the photosensitivity of the layer when the concentration of the initiation system therein is low.

Ine one preferred embodiment thereof, the photosensitive lithographic printing plate of the invention is processed with aqueous developer. For enhancing the processability of the photosensitive layer with aqueous developer (alkali developer) in such a preferred embodiment, it is effective to introduce a hydrophilic moiety (acid group or polar group such as carboxyl group and its ester, sulfonic acid group and its ester, ethylene oxide group) into the sensitizing dyes. In particular, the ester-type hydrophilic group is characterized in that it has a relatively hydrophobic structure while in the photosensitive layer and is therefore well miscible with the other components therein, but when brought into contact with developer, it is readily hydrolyzed to produce an acid group to thereby increase the hydrophilicity of the sensitizing dyes. In addition, any other suitable substituentmaybe introduced into the sensitizing dyes for further enhancing their compatibility in the photosensitive layer and for preventing crystal deposition in the layer. For example, in some photosensitive systems, the unsaturated bond in an aryl group or an allyl is often extremely effective for improving the compatibility of the sensitizing dyes, and when a branched alkyl structure is introduced into the dyes, then it introduces steric hindrance into the $\pi$-plane of the dyes and therefore significantly inhibit crystal deposition in the layer. When a phosphonic acid group, an epoxy group or a trialkoxysilyl group is introduced into the sensitizing dyes, then it enhances the affinity of the dyes for inorganic substances such as metals and metal oxides. In addition, the sensitizing dyes may form polymers in accordance with their object for use herein.

The details of the application of the sensitizing dyes as to what type of them with what structure is to be used or as to whether two or more of them are combined, or as to how much of them is used may be suitably determined in accordance with the property design of the final photosensitive material to be produced herein. For example, when two or more different types of sensitizing dyes are combined and used, then it may enhance the compatibility of the combined dyes in the photosensitive layer. For selecting the sensitizing dyes for use herein, the photosensitivity of the dyes and the molar extinction coefficient thereof at the wavelength of the light source used are important factors. When dyes

having a large molar extinction coefficient are used, then their amount may be relatively small and therefore they are economical, and in addition, they are advantageous in point of the filmy physical properties of the photosensitive layer that contains them. Since the photosensitivity and the resolution of the photosensitive layer and the physical properties of the exposed film are significantly influenced by the absorbance (optical density) of the sensitizing dyes at the wavelength of the light source used, the amount of the sensitizing dyes to be added to the photosensitive layer is suitably determined in consideration of these parameters. For example, in a region in which the absorbance of the sensitizing dyes is smaller than 0.2, the sensitivity of the photosensitive layer is low. When influenced by halation, the resolution of the layer is low.

However, when a thick film of 5 μm or more are cured, sensitizing dyes having such a low absorbance will be rather favorable for increasing the hardness of the cured film. In a region in which the absorbance of the dyes is more than 1 and is high, most light having reached the surface of the photosensitive layer is absorbed by the layer and, as a result, the layer in its depth could not be well cured and the film strength and the adhesiveness to the support of the photosensitive layer will be poor. In lithographic printing plates in which the photosensitive layer is relatively thin, the amount of the sensitizing dye to be added to the layer is preferably is preferably so defined that the optical density of the layer could be from 0.2 to 1.0, more preferably from 0.25 to 1. In general, this corresponds to from 0.05 to 20 parts by weight, preferably from 0.1 to 20 parts by weight, more preferably from 0.2 to 10 parts by weight relative to 100 parts by weight of the components constituting the photosensitive layer.

The optical density of the sensitizing dye in the photosensitive layer may be measured by an ultraviolet-visible spectrophotometer.

The photopolymerization initiator to be combined with the sensitizing dye of formula (SD-1) or (SD-2) is preferably metallocene compounds (for example, titanocene), aromatic ketone, hexaaryldiimidazoles, ketoximeester compound, borate compound, onium salt, activated ester compound, halomethyl group-having compound, acylphosphine compound.

<d. Polymerization Inhibitor>

In addition to the basic components mentioned above, it is desirable that the photopolymerization layer in the invention additionally contains a small amount of a thermal polymerization inhibitor that inhibits unnecessary thermal polymerization of the polymerizable, ethylenic unsaturated bond-having compound in the photosensitive composition while the composition is prepared or stored. Examples of the thermal polymerization inhibitors are hydroquinone, p-methoxyphenol, di-t-butyl-p-cresol, pyrogallol, t-butylcatechol, benzoquinone, 4,4-thiobis(3-methyl-6-t-butylphenol), 2,2'-methylenebis(4-methyl-6-5-butylphenol), N-nitrosophenylhydroxylamine cerous salt, N-nitrosophenylhydroxylamine aluminium salt. The amount of the thermal polymerization inhibitor to be added to the composition is preferably from about 0.01 % to about 5 % of the composition. If further desired, a higher fatty acid or its derivative such as behenic acid or behenic acid amide may be added to the layer for preventing the compound from being polymerized by oxygen. While the photopolymerizing photosensitive layer with it is dried, the compound may be locally in the surface of the layer. The amount of the compound, higher fatty acid or its derivative to be added to the composition is preferably from about 0.5 % by weight to about 10 % by weight of the composition.

<e. Other Additives>

For coloring the photopolymerizing photosensitive layer, a colorant may be added to the layer. The colorant includes, for example, phthalocyanine pigments (C.I. Pigment Blue 15:3, 15: 4, 15: 6), azo pigments, other pigments such as carbon black and titanium oxide; and ethyl violet, crystal violet, azo dyes, anthraquinone dyes, cyanine dyes. The amount of the dye or pigment to be added to the composition is preferably from about 0.5 % by weight to about 20 % by weight of the composition. In addition, any other additives, for example, inorganic filler or plasticizer such as dioctyl phthalate, dimethyl phthalate or tricresyl phosphate may also be added to the composition. Their amount is preferably at most 10 % by weight of the composition.

Surfactant may be added to the photopolymerizing composition for the photopolymerizing photosensitive layer in the photosensitive lithographic printing plate of the invention for improving the quality of the layer. The amount of the coating layer may be generally from about 0.1 $g/m^2$ to about 10 $g/m^2$, but preferably from 0.3 to 5 $g/m^2$, more preferably from 0.5 to 3 $g/m^2$ in terms of the dry weight of the layer.

<f. Solvent>

When the photosensitive composition for the photosensitive lithographic printing plate of the invention is applied onto the above-mentioned subbing layer, it is dissolved in various types of solvent. The solvent usable for it includes, for example, acetone, methyl ethyl ketone, cyclohexanone, ethyl acetate, ethylene chloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol

monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate 3-methoxypropyl acetate, N,N-dimethylformamide, dimethylsulfoxide, γ-butyrolactone, methyl lactate, ethyl lactate. One or more of solvents may be used herein either singly or as combined. The solid concentration in the coating liquid is suitably from 1 to 50 % by weight.

[D. Protective Layer]

An oxygen-blocking protective layer is generally formed on the photopolymerizing photosensitive layer for protecting it frompolymerization by oxygen. A water-soluble vinyl polymer is in the oxygen-blocking protective layer, and it includes, for example, polyvinyl alcohol and its partial esters, ethers and acetals, as well as their copolymers that contain a substantial amount of unsubstituted vinyl alcohol units enough to ensure their solubility in water. The polyvinyl alcohol may be hydrolyzed to a degree of from 71 to 100 %, and its degree of polymerization may fall between 300 and 2400. Concretely, it includes Kuraray's PVA-105, PA-110, PVA-117, PVA-117H, PVA-120, PVA-124, PVA-214H, PVA-CS, PVA-CST, PVA-HC, PVA-203, PVA-204, PVA-025, PVA-210, PVA-217, PVA-220M PVA-224, PVA-217EE, PVA-217E, PVA-220E, PVA-224E, PVA-405, PVA-420, PVA-613, L-8. The copolymers include polyvinyl acetate chloroacetate or propionate, polyvinyl formal or polyvinyl acetate, and their copolymers that are hydrolyzed to a degree of 88 to 100 %. Other useful polymers are polyvinyl pyrrolidone, gelatin and gum arabic. One or more of these may be used herein either singly or as combined.

The solvent that is used in forming the oxygen-blocking protective layer in the photosensitive lithographic printing plate of the invention is preferably pure water, for which, however, any of alcohols such as methanol or ethanol, or ketones such as acetone or methyl ethyl ketone may be combined with pure water. The solid concentration in the coating liquid is suitably from 1 to 20 % by weight. Any known additives such as surfactant for improving the coatability of the coating liquid for the oxygen-blocking protective layer, or water-soluble plasticizer for improving the physical properties of the coated films may be added to the layer. The water-soluble plasticizer includes, for example, propionamide, cyclohexanediol, glycerin, sorbitol. In addition, water-soluble (meth)acrylic polymer may also be added to the layer. The amount of the coating layer is suitably from about 0.1 $g/m^2$ to about 15 $g/m^2$, but preferably from about 1.0 $g/m^2$ to about 5 $g/m^2$ in terms of the dry weight of the layer. [E. Plate-Making Method]

A method of processing the photosensitive lithographic printing plate of the invention to give a lithographic printing plate is described in detail hereinunder. The photosensitive lithographic printing plate is imagewise exposed and then developed with an alkali developer having a pH of generally from 11.0 to 12.7, preferably from 11.5 to 12.5.

(Developer)

The developer to be used in the method of making the lithographic printing plate is not specifically defined. Preferably, for example, it contains an inorganic alkali salt and a nonionic surfactant and has a pH of from 11.0 to 12.5.

The inorganic alkali salt may be any desired one. For example, it may be an inorganic alkali agent, including sodium, potassium, ammonium and lithium hydroxides, sodium, potassium ammonium and lithium silicates, sodium, potassium and ammonium tertiary phosphates, sodium, potassium and ammonium carbonates, sodium, potassium and ammonium hydrogencarbonates, sodium, potassium and ammonium borates. One or more of these may be used herein either singly or as combined.

In case where silicates are used in the developer, the developability of the developer may be readily controlled by controlling the blend ratio of silicon oxide $SiO_2$ and alkali oxide $M_2O$ (where M indicates an alkali metal or ammonium group) and the concentration of the resulting salt. For the aqueous alkali solution for development, it is desirable that the blend ratio of silicon oxide $SiO_2$ and alkali oxide $M_2O$ ($SiO_2/M_2O$ by mol) falls between 0.5 and 3.0, more preferably between 1.0 and 2.0. If the ratio $SiO_{2/}M_2O$ is smaller than 0.5, then it is preferably from 1 to 10 % by weight, more preferably from 3 to 8 % by weight, most preferably from 4 to 7 % by weight of the aqueous alkali solution. When the concentration is higher than 1 % by weight, then the developability and the processability of the developer will not good; and when it is lower than 10 % by weight, then the developer will not form deposit and crystal and, in addition, its waste will not gel when neutralized and waste treatment is easy.

An organic alkali agent may be added to the developer for delicately controlling the alkali concentration of the developer and for assisting the solubility of the photopolymerizing photosensitive layer. The organic alkali agent includes, for example, monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, tetramethylammonium hydroxide. One or more of these alkali agents may be used herein either singly or as combined.

Surfactant may also be used in the developer, if desired. It includes polyoxyalkylene ether group-having nonionic

surfactants and other nonionic surfactants, for example, polyoxyethylene alkyl esters such as polyoxyethylene stearate, sorbitan alkyl esters such as sorbitan monolaurate, sorbitan monostearate, sorbitan distearate, sorbitan monooleate, sorbitan sesquioleate, sorbitan trioleate, monoglyceride alkyl esters such as glycerol monostearate, glycerol monooleate; anionic surfactants, for example, alkylbenzenesulfonates such as sodium dodecylbenzenesulfonate, alkylnaphthalenesulfonates such as sodium butylnaphthalenesulfonate, sodium pentylnaphthalenesulfonate, sodium hexylnaphthalenesulfonate, sodium octylnaphthalenesulfonate, alkylsulfates such as sodium laurylsulfate, alkylsulfonates such as sodium dodecylsulfonate, sulfosuccinates such as sodium dilaurylsulfosuccinate; and ampholytic surfactants, for example, alkylbetaines such as laurylbetaine, stearylbetaine, and amino acids. Especially preferred are polyoxyalkylene ether group-having nonionic surfactants.

Preferred examples of the polyoxyalkylene ether group-having nonionic surfactants for use herein are those having a structure of the following formula (A):

$$R^{40}\text{-O-}(R^{41}\text{-O})_pH \qquad (A)$$

wherein $R^{40}$ represents an optionally-substituted alkyl group having from 3 to 15 carbon atoms, an optionally-substituted aromatic hydrocarbon group having from 6 to 15 carbon atoms, or an optionally-substituted heterocyclic aromatic group having from 4 to 15 carbon atoms (in which the substituent may be any of an alkyl group having from 1 to 20 carbon atoms, a halogen atom such as Br, Cl, I, an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms, an acyl group having from 2 to 15 carbon atoms); $R^{41}$ represents an optionally-substituted alkylene group having from 1 to 100 carbon atoms (in which the substituent may be any of an alkyl group having from 1 to 20 carbon atoms, and an aromatic hydrocarbon group having from 6 to 15 carbon atoms) ; and p indicates an integer of from 1 to 100.

In the definition of (A), specific examples of the "aromatic hydrocarbon group" are a phenyl group, a tolyl group, a naphthyl group, an anthryl group, a biphenyl group, and a phenanthryl group; and specific examples of the "heterocyclic aromatic group" are a furyl group, a thionyl group an oxazolyl group, an imidazolyl group, a pyranyl group, a piperidinyl group, an acridinyl group, a benzofuranyl group, a benzothionyl group, a benzopyranyl group, a benzoxazolyl group, and a benzimidazolyl group.

Within the range defined above, two or three different types of the group may be for the moiety of $(R^{41}\text{-O})_p$ in formula (A). Concretely mentioned are random-like or block-like combinations of ethylene oxy group and propylene oxy group; ethylene oxy group and isopropylene oxy group; ethylene oxy group and butylene oxy group; ethylene oxy group and isobutylene oxy group. In the invention, one or more different types of polyoxyalkylene ether group-havingsurfactant may be used either singly in a composite system thereof. The amount of the surfactant to be in the developer is effectively from 1 to 30 % by weight, more preferably from 2 to 20 % by weight of the developer. If it is too small, then the developability of the developer may lower; but if too much, then the development damage will be too strong and the printing durability of the printing plate will be thereby lowered.

Polyoxyalkylene ether group-having nonionic surfactants of formula (A) are, for example, polyoxyethylene alkyl ethers such as polyoxyethylene lauryl ether, polyoxyethylene cetyl ether, polyoxyethylene stearyl ether; polyoxyethylene aryl ethers such as polyoxyethylene phenyl ether, polyoxyethylene naphthyl ether; polyoxyethylene alkylaryl ethers such as polyoxyethylene methylphenyl ether, polyoxyethylene octylphenyl ether, polyoxyethylene nonylphenyl ether.

One or more of these surfactants may be used herein either singly or as combined. The amount of the surfactant that may be in the developer is preferably from 0.1 to 20 % by weight in terms of the active ingredient thereof.

Though not specifically defined, the pH of the developer for use in processing the photosensitive lithographic printing plate of the invention is preferably from 11.0 to 12.7, more preferably from 11.5 to 12.5. When the pH value is at least 11.0, it enables safe image formation; and when at most 12.7, it causes neither overdevelopment nor damage to the exposed area of the printing plate.

Preferably, the electroconductivity of the developer is from 3 to 30 mS/cm. When the electroconductivity is at least 3 mS/cm, it ensures the dissolution of the photopolymerizing photosensitive layer on the surface of the aluminium support and is therefore free from a problem of stains in prints; and when at most 30 mS/cm, then the salt concentration in the developer is not too high and therefore the dissolution speed of the photopolymerizing photosensitive layer is not too much lowered, and, as a result, no film remains in the non-exposed area of the printing plate. More preferably, the electroconductivity of the developer is from 5 to 20 mS/cm.

More preferably, the developer for use in processing the photosensitive lithographic printing plate of the invention contains a nonionic compound of the following formula (B), and has a pH of from 11.5 to 12.8 and an electroconductivity of from 3 to 30 mS/cm.

$$A\text{-}W \qquad (B)$$

wherein A represents a hydrophobic organic group having a log P of A-H of at least 1.5; W represents a hydrophilic organic residue having a log P of W-H of smaller than 1.0. LogP is generally used as a hydrophobic property parameter, which is described in C. Hansch, A. Leo, "Substituent Constants for Correlation Analysis in Chemistry and Biology", J. Wile & Sons, 1979. LogP is determined as follows: the object molecule (A-H and W-H) is distributed in a two-layers system of octanol/water to obtain a proportion of partition between octanol layer and water layer, a balanced concentration ratio P is calculated from said proportion, and logP is defined as a logarithmic value of said balanced concentration ratio P.

(Exposure and Development)

The photosensitive lithographic printing plate of the invention is imagewise exposed to known conventional active rays of, for example, carbon arc lamp, high-pressure mercury lamp, xenon lamp, metal halide lamp, fluorescent lamp, tungsten lamp, halogen lamp, helium-cadmium laser, argon ion laser, FD-YAGlaser, helium-neon laser, semiconductor laser (350 nm to 600 nm), and then developed, where an image is formed on the surface of the aluminium support. After imagewise exposed, the plate may be optionally heated at a temperature of from 50 to 150˚C for a period of from 1 second to 5 minutes for the purpose of enhancing the curing degree of the photopolymerizing photosensitive layer.

As so mentioned hereinabove, an oxygen-blocking overcoat layer is generally formed on the photopolymerizing photosensitive layer in the photosensitive lithographic printing plate of the invention, for which, for example, known are a method of simultaneously removing both the overcoat layer and the non-exposed area of the photopolymerizing photosensitive layer with the developer as above, and a method of first removing the overcoat layer with water or hot water and then removing the non-exposed are of the photopolymerizing photosensitive layer through development. Water and hot water to be used in the method may contain, if desired, the preservative as in JP-A 10-10754 and organic solvent as in JP-A 8-278636.

Development of the photosensitive lithographic printing plate of the invention with the above-mentioned developer may be effected in any ordinary manner at a temperature falling between 0 and 60˚C, preferably between 15 and 40˚C or so, for example, by dipping the exposed, photosensitive lithographic printing plate in the developer and rubbing it with a brush or the like.

In case where the development is effected in an automatic developing machine, the developer used will be fatigued in accordance with the amount of the plate processed therewith, and a replenisher or a fresh developer may be supplied to the machine for restoring the ability of the processing solution in the machine.

Thus developed, the photosensitive lithographic printing plate is post-processed with washing water, or a rinsing solution containing surfactant, or a desensitizer containing gum arabic or starch derivative. These treatments may be combined in any desired manner for post-processing the photosensitive lithographic printing plate of the invention.

Thus obtained, the printing plate of the invention may be post-exposed or burned, for example, according to the method described in JP-A 2000-89478 to thereby enhance the printing durability thereof.

The lithographic printing plate thus obtained through these treatments is set in an offset print machine and is driven to give a large number of prints.

## EXAMPLES

The invention is describedmore concretely with reference to the following Examples.

[Examples 1-6 and Comparative Examples 1 to 4]

<Formation of Support>

Aluminium sheets of JIS-A-1050 having a thickness of 0.3 mm were processed according to the process mentioned below to form supports A, B, C, D and E.

(Support A)

An aluminium sheet (JIS-A-1050) having a thickness of 0.3 mm was etched with a solution having a sodium hydroxide concentration of 30 g/liter and an aluminium ion concentration of 10 g/liter, at 60˚C for 10 seconds, then washed with running water, neutralized with nitric acid (12 g/liter) and then again washed with water. This was electrolytically surface-roughened with 50 Hz sine wave alternating current applied thereto in a processing solution having a hydrochloric acid concentration of 15 g/liter and an aluminium ion concentration of 10 g/liter, at 30˚C. The current density was 16 A/dm$^2$, and the quantity of electricity was 400 C/dm$^2$. This was then washed with water. Next, this was etched with a solution having a sodium hydroxide concentration of 36 g/liter and an aluminium ion concentration of 10 g/liter, at 35˚C for 10 minutes, then washed with running water, then desmutted in an aqueous sulfuric acid solution having a

sulfuric acid concentration of 15 % by weight, at 30˚C for 10 seconds, and again washed with water. Further, this was subjected to anodic oxidation in an aqueous 10 % sulfuric acid solution at 20˚C. The current density was 6 $A/dm^2$, and the condition for the anodic oxidation was so controlled that the amount of the oxide film formed on it could be 2.5 $g/m^2$. The surface roughness of the sheet was Ra = 0.44 μm.

(Support B)

Support B was formed in the same manner as that for support A, for which, however, the current density in the electrolytic surface-roughening was 12 $A/dm^2$ and the quantity of electricity therein was 300 $C/dm^2$. Its surface roughness was Ra = 0.34 μm.

(Support C)

Support C was formed in the same manner as that for support A, for which, however, the current density in the electrolytic surface-roughening was 24 $A/dm^2$ and the quantity of electricity therein was 600 $C/dm^2$. Its surface roughness was Ra = 0.34 μm.

(Support D)

Support D was formed in the same manner as that for support A, for which, however, the liquid temperature in etching with sodium hydroxide after the electrolytic surface-roughening treatment was 30˚C.

(Support E)

Support E was formed in the same manner as that for support A, for which, however, the liquid temperature in etching with sodium hydroxide after the electrolytic surface-roughening treatment was 45˚C.

(Support F)

Support A was dipped in an aqueous solution of 1 % by weight of #3 sodium silicate at 20˚C for 10 seconds. This is alkali metal silicate treatment (silicate treatment). Next, this was washed by spraying it with tap water. The silicate deposition was 3.5 $mg/m^2$.

(Support G)

Support G was formed in the same manner as that for support A, for which, however, the liquid temperature in etching with sodium hydroxide after the electrolytic surface-roughening treatment was 60˚C.

(Support H)

Support H was formed according to the steps (a) to (f) in that order.

(a) Mechanical surface-roughening:

Using rotary nylon brush rollers, the surface of the aluminium sheet was mechanically roughed while an abrasive slurry prepared by suspending an abrasive (silica sand) having a specific gravity of 1.12 in water was applied thereto. The abrasive had a mean grain size of 8 μm and a maximum grain size of 50 μm. The nylon brushes were made of 6, 10-nylon, the length of each nylon hair was 50 mm, and the diameter thereof was 0.3 mm. The nylon hairs were densely planted in many holes formed in a stainless cylinder of 300 mmϕ to construct the nylon brushes. Three such rotary nylon brush rollers were used. Two support rollers (200 mmϕ) were disposed below the brush rollers, spaced from them by 300 mm. The brush rollers were pressed against the aluminium sheet to such a degree that the load of the power motor to drive the brush rollers increased by 7 kW over the load thereof to the brush rollers not kept in contact with the aluminium sheet. The direction of the brush rotation was the same as the traveling direction of the aluminium sheet. The number of brush revolutions was 200 rpm.

(b) Etching with alkali:

Thus mechanically roughened, the aluminium sheet was etched by spraying it with an aqueous NaOH solution

(having a sodium hydroxide concentration of 26 % by weight and an aluminium ion concentration of 6.5 % by weight) at 70˚C. The aluminium sheet was etched to a degree of 6 g/$m^2$. Then, this was washed with a spray of tap water.

(c) Desmutting:

Thus etched, the aluminium sheet was desmutted by spraying it with an aqueous 1 weight % nitric acid solution (containing 0.5 % by weight of aluminium ions) at 30˚C, and then washed with a spray of water.

(d) Electrochemical surface-roughening:

This was electrolytically surface-roughened with 50 Hz sine wave alternating current applied thereto in a solution having a hydrochloric acid concentration of 15 g/liter, a sulfate ion concentration of 3000 ppm and an aluminium ion concentration of 10 g/liter, at 30˚C. The current density was 16 A/$dm^2$, and the quantity of electricity was 400 C/$dm^2$. This was then washed with water.

(e) Etching with alkali:

Next, this was etched with a solution having a sodium hydroxide concentration of 35 g/liter and an aluminium ion concentration of 10 g/liter, at 35˚C for 10 minutes, then washed with running water, then desmutted in an aqueous sulfuric acid solution having a sulfuric acid concentration of 15 % by weight, at 30˚C for 10 seconds, and again washed with water.

(f) Anodic oxidation:

Thus etched, this was subjected to anodic oxidation in an aqueous 10 % sulfuric acid solution at 20˚C. The current density was 6 A/$dm^2$, and the condition for the anodic oxidation was so controlled that the amount of the oxide film formed on it could be 2.5 g/$m^2$. The surface roughness of the sheet was Ra = 0.46 μm.

(Support I)

(a) Mechanical surface-roughening:

Using rotary nylon brush rollers, the surface of the aluminium sheet was mechanically roughed while an abrasive slurry prepared by suspending an abrasive (pumice) having a specific gravity of 1.12 in water was applied thereto. The abrasive had a mean grain size of 50 μm and a maximum grain size of 150 μm. The nylon brushes were made of 6,10-nylon, the length of each nylon hair was 50 mm, and the diameter thereof was 0.3 mm. The nylon hairs were densely planted in many holes formed in a stainless cylinder of 300 mmϕ to construct the nylon brushes. Three such rotary nylon brush rollers were used. Two support rollers (200 mmϕ) were disposed below the brush rollers, spaced from them by 300 mm. The brush rollers were pressed against the aluminium sheet to such a degree that the load of the power motor to drive the brush rollers increased by 7 kW over the load thereof to the brush rollers not kept in contact with the aluminium sheet. The direction of the brush rotation was the same as the traveling direction of the aluminium sheet. The number of brush revolutions was 200 rpm.

(b) Etching with alkali:

Thus mechanically roughened, the aluminium sheet was etched by spraying it with an aqueous NaOH solution (having a sodium hydroxide concentration of 26 % by weight and an aluminium ion concentration of 6.5 % by weight) at 70˚C. The aluminium sheet was etched to a degree of 8 g/$m^2$. Then, this was washed with a spray of tap water.

(c) Desmutting:

Thus etched, the aluminium sheet was desmutted by spraying it with an aqueous 1 weight % nitric acid solution (containing 0.5 % by weight of aluminium ions) at 30˚C, and then washed with a spray of water.

(d) Electrochemical surface-roughening:

With 60 Hz AC voltage applied thereto, this was subjected to continuous electrochemical surface-roughening treatment. The electrolytic solution used was an aqueous nitric acid (10.5 g/liter) solution (with 5 g/liter of aluminium

ions therein), and its temperature was 50˚C. The AC power wave was a trapezoidal rectangular wave of such that the time, tp, for which the current rises from 0 (zero) to the peak is 0.8 msec and the duty ratio is 1/1. The counter electrode was formed of carbon. The auxiliary electrode was formed of ferrite. The electrolytic cell was a radial type cell.

The current density was 30 A/$dm^2$ in terms of its peak value, and the quantity of electricity was 220 C/$dm^2$ in terms of the sum total in anodic reaction on the aluminium sheet. 5 % of the current from the power was divided into the auxiliary electrodes.

Thus roughened, this was washed with a spray of tap water.

(e) Etching with alkali:

Next, the aluminium sheet was etched with a spray having a sodium hydroxide concentration of 26 % by weight and an aluminium ion concentration of 5 % by weight, at 60˚C. The degree of etching was 1.0 g/$m^2$, and the smut component of essentially aluminium hydroxide that had been formed in the previous step of electrochemical surface-roughening was thereby removed from the aluminium sheet, and the edges of the pits formed in the previous step were rounded. Next, the aluminium sheet was washed with a spray of tap water.

(f) Desmutting:

The aluminium sheet was then desmutted with a spray of an aqueous 15 weight % sulfuric acid solution (with 4.5 % by weight of aluminium ions therein) at 30˚C, and then washed with a spray of tap water. The aqueous nitric acid solution used in the previous desmutting treatment was a waste in the electrochemical surface-roughening treatment with AC in an aqueous nitric acid solution.

(g) Anodic oxidation:

This was subjected to anodic oxidation in an aqueous 10 % sulfuric acid solution at 20˚C. The current density was 6 A/$dm^2$, and the condition for the anodic oxidation was so controlled that the amount of the oxide film formed on it could be 2.5 g/$m^2$. The surface roughness of the sheet was Ra = 0.55 μm.

(Support J)

Support J was formed in the same manner as that for support I, for which, however, the aluminium sheet was not subjected to the mechanical surface-roughening treatment (a), and the etching temperature in the step (e) was 32˚C and the degree of etching was 0.2 g/$m^2$.

<Formation of subbing layer, photosensitive layer, and overcoat layer>

A solution prepared by dissolving methyl methacrylate/ethyl acrylate/sodium 2-acrylamido-2-methylpropanesulfonate copolymer (60/25/15 by mol, molecular weight Mn = 30,000) in water/methanol (5 g/95 g) was applied to each support processed in the manner as above, and dried at 80˚C for 30 seconds. The thickness of the thus-formed subbing layer was 3mg/$m^2$. Ahigh-sensitivityphotopolymerizing composition P-1 mentioned below was applied to it so that the dry amount of the coating layer could be 1.5 g/$m^2$. This was dried at 100˚C for 1 minute, and a photosensitive layer was thus formed thereon.

(Photopolymerizing Composition P-1)

| | |
|---|---|
| Ethylenic unsaturated bond-having compound (A1) | 1.5 parts by weight |
| Linear organic polymer (polymer binder) (B1) | 2.0 parts by weight |
| Sensitizer (C1) | 0.15 parts by weight |
| Photopolymerization initiator (D1) | 0.2 parts by weight |
| ε-phthalocyanine (F1) dispersion | 0.02 parts by weight |
| Fluorine-containing nonionic surfactant, Megafac F177 (by Dai-Nippon Ink & Chemicals) | 0.03 parts by weight |
| Methyl ethyl ketone | 9.0 parts by weight |
| Propylene glycol monomethyl ether acetate | 7.5 parts by weight |
| Toluene | 11.0 parts by weight |

A1

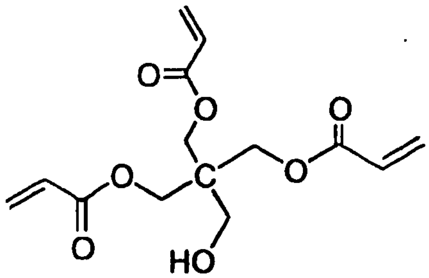

B1

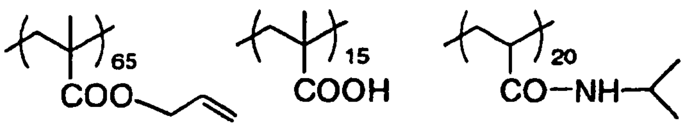

Mw: 150,000

C1

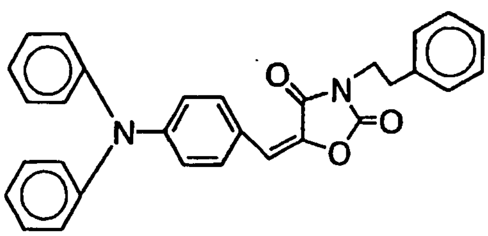

D1

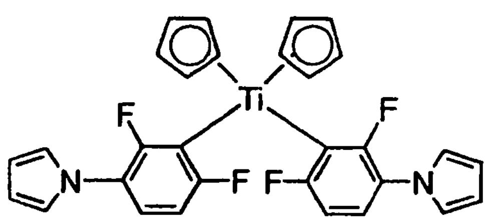

F1

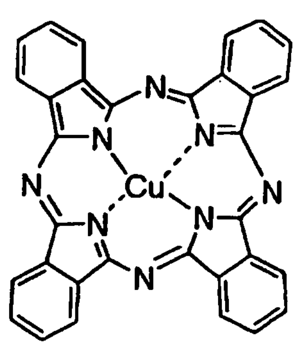

An aqueous solution of 3 weight % polyvinyl alcohol (degree of saponification 98 mol%, degree of polymerization 500) was applied to the photosensitive layer so that its dry weight could be 2.5 g/m[2] and dried at 120˚C for 3 minutes. The process gave a photosensitive lithographic printing plate.

[Reference Example 1]

A photosensitive lithographic printing plate was fabricated in the same manner as in Example 1, for which, however, the polymer binder B2 mentioned below was used in place of the polymer binder B1 in the photosensitive layer.

B2

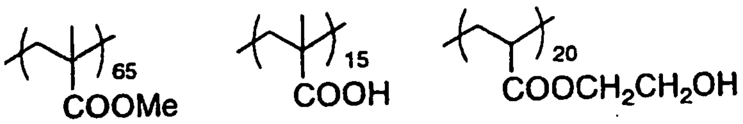

Mw: 150,000

(1) Mean opening diameter of large pit structure:

With SEM, a picture (× 1000) of the top view of each support was taken. On the SEM picture, 50 large closed-cell pits were extracted, and their diameter was read. This is an opening diameter. The data were averaged to give a mean opening diameter.

(2) Mean opening diameter of small pit structure:

With high-resolution SEM, a picture (× 50000) of the top view of each support was taken. On the SEM picture, 50 small wave-structured pits (small wave pits) were extracted, and their diameter was read. This is an opening diameter. The data were averaged to give a mean opening diameter.

(3) Mean ratio of depth to opening diameter of small pit structure:

The mean ratio of the depth to the opening diameter of the small wave structure was determined as follows: With high-resolution SEM, a picture (× 50000) of the cross-sectional view of each support was taken. On the SEM picture, 20 small wave pits of not larger than 8 μm in diameter were extracted, and their opening diameter and depth were read. Their ratio was computed, and the data were averaged to give a mean ratio.

(4) Surface roughness:

Using a profilometer (Sufcom 575 by Tokyo Precision Instruments), each support was analyzed for the two-dimensional surface roughness thereof. The mean surface roughness Ra defined in ISO4287 of each support was measured 5 times, and the data were averaged. The mean value indicates the surface roughness of the support analyzed. The condition for the measurement of two-dimensional surface roughness is mentioned below.

Cut off: 0.8
Inclination correction: Flat ML
Length: 3 mm
MD magnification: 10000 times
Scanning speed: 0.3 mm/s
Probe tip diameter: 2 μm

(5) Surface area ΔS:

ΔS of the surface of the support obtained in the above for lithographic printing plates was measured in the manner mentioned below. The result is given in Table 4.

With an atomic force microscope (SP 13700 by Seiko Electronics), the support was analyzed for the surface profile thereof and its three-dimensional data were obtained.

Concretely, a sample of 1 $cm^2$ in size is cut out of the support, and set on a horizontal sample stand put on a piezo-scanner. A cantilever is made to approach the sample surface, and when it has reached a region that may receive interatomic force, the sample is scanned in the X-Y directions whereupon the surface roughness of the sample is detected as the piezo-displacement thereof in the Z direction. The piezo-scanner is scannable for 150 μm in the X-Y directions and for 10 μm in the Z direction. The cantilever has a resonance frequency of from 120 to 150 kHz and a spring constant of from 12 to 20 N/m (SI-DF20 by Nanoprobe), and it is driven in DFM (dynamic force mode). Thus obtained, the three-dimensional data are processed for least square approximation to correct any slight inclination of the sample so as to determine the standard face thereof.

512 × 512 points of the surface of 50 $\mu m^2$ each are measured. The resolution in the X-Y directions is 1.9 μm, and that in the Z direction is 1 nm, and the scanning speed is 60 μm/s.

Using the three-dimensional data (f(x, y)) obtained as in the above, the neighboring three points are extracted, and the sum total of the area of the small triangles that are formed by the three points is obtained. This is the actual surface area Sx. The surface area ratio ΔS is obtained according to the following formula that includes the thus-measured actual surface area Sx and the geometrically-measured surface area So:

$$\Delta S = (Sx - So)/So \times 100\ (\%).$$

So is obtained as So = Lx × Ly. Lx and Ly each indicate the length of the side in the x direction and the y direction, respectively, in the measurement region (rectangle). In the invention, Lx = Ly = 50 μm.

(6) Measurement of Si amount:

The Si deposition on the support was measured in terms of the amount of the Si atom in a sample ($mg/m^2$), according to a calibration curve method using a fluorescent X-ray analyzer. Concretely, a fluorescent X-ray analyzer, Rigaku Denki's RIX 3000 was used, and the amount of the Si atom in a sample of the support was determined from the peak height of the Si-Kα spectral pattern of the sample under the condition mentioned below.

Device: Rigaku Denki Kogyo's RIX 3000
X-ray bulb: Rh
Spectrum for measurement: Si-Kα
Bulb voltage: 50 kV
Bulb current: 50 mA
Slit: Coarse
Analyzing crystal: RX4
Detector: F-PC
Area for analysis: 30 mmϕ
Peak position (2 θ): 144.7d deg.
Background (2 θ): 140.70 deg., 146.85 deg.
Total time: 80 s/sample

(7) Sensitivity:

Using a Fuji Photo Film's imager, Vx9600 CTP, the photosensitive lithographic printing plate was imagewise exposed to a varying degree of from 0.01 to 0.2 $mJ/cm^2$.

Next, using a Fuji Photo Film's processor PS Processor LP-850 PII filled with an alkali developer having the composition mentioned below, this was developed at 30˚C for 20 seconds. The quantity of light for exposure enough to give good images of good image density was derived from the data of the processed samples, and it indicates the sensitivity of the samples. Samples for which the necessary exposure amount is smaller have a higher sensitivity. The wavelength of the exposure source was 405 nm. The result is given in Table 4.

(Composition of Alkali Developer)

| | |
|---|---|
| Potassium hydroxide | 0.15 g |

(continued)

| | |
|---|---|
| Polyoxyethylene naphthyl ether (n = 13) | 5.0 g |
| Chlest 400 (chelating agent) | 0.1 g |
| Water | 94.75 g |

(8) Printing Durability:

Using a Fuji Photo Film's imager, Vx9600 CTP, the photosensitive lithographic printing plate was imagewise exposed to a degree of 0.05 mJ/$cm^2$.

Next, using a Fuji Photo Film's processor PS Processor LP-850 PII filled with the alkali developer mentioned above, this was developed at 30˚C for 20 seconds. Thus obtained, the lithographic printing plate was set in a Lithrone printer (by Komori Corp.) with black Indian ink, Dai-Nippon Ink & Chemicals' DIC-GEOS (N) therein, and the printer was driven to give prints. The number of the prints on which the solid image became thin in visual observation was counted, and it indicates the printing durability of the printing plate tested. The result is given in Table 4.

(9) Printing Durability after burning:

Developed in the same manner as in the above (8), the lithographic printing plate was wiped with a burning conditioner, Fuji Photo Film's BC-3, and then burned at about 240˚C for 7 minutes. Next, this was washed with water and then post-processed with Fuji Photo Film's Gum GU-7 diluted 2-fold by volume with water.

In the same manner as in the above (8), the lithographic printing plate was set in a Lithrone printer (by Komori Corp.) with black Indian ink, Dai-Nippon Ink & Chemicals' DIC-GEOS (N) therein, and the printer was driven to give prints. The number of the prints on which the solid image became thin in visual observation was counted, and it indicates the printing durability after burning of the printing plate tested. The result is given in Table 4.

The lithographic printing plates obtained in the above were evaluated for their staining resistance and easy visibility when dampened with water, according to the methods mentioned below.

(10) Staining resistance:

The printing plate was set in a Mitsubishi Dia-type F2 printer (by Mitsubishi Heavy Industries) with scarlet ink DIC-GEOS(s) therein, and the printer was driven to give prints. After 10000 prints were given, the blanket was visually checked for dirt.

The result is given in Table 4. The staining resistance of the printing plate was evaluated from the degree of the dirt on the blanket. Concretely, the blanket was visually checked for dirt, and the samples were grouped into three ranks, A, B and C. A is the best in point of the staining resistance. That is, A indicates none of the dirt on the blanket, B indicates a small amount of the dirt on the blanket, C indicates a large amount of the dirt on the blancket.

(11) Easy visibility when dampened with water:

The printing plate was set in a Lithrone printer (by Komori Corp.), and the printer was driven while the amount of the dampening water applied to the printing plate was increased. The condition of the non-image area of the printing plate was visually observed, and the amount of the dampening water with which the non-image area of the printing plate became bright was determined. The plate inspection (easy visibility when dampened with water) was evaluated from the amount of the dampening water applied to the printing plate before the plate appeared bright. The samples were grouped into three ranks, A, B and C. For A, Bright appearance doesn't occur in at least the midium-amount of the dampening water, and for B, the amount of the dampening water needed for bright appearance is from small-amount to midium-amount. For C, that is small amount.

Table 4

| | Support | Large Pits µm | Small Pits µm | Ratio of depth to diameter of small pits | Surface Area Difference Δs | Si Deposition mg/m$^2$ | Polymer Binder | Sensitivity mJ/cm$^2$ | Printing Durability | Printing Durability after burning | Staining Resistance | Easy Visibility when dampened with water |
|---|---|---|---|---|---|---|---|---|---|---|---|---|
| Example 1 | A | 5 | 0.2 | 0.34 | 30 | 0 | B-1 | 0.03 | 150,000 | 250,000 | A | A |
| Example 2 | B | 2 | 0.2 | 0.34 | 27 | 0 | B-1 | 0.03 | 150,000 | 250,000 | A | A |
| Example 3 | C | 8 | 0.2 | 0.34 | 32 | 0 | B-1 | 0.03 | 150,000 | 250,000 | A | A |
| Example 4 | D | 5 | 0.1 | 0.60 | 40 | 0 | B-1 | 0.03 | 150,000 | 250,000 | A | A |
| Example 5 | E | 5 | 0.6 | 0.20 | 20 | 0 | B-1 | 0.03 | 150,000 | 250,000 | A | A |
| Example 6 | F | 5 | 0.2 | 0.34 | 20 | 3.5 | B-1 | 0.05 | 130,000 | 220,000 | A | A |
| Comp. Example 1 | G | 5 | 0.9 | 0.10 | 30 | 0 | B-1 | 0.05 | 30,000 | 60,000 | A | A |
| Comp. Example 2 | H | 12 | 0.2 | 0.34 | 30 | 0 | B-1 | 0.03 | 100,000 | 200,000 | B | A |
| Comp. Example 3 | I | 12 | 1.2 | 0.1 | 23 | 0 | B-1 | 0.04 | 150,000 | 250,000 | B | A |
| Comp. Example 4 | J | no | no | | 45 | 0 | B-1 | 0.05 | 50,000 | 50,000 | B | A |
| Ref. Example 1 | A | 5 | 0.2 | 0.34 | 30 | 0 | B-2 | 0.20 | 20,000 | 30,000 | A | C |

As is obvious from Table 4, it is understood that the printing plates of the invention are all well-balanced in point of the properties of sensitivity, printing durability, printing durability after burning, staining resistance and easy visibility when dampened with water, and give good results as compared with the comparative printing plates.

[Examples 7 to 12, and Comparative Examples 6 to 9]

<Support>

In Examples 7 to 12, the above supports A to F were used; and in Comparative Examples 6 to 9, the above supports G to J were used.

<Formation of subbing layer, photosensitive layer, and overcoat layer>

A solution prepared by dissolving methyl methacrylate/ethyl acrylate/sodium 2-acrylamido-2-methylpropanesulfonate copolymer (60/25/15 by mol, molecular weight Mn = 30,000) in water/methanol (5 g/95 g) was applied to the support, and dried at 80˚C for 30 seconds. The thickness of the thus-formed subbing layer was 3 mg/$m^2$. Ahigh-sensitivityphotopolymerizing composition P-2 mentioned below was applied to it so that the dry amount of the coating layer could be 1.5 g/$m^2$. This was dried at 100˚C for 1 minute, and a photosensitive layer was thus formed thereon.

(Photopolymerizing Composition P-2)

| | |
|---|---|
| Ethylenic unsaturated bond-having compound (A2) | 1.5 parts by weight |
| Linear organic polymer (polymer binder) (B3) | 2.0 parts by weight |
| Sensitizer (C1) | 0.15 partsby weight |
| Photopolymerization initiator (D1) | 0.2 parts by weight |
| ε-phthalocyanine (F1) dispersion | 0.02 parts by weight |
| Fluorine-containing nonionic surfactant, Megafac F177 (by Dai-Nippon Ink & Chemicals) | 0.03 parts by weight |
| Methyl ethyl ketone | 9.0 parts by weight |
| Propylene glycol monomethyl ether acetate | 7.5 parts by weight |
| Toluene | 11.0 parts by weight |

A2

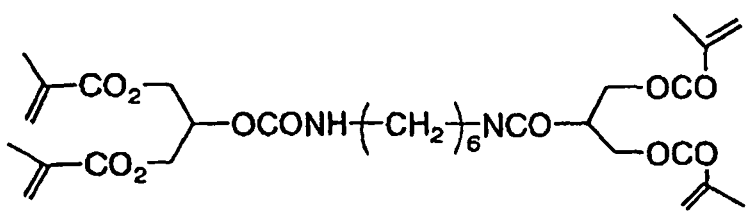

B3

Polyurethane Resin Compound (11) mentioned above weight-average molecular weight, 110,000 (measured in terms of polystyrene through GPC)

C1

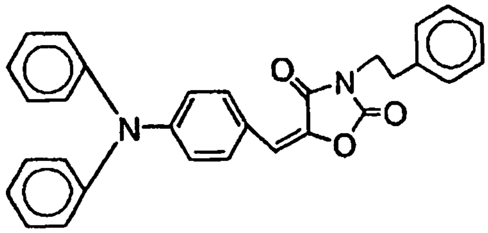

D1

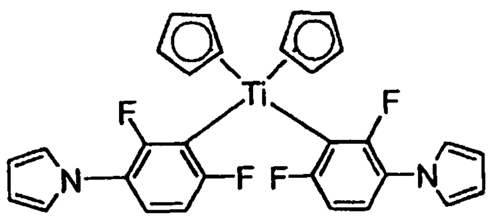

F1

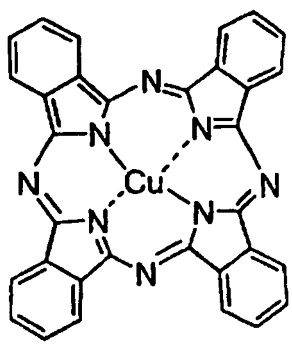

An aqueous solution of 3 weight % polyvinyl alcohol (degree of saponification 98 mol%, degree of polymerization 500) was applied to the photosensitive layer so that its dry weight could be 2.5 g/m$^2$, and dried at 120°C for 3 minutes. The process gave a photosensitive lithographic printing plate.

In that manner, photosensitive lithographic printing plates of Examples 7 to 12 and Comparative Examples 6 to 9 with supports A to J therein were fabricated.

[Examples 13 to 17, and Comparative Example 10]

Photosensitive lithographic printing plates were fabricated in the same manner as in Example 7, for which, however, the components A1, B1 and C1 of the photosensitive layer were varied to those mentioned below.

Table 5

| | Ethylenic Unsaturated Compound | Polymer Binder (polyurethane resin compound mentioned above) [weight-average molecular weight] | Sensitizing Dye |
|---|---|---|---|
| Example 13 | A1 | (4) [78,000] | C-1 |
| Example 14 | A1 | (12) [9,000] | C-1 |
| Example 15 | 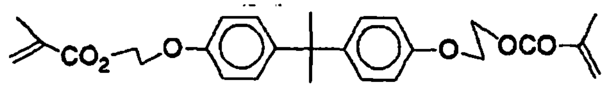 | (13) [32,000] | C-1 |
| Example 16 | A1 | (11) [110,000] | 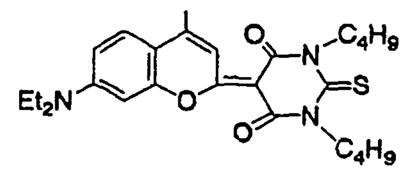 |
| Example 17 | 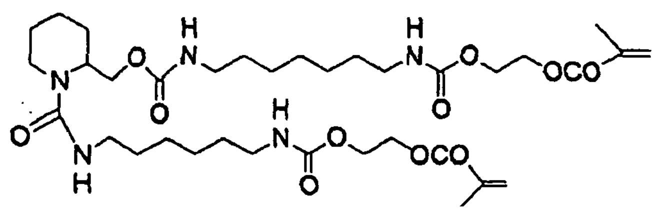 | (11) [110,000] | " |
| Comparative Example 10 | A1 | 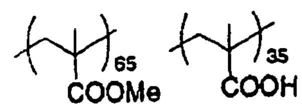 (molecular weight, 100,000) | " |
| In the Table, [weight-average molecular weight] is in terms of polystyrene, measured through GPC. | | | |

(12) Sensitivity:

Using a Fuji Photo Film's imager, Vx9600 CTP, the photosensitive lithographic printing plates of Examples 7 to 15 and Comparative Examples 6 to 9 were imagewise exposed to a varying degree of from 0.01 to 0.2 mJ/$cm^2$. Those of Examples 16 and 17 and Comparative Example 10 were imagewise exposed in the same manner but using CSI's Plate Jet 8.

Next, using a Fuji Photo Film's processor PS Processor LP-850 PII filled with the same alkali developer as that used in the previous Examples, these were developed at 30˚C for 20 seconds. The quantity of light for exposure enough to give good images of good image density was derived from the data of the processed samples, and it indicates the sensitivity of the samples. Samples for which the necessary exposure amount is smaller have a higher sensitivity. The result is given in Table 6.

(13) Printing Durability:

Using a Fuji Photo Film's imager, Vx9600 CTP, the photosensitive lithographic printing plates of Examples 7 to 15 and Comparative Examples 6 to 9 were imagewise exposed to a degree of from 0.05 mJ/$cm^2$. Those of Examples 16 and 17 and Comparative Example 10 were imagewise exposed in the same manner but using CSI's Plate Jet 8.

Next, using a Fuji Photo Film's processor PS Processor LP-850 PII filled with the same alkali developer as that used in the previous Examples, these were developed at 30˚C for 20 seconds. Thus obtained, the lithographic printing plate was set in a Lithrone printer (by Komori Corp.) with black Indian ink, Dai-Nippon Ink & Chemicals' DIC-GEOS (N) therein, and the printer was driven to give prints. The number of the prints on which the solid image became thin in visual observation was counted, and it indicates the printing durability of the printing plate tested. The result is given in Table 6.

(14) Printing Durability after burning:

Developed in the same manner as in the above (13), the lithographic printing plate was wiped with a burning conditioner, Fuji Photo Film's BC-3, and then burned at about 240˚C for 7 minutes. Next, this was washed with water and then post-processed with Fuji Photo Film's Gum GU-7 diluted 2-fold by volume with water.

In the same manner as in the above (13), the lithographic printing plate was set in a Lithrone printer (by Komori Corp.) with black Indian ink, Dai-Nippon Ink & Chemicals' DIC-GEOS (N) therein, and the printer was driven to give prints. The number of the prints on which the solid image became thin in visual observation was counted, and it indicates the printing durability after burning of the printing plate tested. The result is given in Table 6.

The lithographic printing plates obtained in the above were evaluated for their staining resistance and easy visibility when dampened with water, according to the methods mentioned below.

(15) Staining resistance:

The printing plate was set in a Mitsubishi Dia-type F2 printer (by Mitsubishi Heavy Industries) with scarlet ink DIC-GEOS(s) therein, and the printer was driven to give prints. After 10000 prints were given, the blanket was visually checked for dirt.

The result is given in Table 6. The staining resistance of the printing plate was evaluated from the degree of the dirt on the blanket. Concretely, the blanket was visually checked for dirt, and the samples were grouped into three ranks, A, B and C. A is the best in point of the staining resistance.

(16) Easy visibility when dampened with water:

The printing plate was set in a Lithrone printer (by Komori Corp.), and the printer was driven while the amount of the dampening water applied to the printing plate was increased. The condition of the non-image area of the printing plate was visually observed, and the amount of the dampening water with which the non-image area of the printing plate became bright was determined. The plate inspection (easy visibility when dampened with water) was evaluated from the amount of the dampening water applied to the printing plate before the plate appeared bright. The samples were grouped into three ranks, A, B and C. For A, the amount of the dampening water needed for bright appearance is the largest.

Table 6

| | Support | Large Pits µm | Small Pits µm | Ratio of depth to diameter of small pits | Surface Area Difference As | Sensitivity $mJ/cm^2$ | Printing Durability | Printing Durability after burning | Staining Resistance | Easy Visibility when dampened with water |
|---|---|---|---|---|---|---|---|---|---|---|
| Example 7 | A | 5 | 0.2 | 0.34 | 30 | 0.05 | 300,000 | 500,000 | A | A |
| Example 8 | B | 2 | 0.2 | 0.34 | 27 | 0.05 | 300,000 | 500,000 | A | A |
| Example 9 | C | 8 | 0.2 | 0.34 | 32 | 0.05 | 300,000 | 500,000 | A | A |
| Example 10 | D | 5 | 0.1 | 0.60 | 40 | 0.05 | 330,000 | 550,000 | A | A |
| Example 11 | E | 5 | 0.6 | 0.20 | 20 | 0.05 | 300,000 | 500,000 | A | A |
| Example 12 | F | 5 | 0.2 | 0.34 | 20 | 0.08 | 270,000 | 450,000 | A | A |
| Example 13 | A | 5 | 0.2 | 0.34 | 30 | 0.05 | 300,000 | 500,000 | A | A |
| Example 14 | A | 5 | 0.2 | 0.34 | 30 | 0.06 | 300,000 | 500,000 | A | A |
| Example 15 | A | 5 | 0.2 | 0.34 | 30 | 0.05 | 270,000 | 450,000 | A | A |
| Example 16 | A | 5 | 0.2 | 0.34 | 30 | 0.10 | 300,000 | 500,000 | A | A |
| Example 17 | A | 5 | 0.2 | 0.34 | 30 | 0.10 | 300,000 | 500,000 | A | A |
| Comp. Example 6 | G | 5 | 0.9 | 0.10 | 30 | 0.08 | 50,000 | 80,000 | A | A |
| Comp. Example 7 | H | 12 | 0.2 | 0.34 | 30 | 0.05 | 150,000 | 300,000 | B | A |
| Comp. | I | 12 | 1.2 | 0.1 | 23 | 0.08 | 300,000 | 500,000 | B | A |
| Example 8 | | | | | | | | | | |
| Comp. Example 9 | J | no | no | | 45 | 0.10 | 50,000 | 60,000 | B | A |
| Comp. Example 10 | A | 5 | 0.2 | 0.34 | 30 | 0.20 | 30,000 | 50,000 | A | C |

As is obvious from Table 6, it is understood that the printing plates of the invention are all well-balanced in point of the properties of sensitivity, printing durability, printing durability after burning, staining resistance and easy visibility when dampened with water, and give good results as compared with the comparative printing plates.

[Examples 18 to 23, and Comparative Examples 11 to 14]

<Support>

In Examples 18 to 23, the above supports A to F were used; and in Comparative Examples 11 to 14, the above supports G to J were used.

<Formation of subbing layer, photosensitive layer, and overcoat layer>

A solution prepared by dissolving methyl methacrylate/ethyl acrylate/sodium 2-acrylamido-2-methylpropanesulfonate copolymer (60/25/15 by mol, molecular weight Mn = 30,000) in water/methanol (5 g/95 g) was applied to the support, and dried at 80˚C for 30 seconds. The thickness of the thus-formed subbing layer was 3 mg/$m^2$. A high-sensitivity photopolymerizing composition P-3 mentioned below was applied to it so that the dry amount of the coating layer could be 1.5 g/$m^2$. This was dried at 100˚C for 1 minute, and a photosensitive layer was thus formed thereon.

(Photopolymerizing Composition P-3)

| | |
|---|---|
| Ethylenic unsaturated bond-having compound (A1) | 1.5 parts by weight |
| Linear organic polymer (polymer binder) (B1) | 2.0 parts by weight |
| Sensitizer (C2) | 0.15 parts by weight |
| Photopolymerization initiator (D1) | 0.2 parts by weight |
| ε-phthalocyanine (F1) dispersion | 0.02 parts by weight |
| Fluorine-containing nonionic surfactant, Megafac F177 (by Dai-Nippon Ink & Chemicals) | 0.03 parts by weight |
| Methyl ethyl ketone | 9.0 parts by weight |
| Propylene glycol monomethyl ether acetate | 7.5 parts by weight |
| Toluene | 11.0 parts by weight |

A1

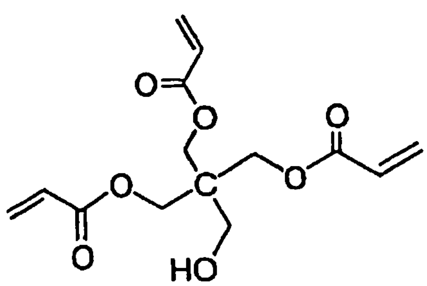

B1

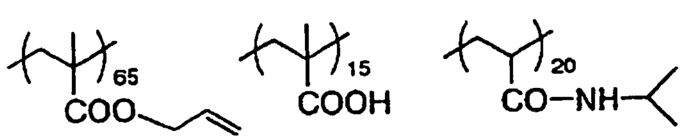

Mw: 150,000

C2

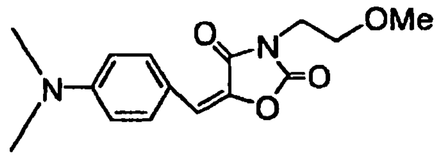

D1

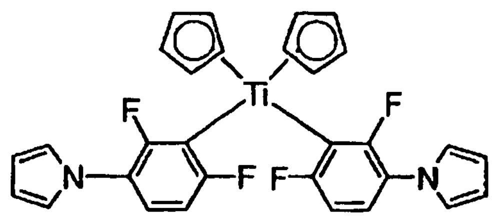

F1

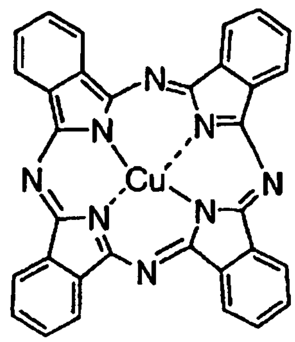

An aqueous solution of 3 weight % polyvinyl alcohol (degree of saponification 98 mol%, degree of polymerization 500) was applied to the photosensitive layer so that its dry weight could be 2.5 g/$m^2$, and dried at 120˚C for 3 minutes. The process gave a photosensitive lithographic printing plate.
In that manner, photosensitive lithographic printing plates of Examples 18 to 23 and Comparative Examples 11 to 14 with supports A to J therein were fabricated.

[Examples 24 to 27]

Photosensitive lithographic printing plates were fabricated in the same manner as in Example 18, for which, however, the components A1, B1 and C1 of the photosensitive layer were varied to those mentioned below.

Table 7

| Example | Ethylenic Unsaturated Compound | Polymer Binder | Sensitizing Dye |
|---|---|---|---|
| 24 | AI | B1 | 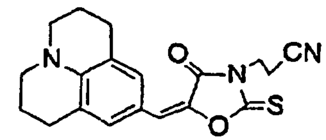 |
| 25 | 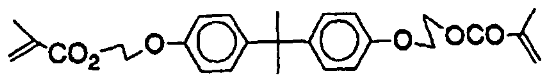 | B1 | 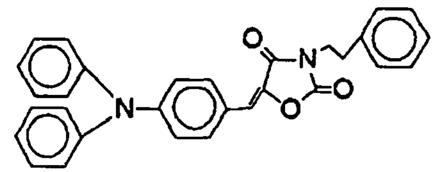 |
| 26 | 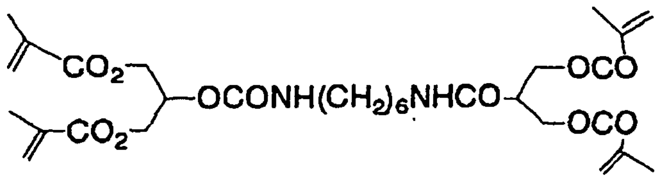 | polyurethane resin compound formed of the following components | 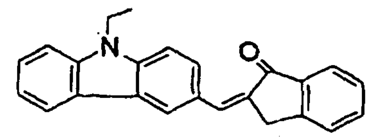 |
| 27 | 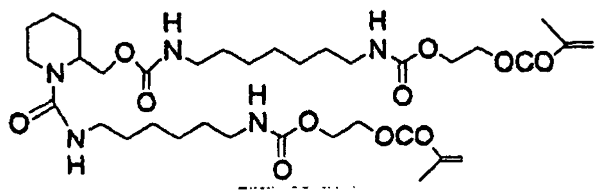 | B1 | 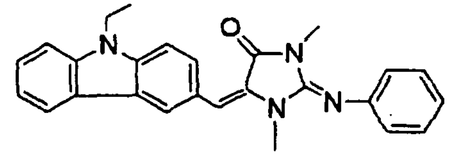 |

Composition of the polyurethane resin compound for Example 26:

| | (mol%) |
|---|---|
| 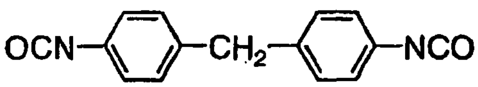 | 40 |
| 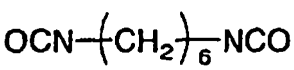 | 10 |
| 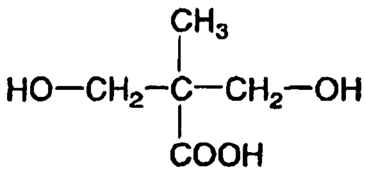 | 40 |
| Polyethylene glycol with number-average molecular weight of 300 and with log P of -1.60 | 5 |
| 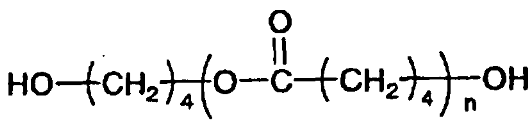 | 5 |

(number-average molecular weight, 2000; hydroxyl value, 56 mg KOH/g; log P, 7.49)

The acid value of the polyurethane resin compound is 1.40 meq/g; and the weight-average molecular weight (in terms of polystyrene measured through GPC) thereof is 110,000.

[Comparative Examples 15 and 16]

Photosensitive lithographic printing plates were fabricated in the same manner as in Example 18, for which, however, the amount of the sensitizing dye was varied to 0.05 parts by weight or 5 parts by weight.

[Comparative Examples 17 and 18]

Photosensitive lithographic printing plates were fabricated in the same manner as in Example 18, for which, however, the coating mount of the photosensitive layer was varied to 0.4 $g/m^2$ and 2.2 $g/m^2$.

Thus fabricated, the photosensitive lithographic printing plates were exposed, developed and evaluated in the same manner as in Examples 1 to 6 and Comparative Examples 1 to 6.

The lateral fog in the solid image area was evaluated as follows:

(17) Lateral fog in solid image area:

The solid image of square having a length each of at least 5 cm was produced, after that, visual observation of the fog generated between solid image area and non-image area was carried out. The samples were grouped into three ranks, A, B and C. For A, the lateral fog in solid image area is not generated at all. For B, it is generated in a small amount. For C, it is obviously distinct as the fog.

The result is given in Table 8.

Table 8

| | Support | Large Pits µm | Small Pits µm | Surface Area Difference Δs | Optical Density (note) | Coating Amount of Photosensitive Layer $g/m^2$ | Sensitivity $mJ/cm^2$ | Printing Durability (x 10, 000) | Staining Resistance | Easy Visibility when dampened with water | Lateral Fog in solid image area |
|---|---|---|---|---|---|---|---|---|---|---|---|
| Example 18 | A | 5 | 0.2 | 0.34 | 0.5 | 1.5 | 0.06 | 20 | A | A | A |
| Example 19 | B | 2 | 0.2 | 0.34 | 0.5 | 1.5 | 0.06 | 20 | A | A | A |
| Example 20 | C | 8 | 0.2 | 0.34 | 0.5 | 1.5 | 0.06 | 18 | A | A | A |
| Example 21 | D | 5 | 0.1 | 0.60 | 0.5 | 1.5 | 0.06 | 20 | A | A | A |
| Example 22 | E | 5 | 0.6 | 0.20 | 0.5 | 1.5 | 0.06 | 18 | A | A | A |
| Example 23 | F | 5 | 0.2 | 0.34 | 0.5 | 1.5 | 0.06 | 17 | A | A | A |
| Example 24 | A | 5 | 0.2 | 0.34 | 0.45 | 1.5 | 0.05 | 18 | A | A | A |
| Example 25 | A | 5 | 0.2 | 0.34 | 0.5 | 1.5 | 0.07 | 17 | A | A | A |
| Example 26 | A | 5 | 0.2 | 0.34 | 0.55 | 1.5 | 0.07 | 18 | A | A | A |
| Example 27 | A | 5 | 0.2 | 0.34 | 0.5 | 1.5 | 0.08 | 19 | A | A | A |
| Comp. Example 11 | G | 5 | 0.9 | 0.10 | 0.5 | 1.5 | 0.12 | 4 | A | A | A |
| Comp. Example 12 | H | 12 | 0.2 | 0.34 | 0.5 | 1.5 | 0.05 | 10 | B | A | A |

(continued)

| | Support | Large Pits μm | Small Pits μm | Surface Area Difference Δs | Optical Density (note) | Coating Amount of Photosensitive Layer g/m$^2$ | Sensitivity mJ/cm$^2$ | Printing Durability (x 10, 000) | Staining Resistance | Easy Visibility when dampened with water | Lateral Fog in solid image area |
|---|---|---|---|---|---|---|---|---|---|---|---|
| Comp. Example 13 | I | 12 | 1.2 | 0.1 | 0.5 | 1.5 | 0.10 | 20 | B | A | A |
| comp. Example 14 | J | no . | no | | 0.5 | 1.5 | 0.15 | 5 | B | A | A |
| Comp. Example 15 | A | 5 | 0.2 | 0.34 | 0.15 | 1.5 | 0.06 | 20 | A | A | C |
| Comp. Example 16 | A | 5 | 0.2 | 0.34 | 1.5 | 1.5 | 0.20 | 5 | A | A | A |
| comp. Example 17 | A | 5 | 0.2 | 0.34 | 0.1 | 0.4 | 0.10 | 7 | A | A | C |
| comp. Example 18 | A | 5 | 0.2 | 0.34 | 0.7 | 2.2 | 0.20 | 4 | A | A | A |

(note) This is the optical density of the sensitizing dye in the photopolymerization layer.

As is obvious from Table 8, it is understood that the printing plates of the invention all have a broad latitude for exposure and are well-balanced in point of the properties of sensitivity, printing durability, printing durability after burning, staining resistance and easy visibility when dampened with water, and give good results as compared with the comparative printing plates.

This application is based on Japanese Patent application: JP 2003-029879, filed February 6, 2003; JP 2003-029880, filed February 6, 2003; and JP 2003-029881, filed February 6, 2003.

## Claims

**1.** A photosensitive lithographic printing plate comprising:

a support prepared by an electrochemically surface-roughening treatment on an aluminium or aluminium alloy sheet with an aqueous solution that contains at least hydrochloric acid and by an anodic oxidation treatment; and
a photopolymerization layer comprising an addition-polymerizable ethylenic unsaturated compound, a photopolymerization initiator, and a polymer binder,

wherein the support has a double structure of large and small pits, the large pits have a mean opening diameter of 2 to 10 μm, the small pits have a mean opening diameter of 0.1 to 0.8 μm, the small pits have a ratio of a diameter to a depth of 1:0.2 to 1:0.6, a surface area ΔS represented by the following formula is at most 40, and the polymer binder in the photopolymerization layer is at least one of organic polymer compounds that have an amido group of the following formula (M1) in a side branches thereof and polyurethane resins produced from compounds (i) at least one diisocyanate compound, (ii) at least one diol compound having at least one carboxyl group, (iii) at least one diol compound having a value log P of smaller than 0, and (iv) at least one diol compound having a value log P of larger than 0, provided that the compounds (iii) and (iv) are not carboxyl group-having diol compounds:

$$\Delta S = (Sx - So)/So \times 100\ \%$$

wherein Sx indicates an actual surface area of the support obtained by measuring 512 × 512 points of 50 $\mu m^2$, and So indicates a geometrically-measured surface area thereof;

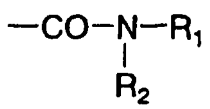

(M1)

wherein $R_1$ and $R_2$ each independently represent a hydrogen atom, an alkyl group, an alkenyl group, an alkynyl group, an aryl group, a heterocyclic group or a substituted sulfonyl group, and $R_1$ and $R_2$ may bond to each other to form a cyclic structure.

**2.** A photosensitive lithographic printing plate comprising:

a support prepared by an electrochemically surface-roughening treatment on an aluminium or aluminium alloy sheet with an aqueous solution that contains at least hydrochloric acid and by an anodic oxidation treatment,
a photopolymerization layer comprising an addition-polymerizable ethylenic unsaturated compound, a sensitizing dye,a photopolymerizationinitiator,and a polymer binder, and
an oxygen-blocking overcoat layer, in this order,

wherein the support has a double structure of large and small pits, the large pits have a mean opening diameter of 2 to 10 μm, the small pits have a mean opening diameter of 0.1 to 0.8 μm, a surface area ΔS represented by the following formula is at most 40, the photopolymerization layer has a coating amount by weight of 0.5 to 2.0 $g/m^2$, and the sensitizing dye in the photopolymerization layer has an optical density of 0.2 to 1.0:

$$\Delta S = (Sx - So)/So \times 100\ \%$$

wherein Sx indicates an actual surface area of the support obtained by measuring 512 × 512 points of 50 $\mu m^2$, and So indicates a geometrically-measured surface area thereof.

**3.** The photosensitive lithographic printing plate according to claim 2, wherein the sensitizing dye in the photopolymerization layer is a compound of the following formula (SD-1) or (SD-2):

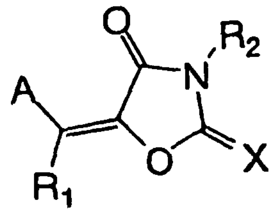

(SD-1)

wherein A represents an optionally-substituted aromatic or heterocyclic ring; X represents an oxygen or sulfur atom, or $-N(R_3)-$; $R_1$, $R_2$ and $R_3$ each independently represent a hydrogen atom, or a monovalent non-metallic atomic group; A and $R_1$, and $R_2$ and $R_3$ may bond to each other to form an aliphatic or aromatic ring;

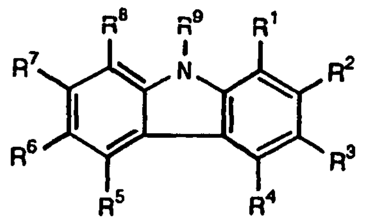

(SD-2)

wherein $R^1$, $R^2$, $R^3$, $R^4$, $R^5$, $R^6$, $R^7$, $R^8$ and $R^9$ each independently a hydrogen atom, or a monovalent non-metallic atomic group, provided that at least one of $R^1$ and $R^3$ is a monovalent organic residue represented by the following partial structural formula (a), and $R^1$, $R^2$, $R^3$, $R^4$ $R^5$, $R^6$, $R^7$, $R^8$ and $R^9$ may independently bond to each other to form an aliphatic or aromatic ring:

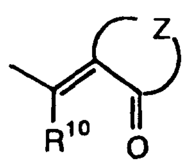

(a)

wherein $R^{10}$ represents a hydrogen atom, or a monovalent non-metallic atomic group; Z represents a divalent non-metallic atomic group necessary for forming a 5-membered acidic nucleus along with the adjacent atoms; $R^{10}$ may bond to any of $R^1$, $R^2$, $R^3$, $R^4$, $R^5$, $R^6$, $R^7$, $R^8$ or $R^9$ to form an aliphatic or aromatic ring.

**4.** The photosensitive lithographic printing plate according to claims 1 or 2, wherein the large pits have a mean opening diameter of 4 to 8 $\mu m$, the small pits have a mean opening diameter of 0.2 to 0.6 $\mu m$, the small pits have a ratio of the diameter to the depth of 1:0.3 to 1:0.5.

**5.** The photosensitive lithographic printing plate according to claims 1 or 2, wherein the aluminium or aluminium alloy sheet have a thickness of 0.05 to 0.8mm.

**6.** The photosensitive lithographic printing plate according to claims 1 or 2, which further comprises at least one of an

organic subbing layer having a dry coating amount of 2 to 200 $mg/m^2$ or an inorganic subbing layer having a dry coating amount of 0.1 to 100 $mg/m^2$.

7. The photosensitive lithographic printing plate according to claims 1 or 2, wherein the polymer binder has a weight-average molecular weight of 5000 to 1,000,000, and an acid value of 0.1 to 5.0 meq/g.

## Patentansprüche

1. Fotoempfindliche Lithographiedruckplatte umfassend:

einen Träger, der durch eine elektrochemische Oberflächen-Aufrauungsbehandlung auf einem Aluminium- oder Aluminiumlegierungsblech mit einer wäßrigen Lösung, die wenigstens Salzsäure enthält, und durch eine anodische Oxidationsbehandlung hergestellt wurde; und
eine Fotopolymerisationsschicht umfassend eine additionspolymerisierbare ethylenische ungesättigte Verbindung, einen Fotopolymerisationsstarter und ein polymeres Bindemittel,

wobei der Träger eine Doppelstruktur aus großen und kleinen Vertiefungen aufweist, wobei die großen Vertiefungen einen mittleren Öffnungsdurchmesser von 2 bis 10 μm aufweisen und die kleinen Vertiefungen einen mittleren Öffnungsdurchmesser von 0,1 bis 0,8 μm aufweisen, die kleinen Vertiefungen ein Verhältnis von Durchmesser zu Tiefe von 1:0,2 bis 1:0,6 aufweisen, die Oberfläche ΔS, wie durch die folgende Formel dargestellt, höchstens 40 beträgt und das polymere Bindemittel in der Fotopolymerisationsschicht wenigstens eine der organischen Polymerverbindungen ist, die eine Amidogruppe der folgenden Formel (M1) in einer Seitenkette aufweisen und Polyurethanharze, die aus (i) wenigstens einer Diisocyanatverbindung, (ii) wenigstens einer Diolverbindung mit wenigstens einer Carboxylgruppe, (iii) wenigstens einer Diolverbindung mit einem logP-Wert kleiner als 0 und (iv) wenigstens einer Diolverbindung mit einem logP-Wert größer als 0 hergestellt wurden, ist, mit der Maßgabe, daß die Verbindungen (iii) und (iv) keine Diolverbindungen mit Carboxylgruppen sind:

$$\Delta S = (Sx - So)/So \times 100\ \%$$

wobei Sx die Oberfläche des Trägers darstellt, die durch Messen von 512 x 512 Punkten auf 50 $\mu m^2$ erhalten wurde, und So eine geometrisch dafür gemessene Oberfläche darstellt;

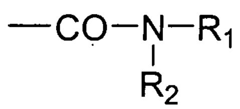

(M1)

wobei $R_1$ und $R_2$ jeweils unabhängig voneinander ein Wasserstoffatom, eine Alkylgruppe, eine Alkenylgruppe, eine Alkinylgruppe, eine Arylgruppe, eine heterocyclische Gruppe oder eine substituierte Sulfonylgruppe darstellen und $R_1$ und $R_2$ unter Ausbildung einer cyclischen Struktur miteinander eine Bindung eingehen können.

2. Fotoempfindliche Lithographiedruckplatte umfassend in dieser Reihenfolge:

einen Träger, der durch eine elektrochemische Oberflächen-Aufrauungsbehandlung auf einem Aluminium- oder Aluminiumlegierungsblech mit einer wäßrigen Lösung, die wenigstens Salzsäure enthält, und durch eine anodische Oxidationsbehandlung hergestellt wurde; und
eine Fotopolymerisationsschicht umfassend eine additionspolymerisierbare ethylenische ungesättigte Verbindung, einen sensibilisierenden Farbstoff, einen Fotopolymerisationsstarter und ein polymeres Bindemittel und eine sauerstoffabsperrende Überzugsschicht,

wobei der Träger eine Doppelstruktur aus großen und kleinen Vertiefungen aufweist, wobei die großen Vertiefungen einen mittleren Öffnungsdurchmesser von 2 bis 10 μm aufweisen, die kleinen Vertiefungen einen mittleren Öffnungsdurchmesser von 0,1 bis 0,8 μm aufweisen, die Oberfläche ΔS, wie durch die folgende Formel dargestellt, höchstens 40 beträgt, die Fotopolymerisationsschicht eine Beschichtungsmenge von 0,5 bis 2,0 $g/m^2$ aufweist und

der sensibilisierende Farbstoff in der Fotopolymerisationsschicht eine optische Dichte von 0,2 bis 1,0 aufweist:

$$\Delta S = (Sx - So)/So \times 100\ \%$$

wobei Sx eine Oberfläche des Trägers darstellt, die durch Messen von 512 x 512 Punkten auf 50 $\mu m^2$ erhalten wurde, und So eine geometrisch dafür gemessene Oberfläche darstellt.

**3.** Fotoempfindliche Lithographiedruckplatte gemäß Anspruch 2, wobei der sensibilisierende Farbstoff in der Fotopolymerisationsschicht eine Verbindung der folgenden Formel (SD-1) oder (SD-2) ist:

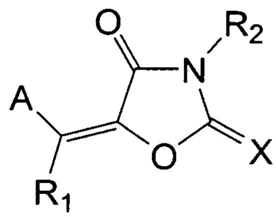

(SD-1)

wobei A einen optional substituierten aromatischen oder heterocyclischen Ring darstellt; X ein Sauerstoff- oder Schwefelatom oder $-N(R_3)-$ darstellt; $R_1$, $R_2$ und $R_3$ jeweils unabhängig voneinander ein Wasserstoffatom oder eine monovalente nicht-metallische atomare Gruppe darstellen; A und $R_1$ und $R_2$ und $R_3$ unter Ausbildung eines aliphatischen oder aromatischen Rings miteinander eine Bindung eingehen können;

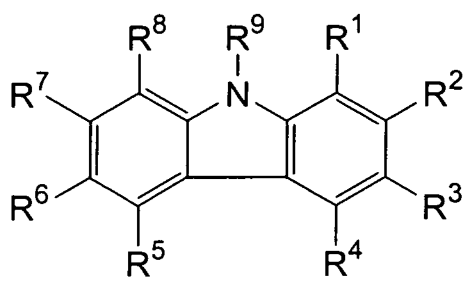

(SD-2)

wobei $R^1$, $R^2$, $R^3$, $R^4$, $R^5$, $R^6$, $R^7$, $R^8$ und $R^9$ jeweils unabhängig voneinander ein Wasserstoffatom oder eine monovalente nicht-metallische atomare Gruppe darstellen, mit der Maßgabe, daß wenigstens eines von $R^1$ und $R^3$ ein monovalenter organischer Rest ist, der durch die folgende Teilstrukturformel (a) dargestellt wird, und $R^1$, $R^2$, $R^3$, $R^4$, $R^5$, $R^6$, $R^7$, $R^8$ und $R^9$ unabhängig voneinander miteinander unter Ausbildung eines aliphatischen oder aromatischen Rings eine Bindung eingehen können:

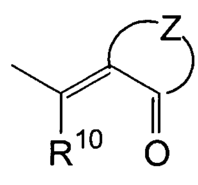

(a)

wobei $R^{10}$ ein Wasserstoffatom oder eine monovalente nicht-metallische atomare Gruppe darstellt; Z eine divalente nicht-metallische atomare Gruppe darstellt, die zur Ausbildung einer 5-gliedrigen sauren Kerns mit den benachbarten Atomen notwendig ist; $R^{10}$ mit irgendeinem von $R^1$, $R^2$, $R^3$, $R^4$, $R^5$, $R^6$, $R^7$, $R^8$ oder $R^9$ unter Ausbildung eines aliphatischen oder aromatischen Rings eine Bindung eingehen kann.

**4.** Fotoempfindliche Lithographiedruckplatte gemäß Anspruch 1 oder 2, wobei die großen Vertiefungen einen mittleren

Öffnungsdurchmesser von 4 bis 8 µm aufweisen, die kleinen Vertiefungen einen mittleren Öffnungsdurchmesser von 0,2 bis 0,6 µm aufweisen, die kleinen Vertiefungen ein Verhältnis von Durchmesser zu Tiefe von 1:0,3 bis 1: 0,5 aufweisen.

**5.** Fotoempfindliche Lithographiedruckplatte gemäß Anspruch 1 oder 2, wobei das Aluminium- oder Aluminiumlegierungsblech eine Dicke von 0,05 bis 0,8 mm aufweist.

**6.** Fotoempfindliche Lithographiedruckplatte gemäß Anspruch 1 oder 2, welche ferner mindestens eine von einer organischen Unterzugsschicht mit einer Trockenbeschichtungsmenge von 2 bis 200 mg/m$^2$ oder einer anorganischen Unterzugsschicht mit einer Trockenbeschichtungsmenge von 0,1 bis 100 mg/m$^2$ umfaßt.

**7.** Fotoempfindliche Lithographiedruckplatte gemäß Anspruch 1 oder 2, wobei das polymere Bindemittel ein gewichtsmittleres Molekulargewicht von 5.000 bis 1.000.000 und eine Säurezahl von 0,1 bis 5,0 meq/g aufweist.

## Revendications

**1.** Plaque d'impression lithographique photosensible qui comprend :

un support préparé par un traitement électrochimique de rugosification de surface sur une feuille d'aluminium ou d'alliage d'aluminium à l'aide d'une solution aqueuse qui contient au moins de l'acide chlorhydrique et par un traitement d'oxydation anodique et
une couche de photopolymérisation qui comprend un composé éthyléniquement insaturé polymérisable par addition, un initiateur de photopolymérisation et un liant polymère ;

dans lequel le support présente une double structure de grands creux et de petits creux, les grands creux présentant un diamètre d'ouverture moyen compris entre 2 et 10 µm, les petits creux présentant un diamètre d'ouverture moyen compris entre 0,1 et 0,8 µm, les petits creux présentant un rapport du diamètre sur la profondeur de 1 : 0,2 à 1 : 0,6, la surface ΔS représentée par la formule vaut au moins 40 et le liant polymère dans la couche de photopolymérisation est au moins un composé de polymères organiques qui présentent un groupe amide de formule (M1) donnée ci-dessous sur leurs branches latérales et des résines de polyuréthane produites à partir (i) d'au moins un composé de diisocyanate, (ii) d'au moins un composé diol qui présente au moins un groupe carboxyle, (iii) d'au moins un composé diol dont la valeur log P est inférieure à 0 et (iv) au moins un composé diol dont la valeur log P est supérieure à 0, pour autant que les composés (iii) et (iv) ne soient pas un groupe carboxyle présentant un composé diol :

$$\Delta S = (Sx - So)/So \times 100\ \%$$

dans lequel Sx indique la surface effective du support obtenue en mesurant 512 x 512 points de 50 µm$^2$, et So indique leur surface mesurée géométriquement :

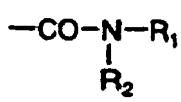

(M1)

où $R_1$ et $R_2$ représentent chacun indépendamment un atome d'hydrogène, un groupe alkyle, un groupe alcényle, un groupe alcynyle, un groupe aryle, un groupe hétérocyclique ou un groupe sulfonyle substitué, et $R_1$ et $R_2$ peuvent être liés l'un à l'autre afin de former une structure cyclique.

**2.** Plaque d'impression lithographique photosensible qui comprend dans cet ordre :

un support préparé par un traitement électrochimique de rugosification de surface sur une feuille d'aluminium ou d'alliage d'aluminium à l'aide d'une solution aqueuse qui contient au moins de l'acide chlorhydrique et par

un traitement d'oxydation anodique,
une couche de photopolymérisation qui comprend un composé éthyléniquement insaturé polymérisable par addition, une encre sensibilisante, un initiateur de photopolymérisation et un liant polymère ;
une couche de recouvrement qui bloque l'oxygène,

dans laquelle le support présente une double structure de grands creux et de petits creux, les grands creux présentant un diamètre d'ouverture moyen compris entre 2 et 10 μm, les petits creux présentant un diamètre d'ouverture moyen compris entre 0,1 et 0,8 μm, la surface ΔS représenté par la formule vaut au moins 40, la couche de photopolymérisation est présente en une quantité de recouvrement en poids de 0,5 à 2,0 g/$m^2$ et l'encre sensibilisante dans la couche de photopolymérisation a une densité optique comprise entre 0,2 et 1,0 :

$$\Delta S = (Sx - So)/So \times 100\ \%$$

dans laquelle Sx indique la surface effective du support obtenu en mesurant 512 x 512 points de 50 $\mu m^2$ et So indique la surface mesurée géométriquement.

**3.** Plaque d'impression lithographique photosensible selon la revendication 2, dans laquelle l'encre sensibilisante de la couche de photopolymérisation est un composé présentant les formules (SD-1) ou (SD-2) ci-dessous :

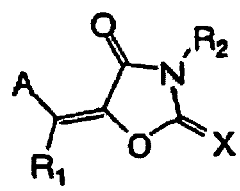

(SD-1)

dans laquelle A représente un cycle aromatique ou hétérocyclique facultativement substitué, X représente un atome d'oxygène ou de soufre ou -N($R_3$)-; $R_1$, $R_2$ et $R_3$ représentent chacun indépendamment un atome d'hydrogène, ou un groupe monovalent d'atomes de non-métaux; A et $R_1$, et $R_2$ et $R_3$ peuvent être liés l'un à l'autre afin de former un groupe aliphatique ou un cycle aromatique:

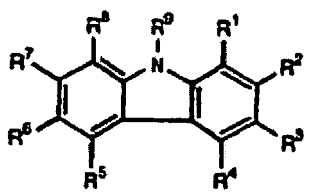

(SD-2)

dans laquelle $R^1$, $R^2$, $R^3$ $R^4$, $R^5$, $R^6$ $R^7$, $R^8$ et $R^9$ représentent chacun indépendamment un atome d'hydrogène ou un groupe monovalent d'atomes de non-métaux, pour autant que au moins un des $R^1$ et $R^3$ soit un groupe organique monovalent représenté par les formules structurelles partielles (a) ci-dessous et $R^1$, $R^2$, $R^3$, $R^4$, $R^5$, $R^6$ $R^7$, $R^8$ et $R^9$ peuvent être liées indépendamment les uns aux autres afin de former un cycle aliphatique ou aromatique:

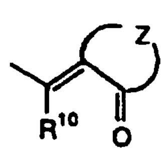

(a)

dans laquelle $R^{10}$ représente un atome d'hydrogène ou un groupe monovalent d'atomes de non-métaux, Z représente un groupe d'atomes de non-métaux divalent nécessaire pour former un noyau acide à 5 chaînons avec les

atomes adjacents; $R^{10}$ peut être lié à $R^1$, $R^2$ , $R^3$, $R^4$, $R^5$, $R^6$, $R^7$, $R^8$ ou $R^9$ afin de former un cycle aliphatique ou aromatique.

**4.** Plaque d'impression lithographique photosensible selon les revendications 1 ou 2, dans laquelle les grands creux présentent un diamètre d'ouverture moyen compris entre 4 et 8 $\mu$m, les petits creux présentent un diamètre d'ouverture moyen compris entre 0,2 et 0,6 $\mu$m et les petits creux présentent un rapport du diamètre sur la profondeur compris entre 1 : 0,3 et 1 : 0,5.

**5.** Plaque d'impression lithographique photosensible selon les revendications 1 ou 2, dans laquelle la feuille d'aluminium ou d'alliage d'aluminium présente une épaisseur comprise entre 0,05 et 0,8 mm.

**6.** Plaque d'impression lithographique photosensible selon les revendications 1 ou 2, qui comprend de plus au moins une couche organique adhésive appliquée à raison de 2 à 200 g/$m^2$ ou une couche minérale adhésive appliquée à raison de 0,1 à 100 mg/$m^2$ en revêtement sec.

**7.** Plaque d'impression lithographique photosensible selon les revendications 1 ou 2, dans laquelle le liant polymère présente un poids moléculaire moyen compris entre 5 000 à 1 000 000 et un indice d'acidité compris entre 0,1 à 5,0 meq/g.

Fig. 1

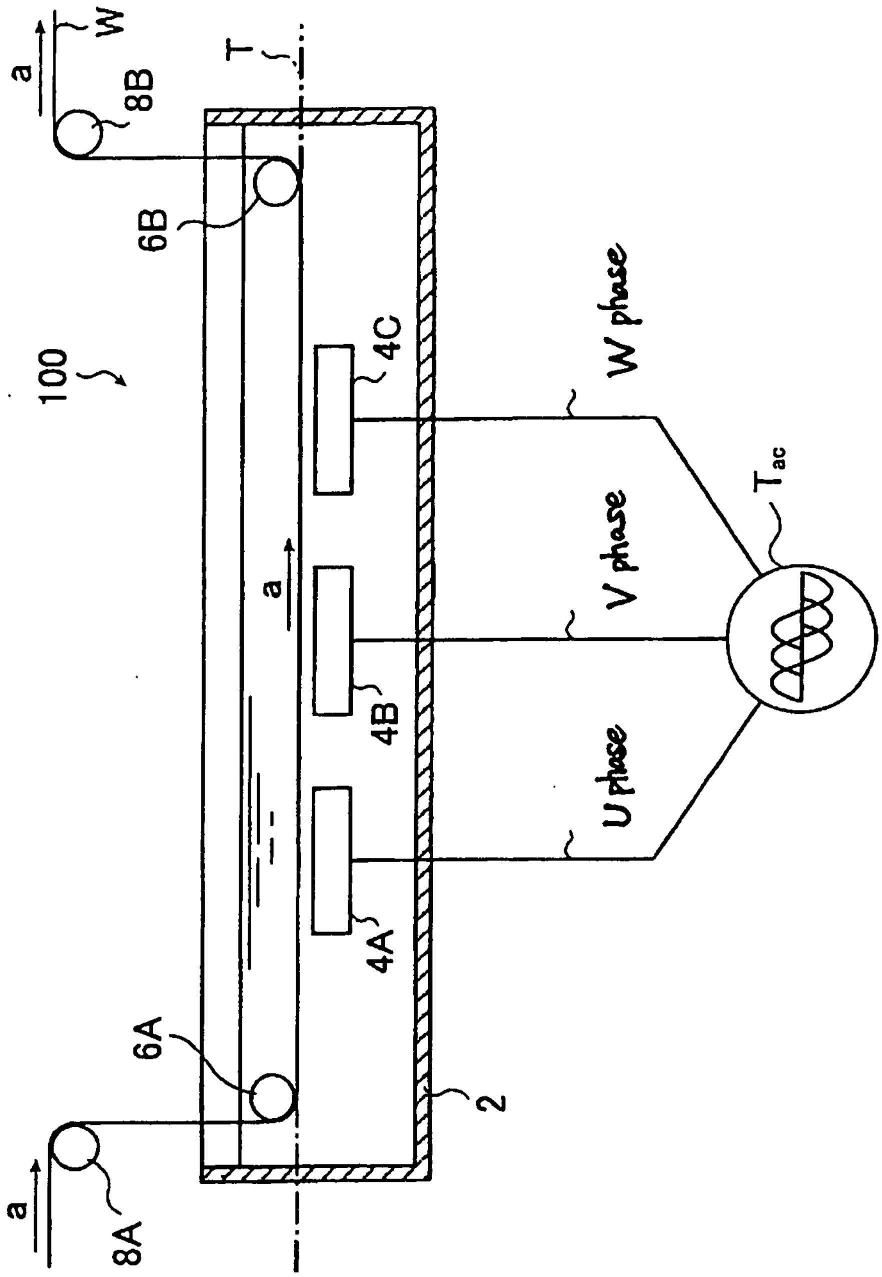

Fig. 2

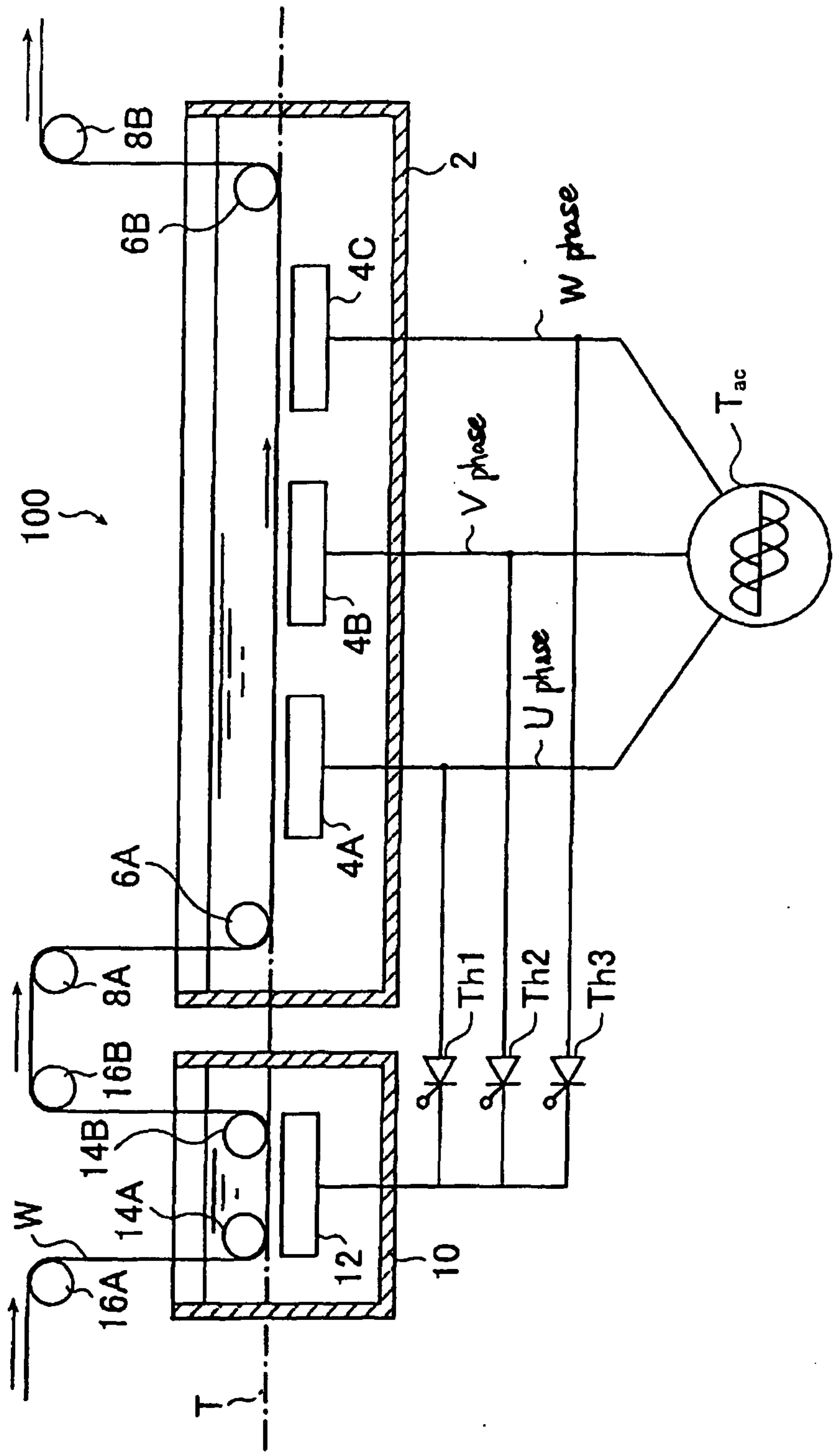

100
102
2
8B
6B
4C
4B
4A
6A
8A
16B
14B
14A
W
16A
12
10
T
Th1
Th2
Th3
W phase
V phase
U phase
$T_{ac}$

Fig. 3

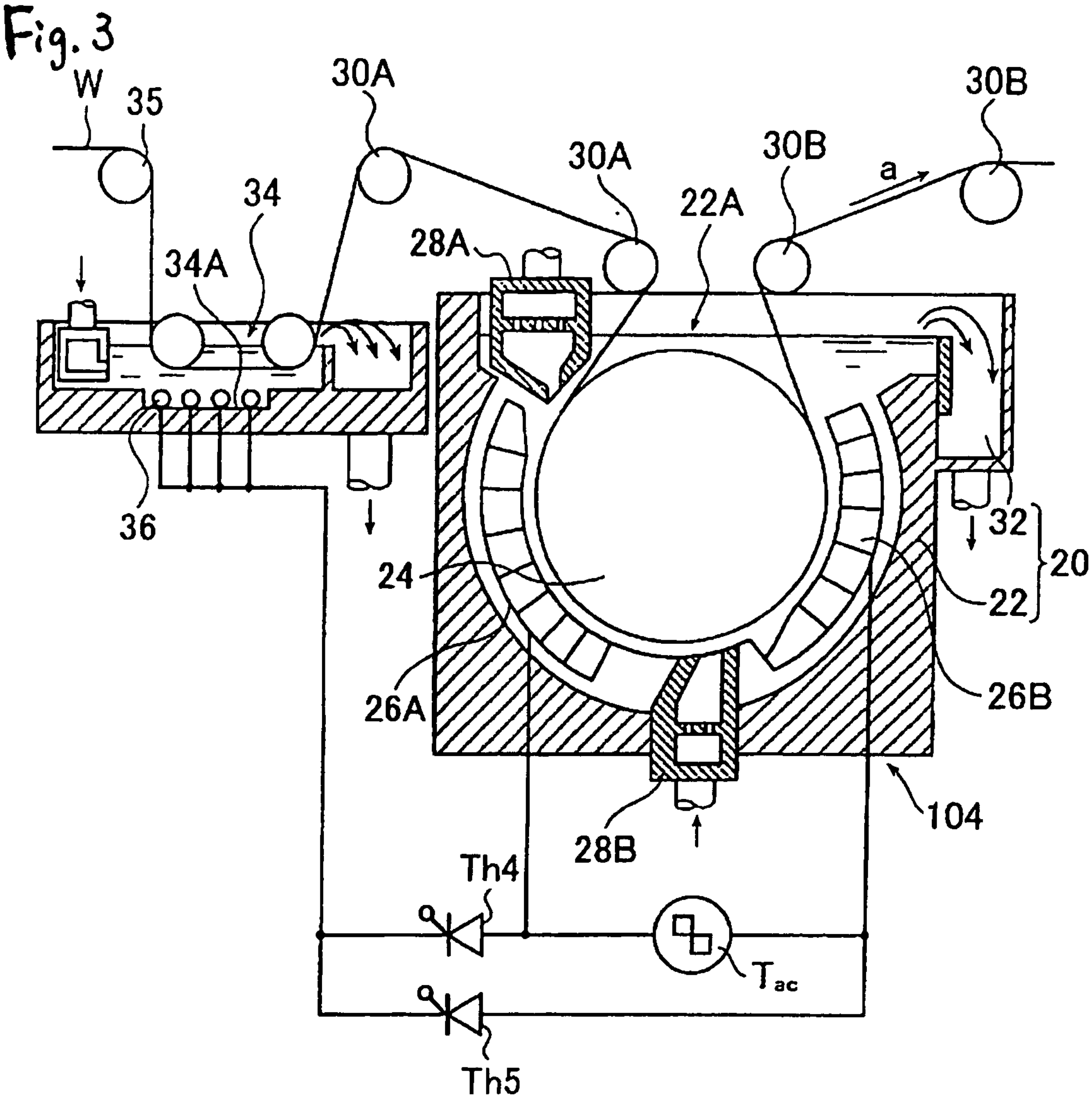
W
35
30A
30A
30B
30B
a
34
34A
22A
28A
36
32
20
24
22
26A
26B
104
28B
Th4
Tac
Th5

Fig. 4

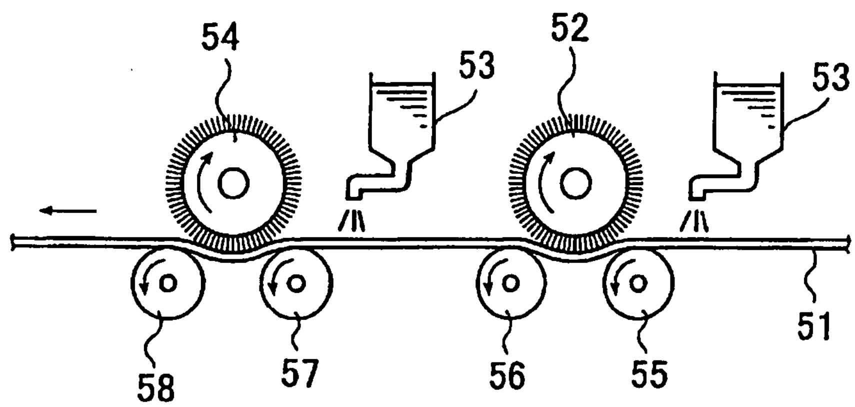
54
53
52
53
51
58
57
56
55

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 4034327 B
- JP 8012577 B
- JP 60159743 A
- JP 60208748 A
- JP 3063740 B
- JP 3012403 A
- JP 6295061 A
- JP 11171907 A
- JP 6135175 A
- JP 50040047 B
- JP 55074898 A
- JP 61162351 A
- JP 63104889 A
- US 3834398 A
- JP 6037716 B
- JP 5042520 B
- JP 55025381 A
- JP 61030036 B
- JP 8300843 A
- JP 58177441 A
- JP 56123400 A
- JP 60043500 A
- JP 1052098 A
- JP 5195300 A
- JP 2000282272 A
- JP 54128453 A
- JP 45303 A
- JP 2001011698 A
- JP 61050138 B
- JP 57051290 A
- JP 62030275 B
- JP 55021840 B
- JP 4176690 A
- JP 5278362 A
- JP 4282637 A
- JP 7314937 A
- JP 10066905 A
- JP 10028901 A
- JP 10028902 A
- JP A738104 B
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 11352691 A
- JP 48041708 B
- JP 51037193 A
- JP 2032293 B
- JP 48064183 A
- JP 49043191 B
- JP 52030490 B
- US 2850445 A
- JP 4420189 B
- JP 4537377 B
- JP 47002528 B
- JP 54155292 A
- JP 48084183 A
- JP 54151024 A
- JP 52112681 A
- JP 58015503 A
- JP 59140203 A
- JP 59001504 A
- JP 59189340 A
- JP 62174203 A
- JP 62001641 B
- US 4766055 A
- JP 63258903 A
- JP 2063054 A
- JP 62143044 A
- JP 62150242 A
- JP 6413140 A
- JP 6413141 A
- JP 6413142 A
- JP 6413143 A
- JP 6413144 A
- JP 6417048 A
- JP 122003 A
- JP 1298348 A
- JP 1138204 A
- JP 2179643 A
- JP 2244050 A
- JP 63221110 A
- JP 4221958 A
- JP 4219756 A
- JP 295061 A
- JP 8334897 A
- JP 11084647 A
- JP 2000147763 A

- JP 2001042524 A
- JP 59028329 B
- JP 10010754 A
- JP 8278636 A
- JP 2000089478 A
- JP 2003029879 A
- JP 2003029880 A
- JP 2003029881 A


**Non-patent literature cited in the description**


- Aluminium Handbook. *Light Metal Association of Japan,* 1990
- Continuous Surface Processing Technology. *the General Technology Center of Japan,* 30 September 1986, 289
- *the Journal of Adhesive Association of Japan,* 1984, vol. 20 (7), 300-308
- **C. HANSCH ; A. LEO.** Substituent Constants for Correlation Analysis in Chemistry and Biology. J. Wile & Sons, 1979